# EUROPEAN PATENT APPLICATION

(11) **EP 4 847 581 A1**
(43) Date of publication of application: **02.12.2026**
(21) Application number: 25751770.6
(22) Date of filing: 01.04.2025
(51) Int. Cl.: C09K 11/02, H10K 50/15, H10K 50/115, C08K 5/37

(54) **CROSS-LINKING AGENT, HOLE TRANSPORT COMPOSITION, LIGAND AND LIGHT-EMITTING DEVICE**

(30) Priority: 07.02.2024 WO PCT/CN2024/076770; 18.10.2024 WO PCT/CN2024/125821
(71) Applicant: Boe Technology Group Co., Ltd., Beijing 100015 (CN); Beijing BOE Technology Development Co., Ltd., Beijing 100176 (CN)
(72) Inventor: CHEN, Zhuo, Beijing 100176 (CN); ZHANG, Shiqiang, Beijing 100176 (CN); LU, Shaoyong, Beijing 100176 (CN); YU, Donghui, Beijing 100176 (CN); LI, Dong, Beijing 100176 (CN); SHI, Shuangshuang, Beijing 100176 (CN)
(74) Representative: Hoffmann Eitle
(86) International application number: PCT/CN2025/086676
(87) International publication number: WO 2025/168161

(57) **Abstract**

A cross-linking agent, comprising: a mercapto group protected by a photo-degradable group, wherein the photo-degradable group is removed under illumination to release mercapto groups, sulfur free radicals or sulfur negative ions. A hole transport composition, the hole transport composition comprising: a hole transport material and a cross-linking agent, wherein the hole transport material comprises: a main chain and a side chain linked with the main chain of the hole transport material. At least one of the side chain of the hole transport material and the cross-linking agent has a mercapto group protected by a photo-degradable group; the photo-degradable group is removed under illumination to release mercapto groups, sulfur free radicals or sulfur negative ions; and the released mercapto groups, sulfur free radicals or sulfur negative ions are configured to crosslink the hole transport material with the cross-linking agent.

## Description

This application claims priority to International Patent Application No. PCT/CN2024/076770, filed on Feb. 7, 2024, the entirety of which is hereby incorporated by reference into this application.

This application claims priority to International Patent Application No PCT/CN2024/125821, filed on Oct. 18, 2024, the entirety of which is hereby incorporated by reference into this application.

### TECHNICAL FIELD

The present disclosure relates to the field of display technologies, and in particular, to a cross-linking agent, a hole transport composition, a ligand, and a light-emitting device.

### BACKGROUND

Quantum dots (QD), as a new type of luminescent materials, possess advantages such as high purity of light color, high luminous quantum efficiency, tunable emission color, and long service life, thus becoming a hot topic in current research on new light-emitting diode (LED) materials. Therefore, quantum dot light-emitting diodes (QLEDs) with quantum dot materials as their light-emitting layer have emerged as the primary direction in the research of new type of display apparatuses.

### SUMMARY

In an aspect, a cross-linking agent is provided. The cross-linking agent includes: a sulfhydryl group protected by a photoremovable group, the photoremovable group being removed under light irradiation to release the sulfhydryl group, a sulfur free-radical or a sulfur anion.

In some embodiments, the cross-linking agent is selected from at least one of structures represented by the following general formula I: PPG-S-R1-S-PPG (I), where R1 is selected from a substituted or unsubstituted alkyl group, or a substituted or unsubstituted alkyl group including at least one of an ethylene glycol group, an ether group, a ketone group, an amine group, a thioether group, a sulfone group, an ester group, an amide group, an alkenyl group, or an alkynyl group; and PPG is the photoremovable group.

In some embodiments, the cross-linking agent is selected from at least one of structures represented by the following general formula II: R2-(R1-S-PPG)ₙ₁ (II), where R2 is selected from any one of a secondary carbon atom, a tertiary carbon atom, and a quaternary carbon atom; and n1 ≥ 2.

In some embodiments, the cross-linking agent is selected from at least one of structures represented by the following general formulas VI-1 or VI-2: 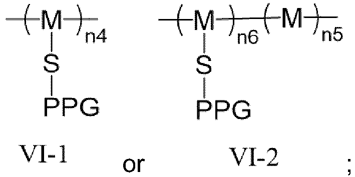 where each M is the same or different, and M is a repeating unit formed by polymerization of at least one selected from styrene, acrylate, alkyl acrylate, maleic anhydride, or caprolactone styrene; n4 is selected from positive integers greater than or equal to 2; n5+n6 is selected from positive integers greater than or equal to 2; and a value of n6/(n5+n6) ranges from 1% to 1.

In some embodiments, the photoremovable group is selected from at least one of the following substituents: 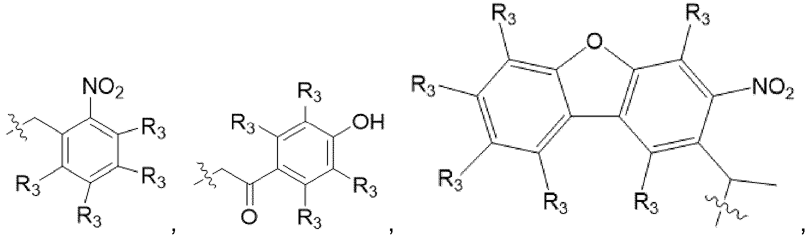 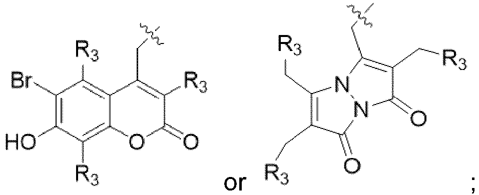 where each R₃ is independently selected from any one of H, an alkyl group, an electron-withdrawing group, an electron-donating group, and a conjugated group.

In some embodiments, the cross-linking agent is selected from at least one of structures represented by the following formula I-I:

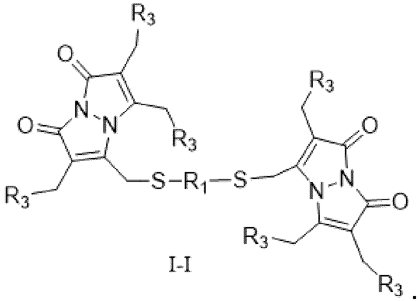

In some embodiments, the cross-linking agent is selected from at least one of structures represented by the following formula I-II:

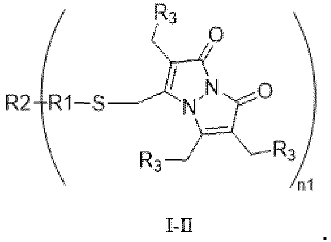

In some embodiments, the cross-linking agent is selected from at least one of structures represented by the following formulas I-III or I-IV: 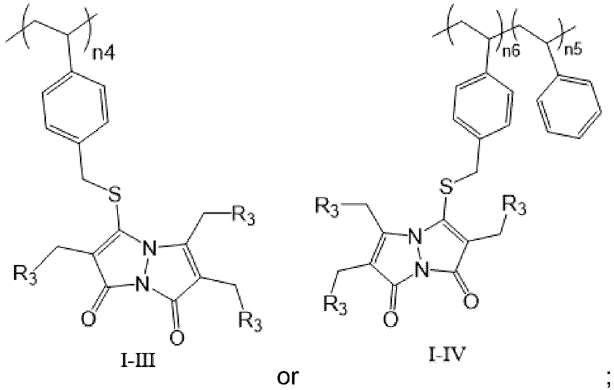 where n4 is selected from positive integers greater than or equal to 2; n5+n6 is selected from positive integers greater than or equal to 2; and a value of n6/(n5+n6) ranges from 1% to 1.

In some embodiments, the cross-linking agent is selected from at least one of the following structural formulas:

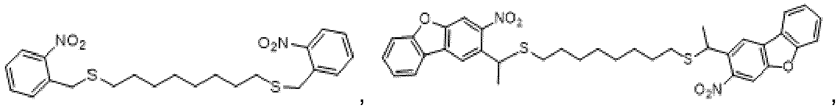

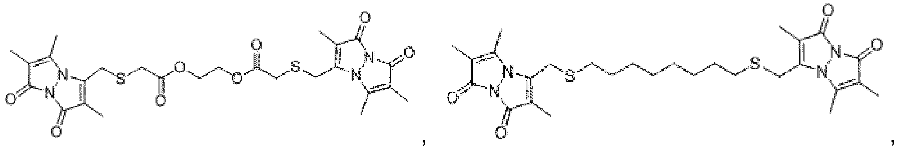

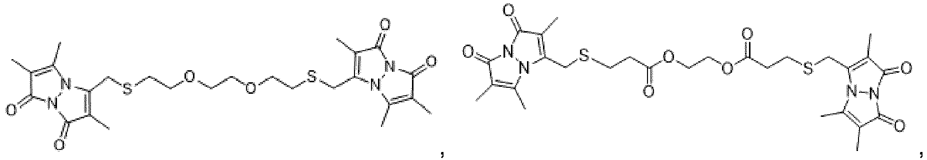

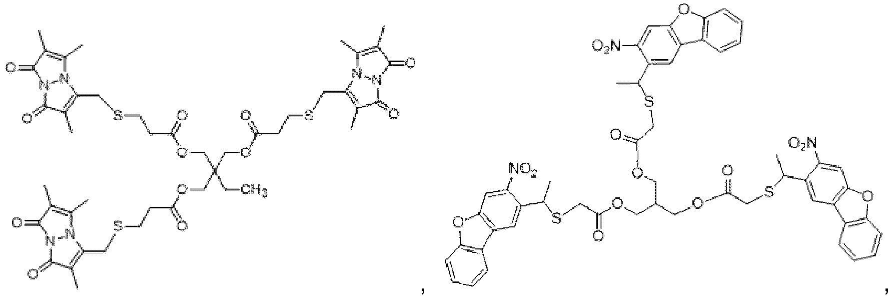

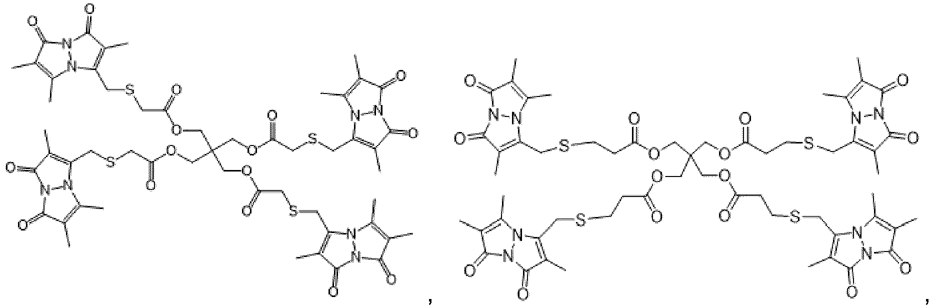

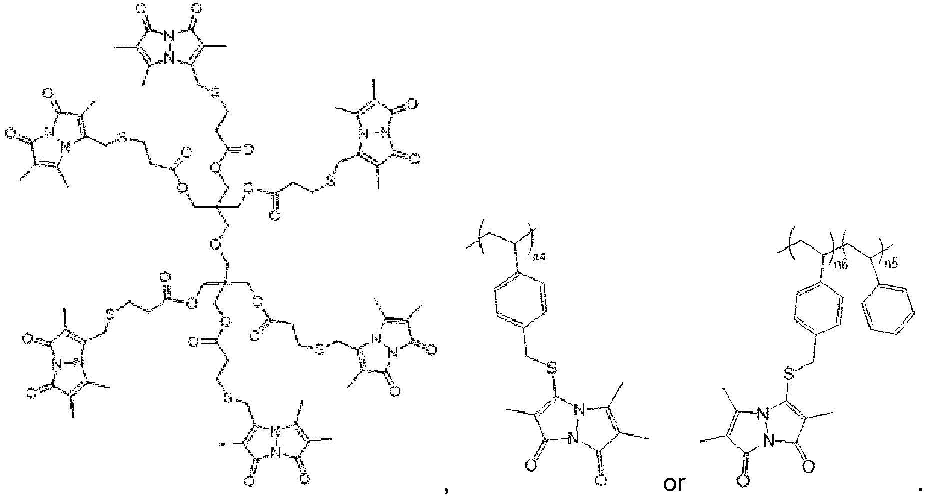

In some embodiments, the cross-linking agent further includes: a carrier transport regulating group.

In some embodiments, the cross-linking agent includes: a main chain and a side chain connected to the main chain of the cross-linking agent; the carrier transport regulating group is located on the main chain of the cross-linking agent; and the sulfhydryl group protected by the photoremovable group is located on the side chain of the cross-linking agent.

In some embodiments, the cross-linking agent is selected from at least one of structures represented by the following general formula III: R4-(R1-S-PPG)ₙ₂ (III), where R4 is the substituted or unsubstituted carrier transport regulating group; and n2 ≥ 2.

In some embodiments, the carrier transport regulating group is a hole transport group, and the hole transport group includes at least one of a triphenylamine group, a carbazole group, or a linked triphenylamine group.

In some embodiments, the cross-linking agent is selected from at least one of the following structural formulas:

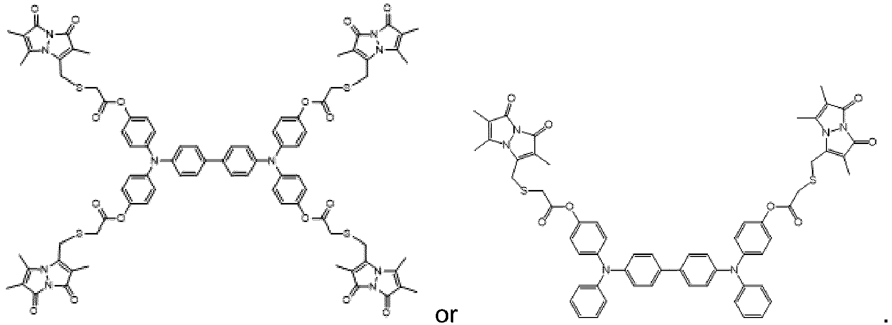

In another aspect, a hole transport composition is provided. The hole transport composition includes: a hole transport material and a cross-linking agent. The hole transport material includes a main chain and a side chain connected to the main chain of the hole transport material. At least one of the side chain of the hole transport material or the cross-linking agent has a sulfhydryl group protected by a photoremovable group, and the photoremovable group is removed under light irradiation to release the sulfhydryl group, a sulfur free-radical or a sulfur anion; and the released sulfhydryl group, sulfur free-radical or sulfur anion is configured to enable cross-linking between the hole transport material and the cross-linking agent.

In some embodiments, the cross-linking agent is selected from the cross-linking agent according to any one of the above embodiments, and the sulfhydryl group, sulfur free-radical or sulfur anion released from the cross-linking agent is configured to react with the side chain of the hole transport material to form a chemical bond.

In some embodiments, the released sulfhydryl group, sulfur free-radical or sulfur anion is located on the side chain of the hole transport material, and the released sulfhydryl group, sulfur free-radical or sulfur anion is configured to react with the cross-linking agent to form a chemical bond.

In some embodiments, in a case where the released sulfhydryl group, sulfur free-radical or sulfur anion is located on the cross-linking agent, the side chain of the hole transport material further includes an activating group; in a case where the released sulfhydryl group, sulfur free-radical or sulfur anion is located on the side chain of the hole transport material, the cross-linking agent further includes an activating group. The activating group includes at least one of a carbon-carbon double bond or a carbon-carbon triple bond.

In some embodiments, the activating group having the carbon-carbon double bond includes at least one of a styryl group, an acrylate group, an alkyl acrylate group, a maleic anhydride group, or a maleimide group.

In some embodiments, a ligand is provided. The ligand is used for coordinatively connecting to a quantum dot body. The ligand includes: a sulfhydryl group protected by a photoremovable group, the photoremovable group being removed under light irradiation to release the sulfhydryl group, a sulfur free-radical or a sulfur anion.

In some embodiments, the photoremovable group is selected from at least one of the following substituents: 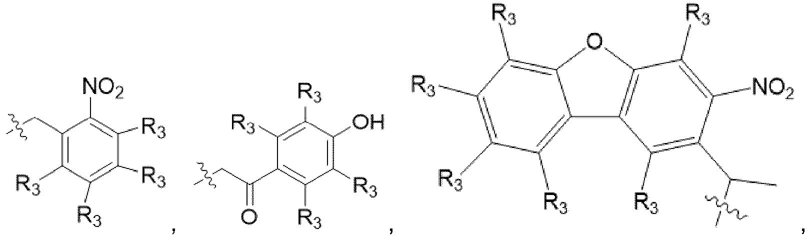 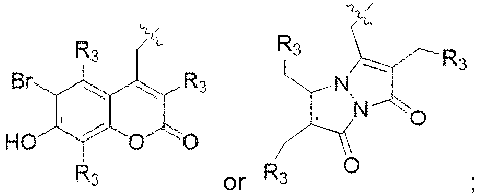 where each R₃ is independently selected from any one of H, an alkyl group, an electron-withdrawing group, an electron-donating group, and a conjugated group.

In some embodiments, the ligand further includes: a coordination group for coordinatively connecting to the quantum dot body. The coordination group includes at least one of an amino group, a carboxylic acid group, a sulfhydryl group, a phosphino group, a phosphine oxide group, a phosphate group, a phosphite group, or a hypophosphite group.

In some embodiments, the ligand is selected from at least one of structures represented by the following general formula IV: A-R1-S-PPG (IV), where A is the coordination group; R1 is selected from a substituted or unsubstituted alkyl group, or a substituted or unsubstituted alkyl group including at least one of an ethylene glycol group, an ether group, a ketone group, an amine group, a thioether group, a sulfone group, an ester group, an amide group, an alkenyl group, or an alkynyl group; and PPG is the photoremovable group.

In some embodiments, a structural formula of the ligand includes:

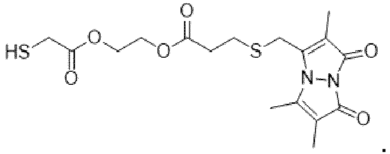

In some embodiments, the ligand is selected from at least one of structures represented by following general formula V: A-R5-(R1-S-PPG)ₙ₃ (V), where R5 is selected from a substituted or unsubstituted alkyl group, or a substituted or unsubstituted alkyl group including at least one of an ethylene glycol group, an ether group, a ketone group, an amine group, a thioether group, a sulfone group, an ester group, an amide group, an alkenyl group, and an alkynyl group; and n3 ≥ 2.

In yet another aspect, a quantum dot composition is provided. The quantum dot composition includes: a quantum dot body, a ligand, and a cross-linking agent, the ligand being coordinatively connected to the quantum dot body. At least one of the ligand or the cross-linking agent has a sulfhydryl group protected by a photoremovable group, and the photoremovable group is removed under light irradiation to release the sulfhydryl group, a sulfur free-radical or a sulfur anion; and the released sulfhydryl group, sulfur free-radical or sulfur anion is configured to enable cross-linking between at least two of the quantum dot body, the ligand, or the cross-linking agent.

In some embodiments, the cross-linking agent is selected from the cross-linking agent according to any one of the above embodiments, and the sulfhydryl group, sulfur free-radical or sulfur anion released from the cross-linking agent is configured to coordinatively connect with the quantum dot body or react with the ligand to form a chemical bond.

In some embodiments, the ligand includes: a first ligand, a structural formula of the first ligand being A1-R1-D, where A1 is a coordination group capable of coordinating with the quantum dot body; R1 is selected from a substituted or unsubstituted alkyl group, or a substituted or unsubstituted alkyl group including at least one of an ethylene glycol group, an ether group, a ketone group, an amine group, a thioether group, a sulfone group, an ester group, an amide group, an alkenyl group, or an alkynyl group; and D is an activating group.

In some embodiments, the ligand further includes: a second ligand, a structural formula of the second ligand being A2-R1, where A2 is a coordination group capable of coordinating with the quantum dot body; and R1 of the first ligand and R1 of the second ligand are the same or different.

In some embodiments, a proportion of the mass of the first ligand to the mass of the ligand is greater than or equal to 5%.

In some embodiments, the ligand includes the ligand according to any one of the above embodiments, and the sulfhydryl group, sulfur free-radical or sulfur anion released from the ligand is configured to react with the cross-linking agent to form a chemical bond, coordinatively connect the quantum dot body, or react with another ligand to form a chemical bond.

In some embodiments, the cross-linking agent includes: an activating group, the activating group including at least one of a carbon-carbon double bond or a carbon-carbon triple bond.

In still another aspect, a light-emitting device is provided. The light-emitting device includes: a hole transport layer and a quantum dot light-emitting layer that are stacked. A material of at least one of the hole transport layer or the quantum dot light-emitting layer includes at least one of the following materials: 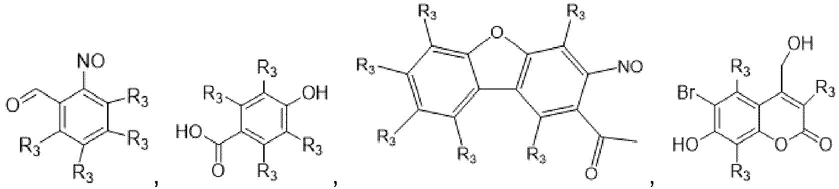 or 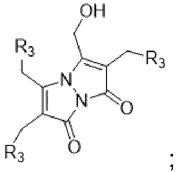 where each R₃ is independently selected from any one of H, an alkyl group, an electron-withdrawing group, an electron-donating group, or a conjugated group.

In some embodiments, a material of the hole transport layer further includes a first cross-linking material. The first cross-linking material includes a first group, the first group including a main chain and a side chain connected to the main chain of the first group; and the first cross-linking material further includes a first cross-linking group connected to the side chain of the first group, and the side chain of the first group and the first cross-linking group are connected via at least two thioether structures.

In some embodiments, the first cross-linking group further includes at least one of a triphenylamine group, a carbazole group, or a linked triphenylamine group.

In some embodiments, the main chain of the first group includes at least one of polycarbazole, polybenzidine, a substituted or unsubstituted carbazole-fluorene copolymer, or a substituted or unsubstituted benzidine-fluorene copolymer.

In some embodiments, the side chain of the first group further includes at least one of an ethylene glycol group or an ester group.

In some embodiments, the quantum dot light-emitting layer includes quantum dot bodies connected to each other via a second cross-linking material. The second cross-linking material includes at least one of the following materials: a coordination group coordinating with a quantum dot body, and a second cross-linking group connected to the coordination group, the coordination group and the second cross-linking group being connected via a thioether structure; a second cross-linking group connected to the quantum dot body via an S-Zn coordination bond or an S-Cd coordination bond; or a first coordination group coordinating with the quantum dot body, and a second coordination group coordinating with the quantum dot body, the first coordination group and the second coordination group being connected via a thioether structure.

### BRIEF DESCRIPTION OF THE DRAWINGS

In order to describe technical solutions in the present disclosure more clearly, the accompanying drawings to be used in some embodiments of the present disclosure will be introduced briefly; obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram showing the manufacturing of a quantum dot light-emitting layer of a light-emitting substrate, in accordance with some embodiments of the present disclosure;
FIG. 2 is a structural diagram of a light-emitting substrate, in accordance with some embodiments of the present disclosure;
FIG. 3 is another structural diagram showing the manufacturing of a quantum dot light-emitting layer of a light-emitting substrate, in accordance with some embodiments of the present disclosure;
FIG. 4 is a structural diagram of a cross-linking agent, in accordance with some embodiments of the present disclosure;
FIG. 5 is a structural diagram of a light-emitting device, in accordance with some embodiments of the present disclosure;
FIG. 6 is a diagram showing the light emission of a light-emitting device including a red quantum dot light-emitting layer, in accordance with some embodiments of the present disclosure;
FIG. 7 is a scanning electron micrograph of a quantum dot light-emitting layer in an exposed region, in accordance with some embodiments of the present disclosure;
FIG. 8 is a scanning electron micrograph of a quantum dot light-emitting layer in an unexposed region, in accordance with some embodiments of the present disclosure;
FIG. 9 is an ultraviolet-visible absorption spectrum of the cross-linking agent shown in Example 3 of the present disclosure;
FIG. 10 is an ultraviolet-visible absorption spectrum of the cross-linking agent shown in Example 4 of the present disclosure;
FIG. 11 is a diagram showing the light emission of a light-emitting device, in accordance with some embodiments of the present disclosure;
FIG. 12 is an ultraviolet-visible absorption spectrum of the cross-linking agent shown in Example 5 of the present disclosure;
FIG. 13 is another diagram showing the light emission of a light-emitting device, in accordance with some embodiments of the present disclosure;
FIG. 14 is an ultraviolet-visible absorption spectrum of the cross-linking agent shown in Example 6 of the present disclosure;
FIG. 15 is a graph showing current efficiency curves of Comparative Example 1, Embodiment 1 and Embodiment 2 of the present disclosure;
FIG. 16 is a graph showing relative luminance curves of Comparative Example 1, Embodiment 1 and Embodiment 2 of the present disclosure;
FIG. 17 is a diagram showing the light emission of a light-emitting substrate, in accordance with some embodiments of the present disclosure;
FIG. 18 is another diagram showing the light emission of a light-emitting substrate, in accordance with some embodiments of the present disclosure; and
FIG. 19 is a structural diagram of a display apparatus, in accordance with some embodiments of the present disclosure.

### DETAILED DESCRIPTION

The technical solutions in some embodiments of the present disclosure will be described clearly and completely below with reference to the accompanying drawings, and obviously, the described embodiments are merely some but not all embodiments of the present disclosure. All other embodiments obtained by a person of ordinary skill in the art based on embodiments provided by the present disclosure shall be included in the protection scope of the present disclosure.

Unless the context requires otherwise, throughout the specification and the claims, the term "comprise" and other forms thereof such as the third-person singular form "comprises" and the present participle form "comprising" are construed as an open and inclusive meaning, i.e., "including, but not limited to." In the description of the specification, the terms such as "one embodiment," "some embodiments," "exemplary embodiments," "example," "specific example," or "some examples" are intended to indicate that specific features, structures, materials, or characteristics related to the embodiment(s) or example(s) are included in at least one embodiment or example of the present disclosure. Schematic representations of the above term do not necessarily refer to the same embodiment(s) or example(s). In addition, specific features, structures, materials, or characteristics may be included in any one or more embodiments or examples in any suitable manner.

Hereinafter, terms such as "first" and "second" are used for descriptive purposes only, but are not to be construed as indicating or implying the relative importance or implicitly indicating the number of indicated technical features. Thus, a feature defined with "first" or "second" may explicitly or implicitly include one or more of the features. In the description of the embodiments of the present disclosure, the term "a/the plurality of" or "multiple" means two or more unless otherwise specified.

In the description of some embodiments, the expressions "coupled," "connected," and derivatives thereof may be used. The term "connected" should be understood in a broad sense. For example, the "connected" may refer to a fixed connection, a detachable connection, or of an integrated structure; and it may refer to a direct connection or an indirect connection by an intermediate medium. The term "coupled" indicates, for example, that two or more components are in direct physical or electrical contact. However, the term "coupled" or "communicatively coupled" may also indicate that two or more components are not in direct contact with each other, but still cooperate or interact with each other. The embodiments disclosed herein are not necessarily limited to the context herein.

The phrase "at least one of A, B and C" has the same meaning as the phrase "at least one of A, B or C", both including the following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

As used herein, the term such as "about," "substantially" or "approximately" means a stated value and an average value within an acceptable range of deviation of a particular value, with the acceptable range of deviation being determined by a person of ordinary skill in the art in view of the measurement in question and errors associated with measurement of a particular quantity (i.e., the limitation of the measurement system).

The term such as "parallel," "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

It will be understood that, if a layer or element is described as being on another layer or substrate, it may mean that this layer or element is directly on another layer or substrate, or there may be an intervening layer between this layer or element and another layer or substrate.

Exemplary embodiments are described herein with reference to sectional views and/or plan views that are schematic illustrations of idealized embodiments. In the drawings, thicknesses of layers and sizes/dimensions of areas/regions are enlarged for clarity. Variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature being curved. Therefore, the regions shown in the accompanying drawings are schematic in nature, and their shapes are not intended to show actual shapes of the regions in a device, and are not intended to limit the scope of the exemplary embodiments.

Quantum dot light-emitting diodes (QLEDs) employing quantum dots (QDs) as light-emitting materials are widely applied in the display field. The main techniques for manufacturing the light-emitting layers of quantum dot light-emitting diodes mainly include inkjet printing, photolithography, transfer printing and the like, in which photolithography is a promising method for manufacturing high-resolution quantum dot light-emitting diodes.

Photolithography refers to a technique for achieving quantum dot patterning through exposure and development processes.

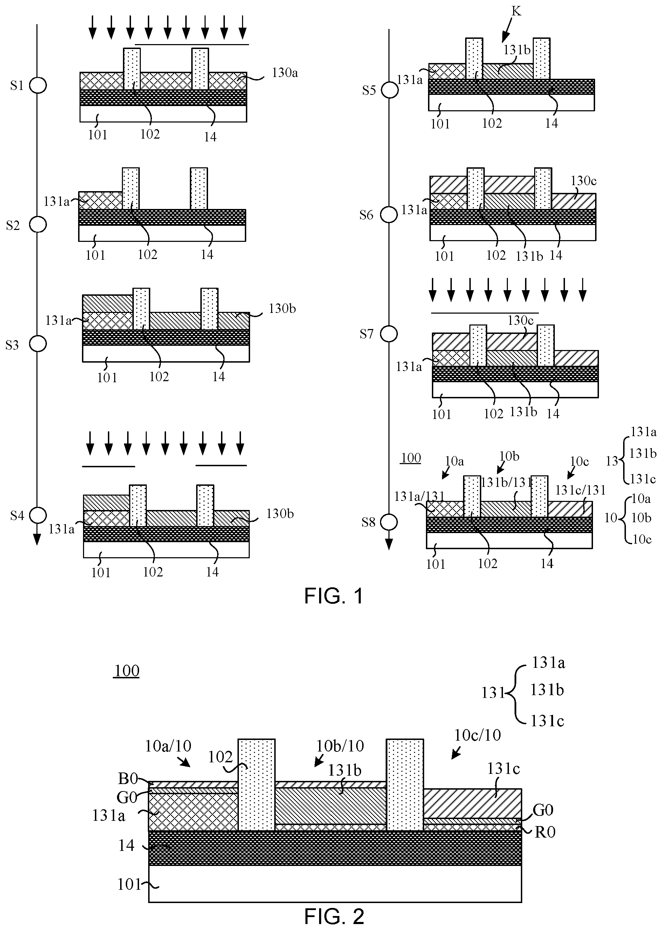

In some examples, as shown in FIG. 1, a structural diagram showing the manufacturing of a quantum dot light-emitting layer 13 of a light-emitting substrate 100 is provided. Referring to the last sub-figure in FIG. 1 (i.e., the sub-figure corresponding to step S8), the light-emitting substrate 100 includes: a substrate 101, as well as a pixel definition layer 102 and a plurality of light-emitting devices 10 that are located on a side of the substrate 101, with each light-emitting device 10 including a light-emitting pattern 131. Here, the pixel definition layer 102 has a plurality of openings K, and the plurality of light-emitting devices 10 may be disposed in one-to-one correspondence with the plurality of openings K.

As an example, the plurality of light-emitting devices 10 include first light-emitting devices 10a, second light-emitting devices 10b, and third light-emitting devices 10c. For example, a first light-emitting device 10a is one of a red light-emitting device, a green light-emitting device, and a blue light-emitting device; a second light-emitting device 10b is another one of the red light-emitting device, the green light-emitting device, and the blue light-emitting device; and a third light-emitting device 10c is the remaining one of the red light-emitting device, the green light-emitting device, and the blue light-emitting device. A light-emitting pattern 131a of the first light-emitting device 10a, a light-emitting pattern 131b of the second light-emitting device 10b, and a light-emitting pattern 131c of the third light-emitting device 10c form the quantum dot light-emitting layer 13.

The following describes a process of sequentially forming the light-emitting pattern 131a of the first light-emitting device 10a, the light-emitting pattern 131b of the second light-emitting device 10b, and the light-emitting pattern 131c of the third light-emitting device 10c. As shown in FIG. 1, the process includes steps S1 to S8.

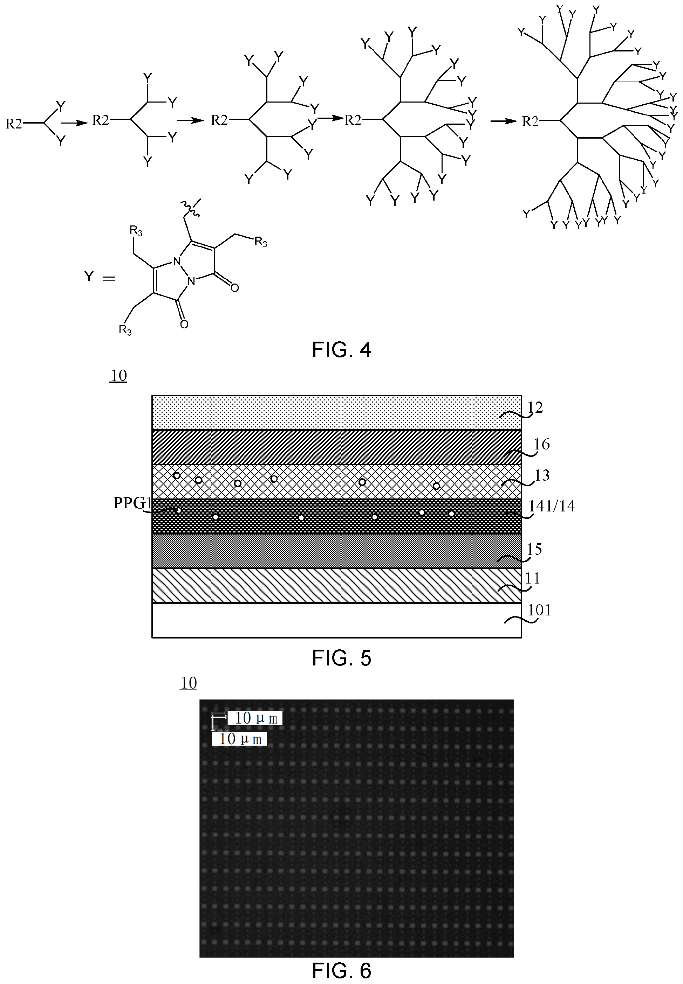

It will be noted that, in order to improve the efficiency of injection of electrons and holes into the light-emitting pattern 131, furthermore, a functional film layer 14 is disposed between the substrate 101 and the light-emitting pattern 131. For example, the functional film layer 14 is an electron transport layer 16 (as shown in FIG. 5) or a hole transport layer 141 (as shown in FIG. 5).

In step S1: a side of the functional film layer 14 away from the substrate 101 is coated with a first quantum dot light-emitting material to form an initial light-emitting pattern 130a; and the initial light-emitting pattern 130a is exposed, in which a region where the first light-emitting device 10a is to be formed is an exposed region.

In step S2: the initial light-emitting pattern 130a is developed, and the initial light-emitting pattern 130a in the exposed region is retained to form the light-emitting pattern 131a of the first light-emitting device 10a.

In step S3: a side of the light-emitting pattern 131a of the first light-emitting device 10a away from the substrate 101 is coated with a second quantum dot light-emitting material to form an initial light-emitting pattern 130b.

In step S4: the initial light-emitting pattern 130b is exposed, in which a region where the second light-emitting device 10b is to be formed is an exposed region.

In step S5: the initial light-emitting pattern 130b is developed, and the initial light-emitting pattern 130b in the exposed region is retained to form the light-emitting pattern 131b of the second light-emitting device 10b.

In step S6: a side of the light-emitting pattern 131b of the second light-emitting device 10b away from the substrate 101 is coated with a third quantum dot light-emitting material to form an initial light-emitting pattern 130c.

In step S7: the initial light-emitting pattern 130c is exposed, in which a region where the third light-emitting device 10c is to be formed is an exposed region.

In step S8: the initial light-emitting pattern 130c is developed, and the initial light-emitting pattern 130c in the exposed region is retained to form the light-emitting pattern 131c of the third light-emitting device 10c.

However, in an actual process for fabricating the light-emitting pattern 131 of the light-emitting substrate 100, as shown in FIG. 2, this patterning method has a problem of incomplete elution of the former layer of quantum dot light-emitting material (e.g., the first quantum dot light-emitting material), which results in residues of the former layer of quantum dot light-emitting material after the patterning process of the latter layer of quantum dot light-emitting material with another color (e.g., the second quantum dot light-emitting material).

As an example, as shown in FIG. 2, taking the sequential formation of the light-emitting pattern 131a of the first light-emitting device 10a, the light-emitting pattern 131b of the second light-emitting device 10b, and the light-emitting pattern 131c of the third light-emitting device 10c as an example, a residual layer G0 formed by the second quantum dot light-emitting material and a residual layer B0 formed by the third quantum dot light-emitting material are present on a side of the light-emitting pattern 131a of the first light-emitting device 10a away from the substrate 101; a residual layer R0 formed by the first quantum dot light-emitting material is present on a side of the light-emitting pattern 131b of the second light-emitting device 10b proximate to the substrate 101, and a residual layer B0 formed by the third quantum dot light-emitting material is present on a side of the light-emitting pattern 131b of the second light-emitting device 10b away from the substrate 101; and a residual layer R0 formed by the first quantum dot light-emitting material and a residual layer G0 formed by the second quantum dot light-emitting material are present on a side of the light-emitting pattern 131c of the third light-emitting device 10c proximate to the substrate 101.

The residues formed by these quantum dot light-emitting materials will cause a color mixing problem. When the light-emitting device 10 is powered on, the emission spectrum is prone to be impure, thereby affecting the performance of the light-emitting device 10.

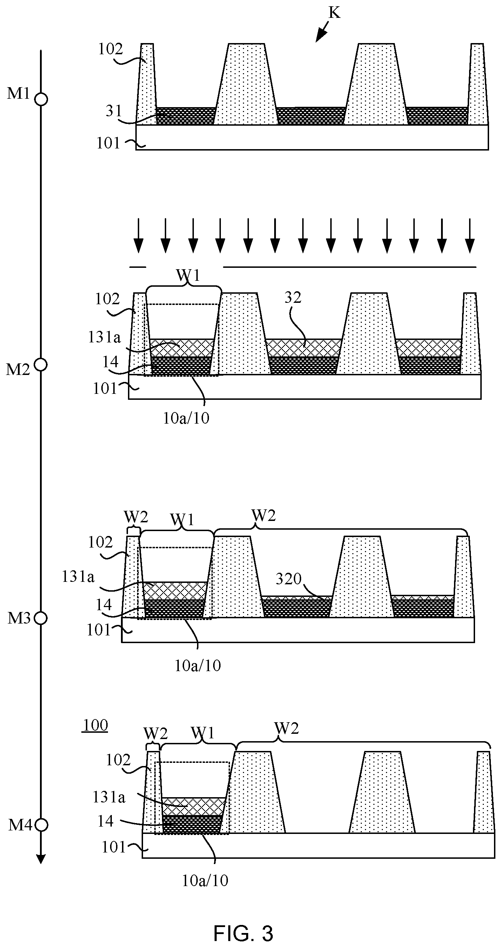

Therefore, in some examples, as shown in FIG. 3, the quantum dot patterning may be performed by arranging a sacrificial layer. Since the quantum dot light-emitting material on a side of the sacrificial layer away from the substrate 101 may be removed as the sacrificial layer is removed, this method may obtain full-color quantum dot light-emitting devices 10 and full-color active-matrix quantum dot light-emitting devices 10 with no residue and high color gamut.

As an example, the material of the sacrificial layer includes a carrier transport material and a cross-linking agent. The carrier transport material and the cross-linking agent form a cross-linking material under light irradiation, and the cross-linking material forms the functional film layer 14.

The following describes an example of a method for performing the quantum dot patterning by means of the sacrificial layer.

As an example, as shown in FIG. 3, the manufacturing method for the light-emitting device includes steps M1 to M4.

In step M1: a first film 31 is formed on the substrate 101, with a material of the first film 31 including a carrier transport material and a cross-linking agent.

As an example, a coating process is used to form the first film 31.

In step M2, a second film 32 is formed on a side of the first film 31 away from the substrate 101, with a material of the second film 32 including a first quantum dot material; and a first region W1 where the first light-emitting device 10a is located is exposed, to enable the carrier transport material and the cross-linking agent in the first region W1 to be crosslinked to generate a cross-linking material.

As an example, a coating process is used to form the second film 32.

In step M3: a portion of the second film 32 located in a second region W2 is dissolved with a first developer to remove the portion of the second film 32 located in the second region W2, in which the second region W2 is the remaining region for multiple light-emitting devices 10 excluding the region where the first light-emitting device 10a is located.

As an example, a portion of the first quantum dot material proximate to the substrate 101 may remain, so a first temporary residual layer 320 remains in the second region W2.

In step M4: a portion of the first film 31 located in the second region W2 is dissolved with a second developer, to remove the portion of the first film 31 located in the second region W2. A portion of the first film 31 located in the first region W1 forms the functional film layer 14, and a portion of the second film 32 located in the first region W1 forms the light-emitting pattern 131a of the first light-emitting device 10a.

As an example, the functional film layer 14 is an electron transport layer or a hole transport layer 141.

When the portion of the first film 31 located in the second region W2 is removed, the first temporary residual layer 320 is also removed. In this step, the portion of the first film 31 located in the second region W2 may be referred to as the sacrificial layer. Therefore, performing the quantum dot patterning by arranging the sacrificial layer may effectively prevent residue of the first quantum dot material in the second region W2.

Similarly, the same method may be used to form the light-emitting pattern 131b of the second light-emitting device 10b and the light-emitting pattern 131c of the third light-emitting device 10c, which will not be repeated here.

However, in a case where the functional film layer 14 is formed by cross-linking of the carrier transport material and the cross-linking agent, there is a problem that a carrier transport path is damaged due to the cross-linking between the carrier transport material and the cross-linking agent.

For example, the functional film layer 14 is a hole transport layer 141, the carrier transport material is poly[(9,9-dioctylfluorenyl-2,7-diyl)-co-(4,4'-(N-(4-sec-butylphenyl) diphenylamine)] (TFB) (also referred to as poly[(9,9-dioctylfluorenyl-2,7-diyl)-alt-(4,4'-(N-(4-butylphenyl)]), and the cross-linking agent is an aromatic azide compound. The aromatic azide compound generates nitrene under light irradiation, and the nitrene initiates a C-H insertion reaction and reacts with alkyl side chains of fluorene repeating units in TFB, thereby obtaining a cross-linking material. The cross-linking material forms the hole transport layer 141.

As an example, a structural formula of TFB is shown as follows:

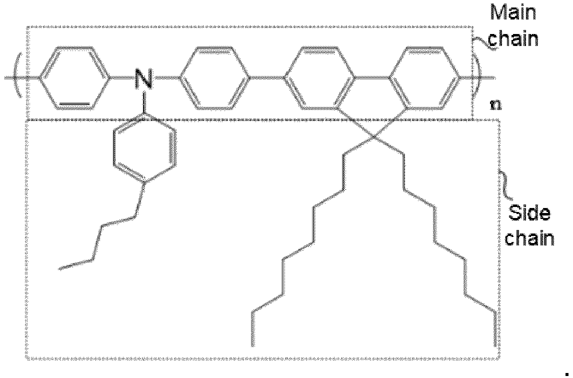

However, the inventors found that during this process, due to the high reactivity of the nitrene, there is a possibility that the nitrene will react with conjugated repeating units of the main chain of TFB, thereby disrupting a hole transport path, introducing defects into the hole transport layer 141, and resulting in a decrease in the efficiency of the light-emitting device 10.

In light of this, embodiments of the present disclosure provide a hole transport composition. The hole transport composition includes: a hole transport material and a cross-linking agent. The hole transport material includes: a main chain and a side chain connected to the main chain of the hole transport material. The side chain of the hole transport material has a sulfhydryl group, and the sulfhydryl group is configured to react with the cross-linking agent to form a chemical bond.

As an example, the main chain of the hole transport material includes at least one of polycarbazole, polybenzidine, a substituted or unsubstituted carbazole-fluorene copolymer, or a substituted or unsubstituted benzidine-fluorene copolymer.

The following example shows a structural formula of a hole transport material including a sulfhydryl group: 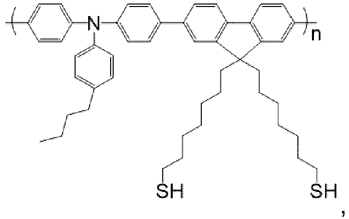 where n ≥ 1.

It will be noted that the sulfhydryl group is a photosensitive group, which generates a sulfur free-radical or a sulfur anion under light irradiation. The generated sulfur free-radical or sulfur anions may react with the cross-linking agent to form a chemical bond, so as to form the hole transport layer 141 with cross-linking material.

By setting the sulfhydryl group on the side chain of the hole transport material, the sulfhydryl group on the side chain of the hole transport material reacts with the cross-linking agent to form the cross-linking material, thereby forming the hole transport layer 141, which may effectively prevent the possibility of reaction of the conjugated repeating units of the main chain of the hole transport material, maintain the hole transport path of the hole transport layer 141, and thus improve the luminous efficiency of the light-emitting device 10.

In some examples, the cross-linking agent includes an activating group. The activating group includes at least one of a carbon-carbon double bond or a carbon-carbon triple bond.

It will be noted that the activating group refers to an atom or an atomic group capable of facilitating an electrophilic substitution reaction, and is used to increase the chemical reaction rate and cross-linking degree of the cross-linking material.

As an example, the activating group having a carbon-carbon double bond includes at least one of a styryl group, an acrylate group, an alkyl acrylate group, a maleic anhydride group, or a maleimide group.

The following example shows a structural formula of a cross-linking agent including an activating group:

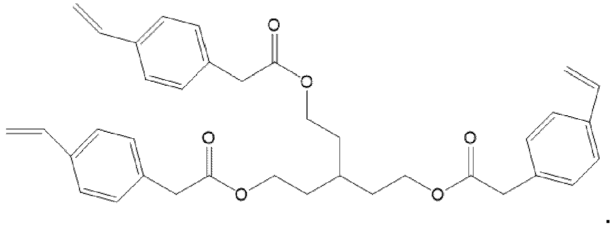

It will be noted that, compared with an azide compound, the activity of the sulfur free-radical or sulfur anion generated by the sulfhydryl group under light irradiation is lower than the activity of the nitrene generated by the azide compound under light irradiation. Therefore, in a case where the photosensitive group is a sulfhydryl group, an activating group needs to be added to the cross-linking agent to improve the reaction activity of the cross-linking agent, thereby increasing the reaction rate and cross-linking degree between the hole transport material and the cross-linking agent.

In some other embodiments, the cross-linking agent includes a sulfhydryl group, and the side chain of the hole transport material includes an activating group.

Since the activity of the sulfur free-radical or sulfur anion generated by the sulfhydryl group under light irradiation is relatively low, the sulfhydryl group in the cross-linking agent is connected to the side chain of the hole transport material, which may also effectively prevent the possibility of reaction of the conjugated repeating units on the main chain of the hole transport material, maintain the hole transport path of the hole transport layer 141, and thus improve the luminous efficiency of the light-emitting device 10.

The following examples show structural formulas of cross-linking agents including sulfhydryl groups: 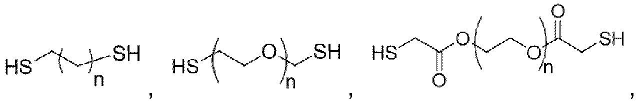 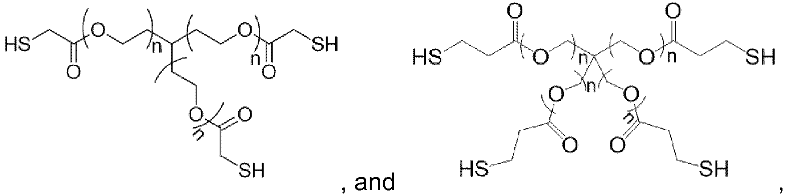 where n ≥ 1.

The following examples show structural formulas of hole transport materials with side chains including activating groups: 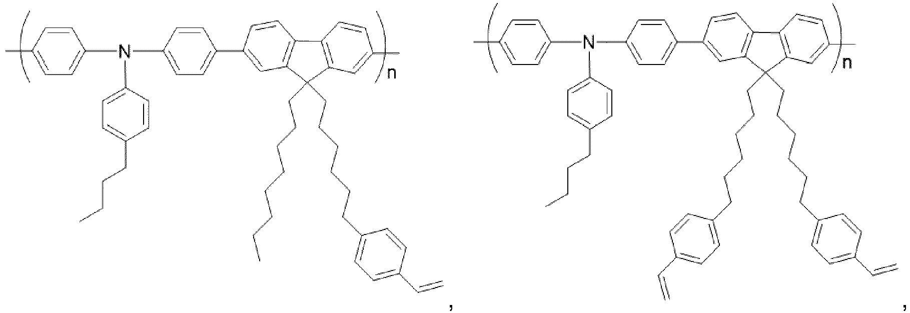 and 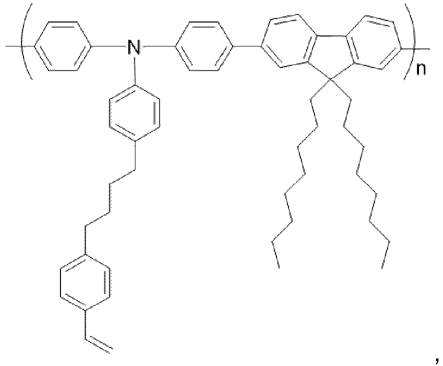 where n ≥ 1.

In some embodiments, in a case where the side chain of the hole transport material includes a sulfhydryl group and the cross-linking agent includes an activating group, and in a case where the cross-linking agent includes a sulfhydryl group and the side chain of the hole transport material includes an activating group, the hole transport composition further includes a free-radical photoinitiator.

It will be noted that the free-radical photoinitiator is used as a light-absorbing group and a free-radical-generating group to initiate a Thiol-ene click reaction, so as to connect the hole transport material to the cross-linking agent. The Thiol-ene click reaction, i.e., the sulfhydryl-alkene click reaction, means that a sulfhydryl group generates a free-radical under the action of ultraviolet light or heat, and then undergoes an addition reaction with an alkene to form a covalent bond connection.

As an example, the reaction formula of the Thiol-ene click reaction is as follows: 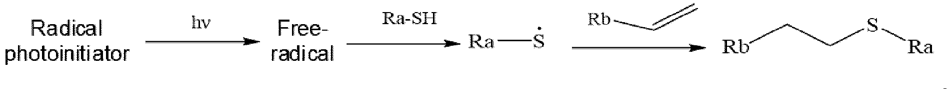 where Ra-SH represents a material including a sulfhydryl group. For example, Ra-SH represents one of the hole transport material and the cross-linking agent. 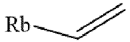 represents a material including an activating group. For example, 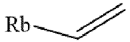 represents the other one of the hole transport material and the cross-linking agent. Under light irradiation, the free-radical photoinitiator generates a radical, and the radical initiates the Thiol-ene click reaction between Ra-SH and 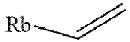 to form a cross-linking material.

Ra-SH and 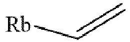 undergo the Thiol-ene click reaction, with low activation energy required for the reaction, low energy of a reactive intermediate, few side reactions, and high yield. The atom utilization rate may reach 100%, which may improve the cross-linking degree between the hole transport material and the cross-linking agent.

As an example, the free-radical photoinitiator includes at least one of 2-benzyl-2-(dimethylamino)-1-(4-(morpholin-4-yl)phenyl)butan-1-one (denoted as Irgacure 369), or bis[2,6-difluoro-3-(1H-pyrrol-1-yl)phenyl]titanocene (denoted as Irgacure 784).

The structural formula of Irgacure 369 is shown as follows:

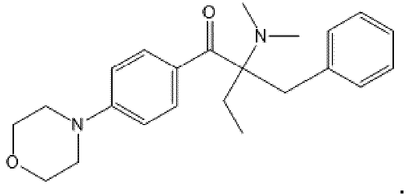

Under light irradiation with an exposure wavelength of 365 nm, Irgacure 369 generates carbon free-radicals. The carbon free-radicals initiate the Thiol-ene click reaction between Ra-SH and 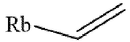 to form a cross-linking material.

The chemical formula for the generation of the carbon free-radicals by Irgacure 369 under light irradiation with the exposure wavelength of 365 nm is as follows:

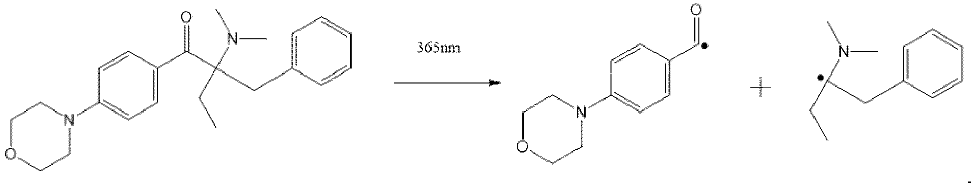

The structural formula of Irgacure 784 is shown as follows:

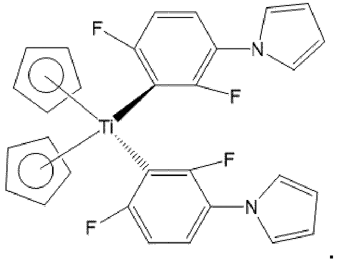

Under light irradiation with an exposure wavelength of 405 nm, Irgacure 784 generates free-radicals. The free-radicals initiate the Thiol-ene click reaction between Ra-SH and 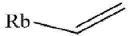 to form a cross-linking material.

The chemical formula for the generation of the free-radicals by Irgacure 784 under light irradiation with the exposure wavelength of 405 nm is as follows:

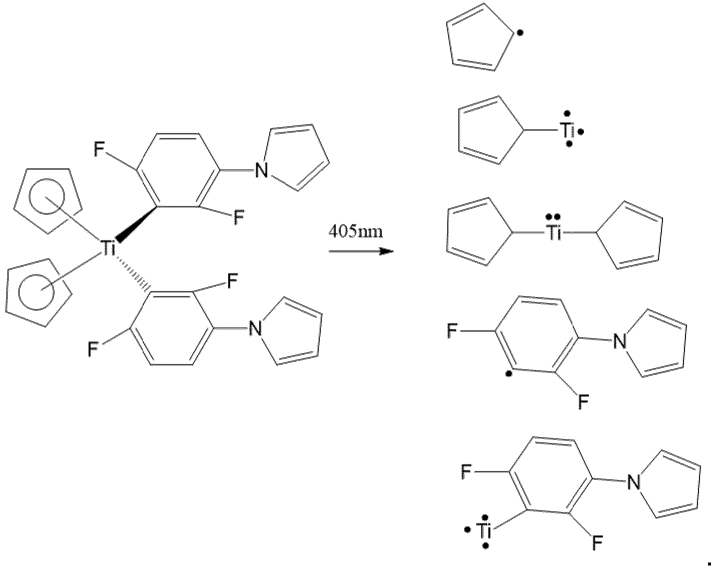

The free-radical photoinitiator may change the exposure wavelength for cross-linking between the hole transport material and the cross-linking agent. The longer the exposure wavelength, the lower the photon energy, and the less damage is caused to the conjugated repeating units of the hole transport material and the quantum dots of the light-emitting device 10, which is beneficial to improving the optical performance and service life of the light-emitting device 10.

The hole transport layer 141 is formed by cross-linking a hole transport material whose side chain includes one of a sulfhydryl group and an activating group and a cross-linking agent that includes the other of the sulfhydryl group and the activating group, which may effectively prevent the possibility of reaction of the conjugated repeating units on the main chain of the hole transport material, and maintain the hole transport path of the hole transport layer 141. Moreover, the provision of the activating group may increase the chemical reaction rate and cross-linking degree between the hole transport material and the cross-linking agent, so as to improve the luminous efficiency of the light-emitting device 10.

However, the inventors have found that sulfhydryl groups are easily oxidized between themselves to form disulfide bonds, which affects the cross-linking between the sulfhydryl group and the activating group, thereby affecting the cross-linking degree between the hole transport material and the cross-linking agent. In addition, the sulfhydryl group usually has a foul odor, which makes materials with sulfhydryl groups inconvenient to use.

In light of this, embodiments of the present disclosure provide a cross-linking agent. The cross-linking agent includes a sulfhydryl group protected by a photoremovable group, where the photoremovable group is removed under light irradiation to release the sulfhydryl group, a sulfur free-radical or a sulfur anion.

The photoremovable protecting group (PPG) refers to a group capable of undergoing a decomposition reaction under the action of light.

The sulfhydryl group being protected by the photoremovable group may not only solve the problem that the sulfhydryl group has a foul odor and is inconvenient to use, but also endow the protected sulfhydryl group with better stability and higher controllability. The photoremovable group is removed under light irradiation to release the sulfhydryl group, a sulfur free-radical or a sulfur anion, and the released sulfhydryl group, sulfur free-radical or sulfur anion may further participate in a cross-linking reaction.

In some examples, the photoremovable group is selected from at least one of the following substituents: 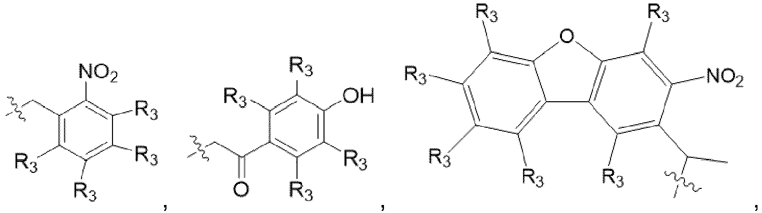 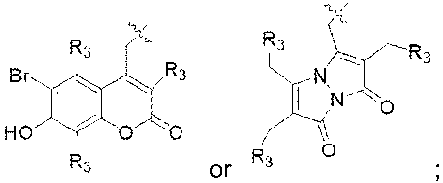 where each R₃ is independently selected from any one of H, an alkyl group, an electron-withdrawing group, an electron-donating group, and a conjugated group.

It will be noted that the symbol " 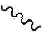 " indicates that this bond is used to connect to the sulfhydryl group.

As an example, the sulfhydryl group is connected to the photoremovable group 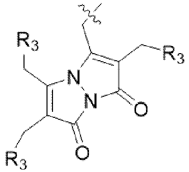 and undergoes a Thiol-ene click reaction with a double bond as follows:

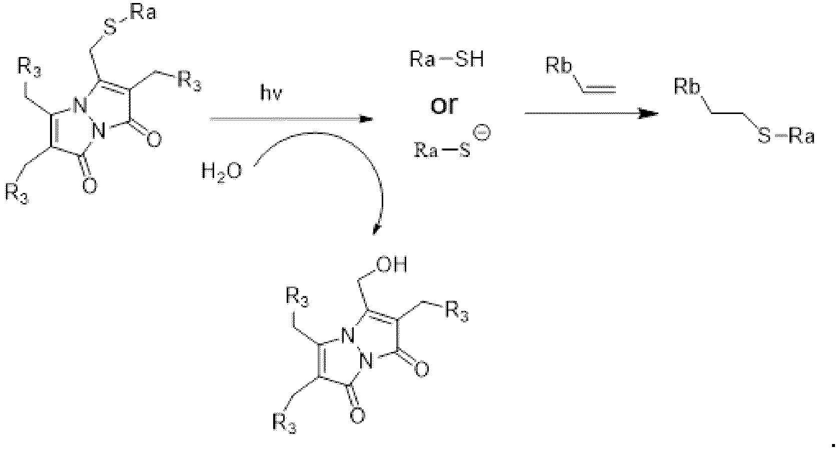

The above photoremovable group is capable of being connected to the sulfhydryl group to protect the sulfhydryl group. The presence of the photoremovable group not only solves the problem that the sulfhydryl group has a foul odor and is inconvenient to use, but also improves the stability of the sulfhydryl group.

In some examples, the cross-linking agent is selected from at least one of structures represented by the following general formula I:

PPG-S-R1-S-PPG I;

where R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and PPG is the photoremovable group.

In some embodiments, PPG is selected from 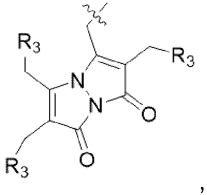 and the cross-linking agent is selected from at least one of structures represented by the following formula I-I: 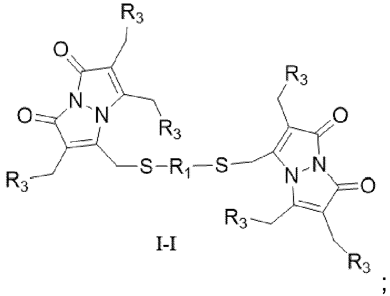 where R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; each R₃ is independently selected from any one of H, an alkyl group, an electron-withdrawing group, an electron-donating group, and a conjugated group.

As an example, the cross-linking agent is selected from at least one of the following structural formulas: 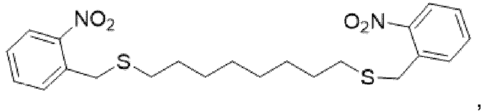 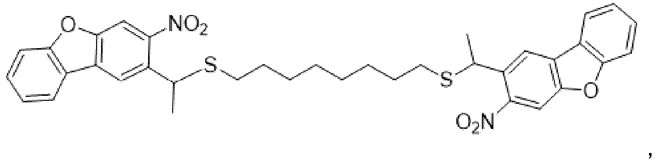 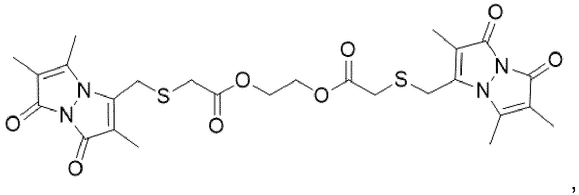 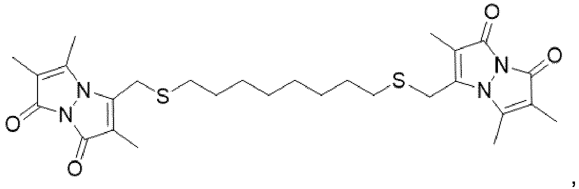 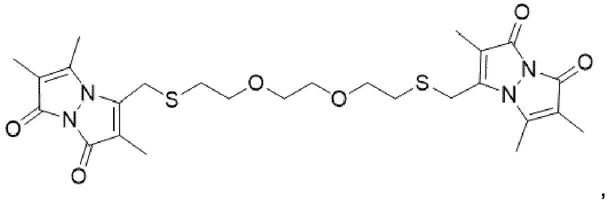 or

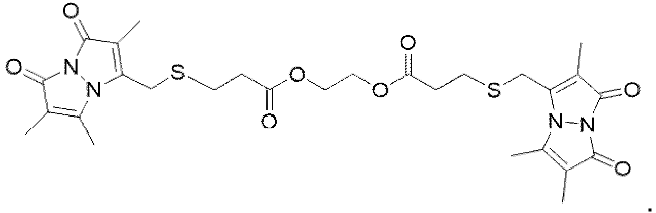

Combinations of photoremovable groups with different structures and R1 with different structures may provide cross-linking agents with different structures. In addition, R1 including an alkyl group, an ester bond, or an ethylene glycol bond may regulate the solubility of the cross-linking agent in different solvents.

In some other examples, the cross-linking agent is selected from at least one of structures represented by the following general formula II:

R2-(R1-S-PPG)ₙ₁ II;

where R2 is selected from any one of a secondary carbon atom, a tertiary carbon atom, and a quaternary carbon atom; and n1 ≥ 2.

For example, n1=2, and the cross-linking agent is selected from at least one of structures represented by the following general formula:

PPG-S-R1-R2-R1-S-PPG;

where in the above general formula, these two PPG groups may be the same or different, and these two R1 groups may be the same or different, which are not limited here.

For example, R2 is a secondary carbon atom, and the general formula may be represented as PPG-S-R1-CH₂-R1-S-PPG.

As an example, n1=3, and the cross-linking agent is selected from at least one of structures represented by the following general formula: 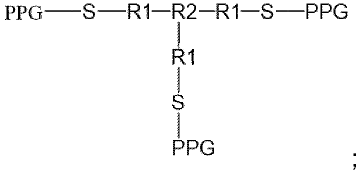 where in the above general formula, these three PPG groups may be the same or different, and these three R1 groups may be the same or different, which are not limited here.

For example, R2 is a tertiary carbon atom, the above general formula may be represented as follows:

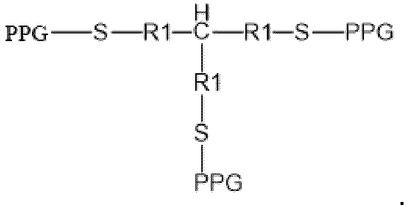

For example, R2 is -CCH₃, and the above general formula may be represented as follows:

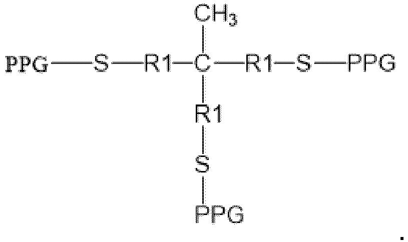

As an example, n1=4, and the cross-linking agent is selected from at least one of structures represented by the following general formula: 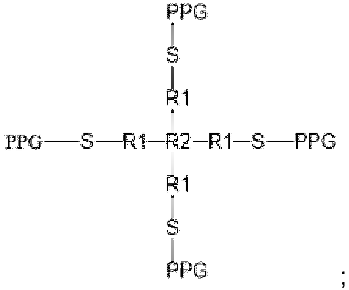 where in the above general formula, these four PPG groups may be the same or different, and these four R1 groups may be the same or different, which are not limited here.

For example, R2 is a quaternary carbon atom, and the above general formula may be represented as follows:

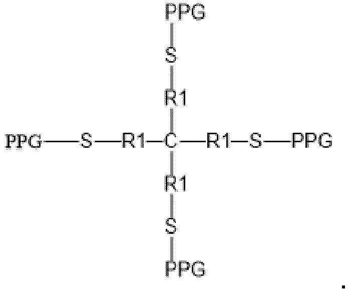

In some embodiments, the cross-linking agent is selected from at least one of structures represented by the following formula I-II: 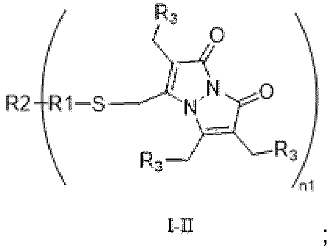 where R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; R2 is selected from any one of a secondary carbon atom, a tertiary carbon atom, and a quaternary carbon atom; and n1 ≥ 2.

As an example, as shown in FIG. 4, the cross-linking agent may have a dendritic polymer structure. The cross-linking agent includes a plurality of groups 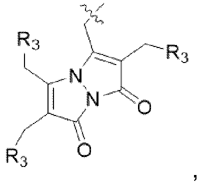 which are denoted by Y in the figure. A linking group connecting R2 and Y may be the same as R1; and each R₃ is independently selected from any one of H, an alkyl group, an electron-withdrawing group, an electron-donating group, and a conjugated group.

As an example, the cross-linking agent is selected from at least one of the following structural formulas: 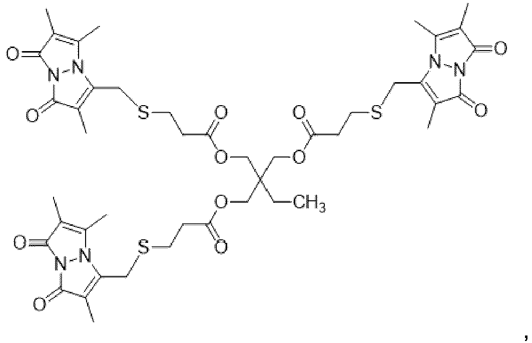 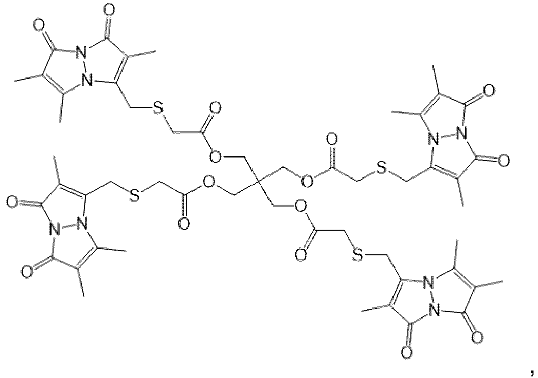 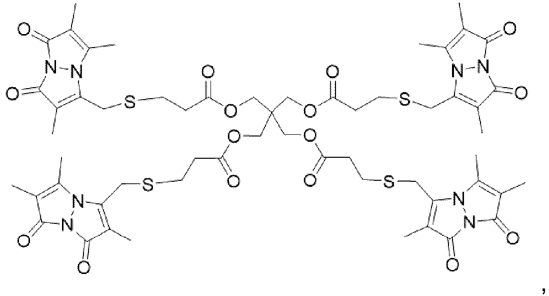 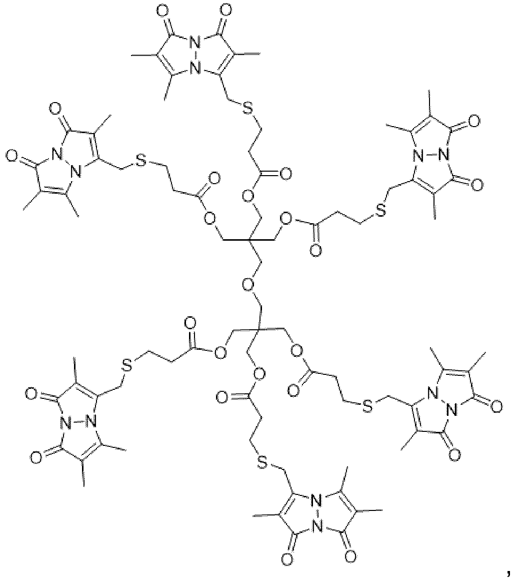 or

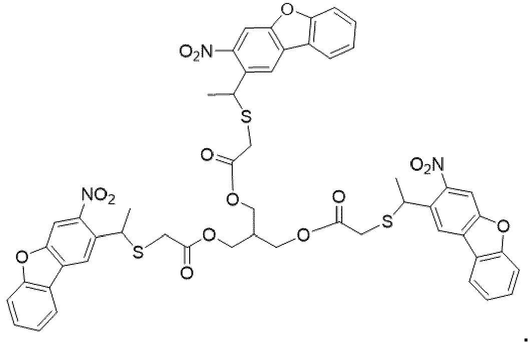

It will be noted that the symbol "-" indicates that the terminal end of this bond is CH₃.

In some embodiments, the cross-linking agent is selected from at least one of structures represented by the following general formulas VI-1 or VI-2: 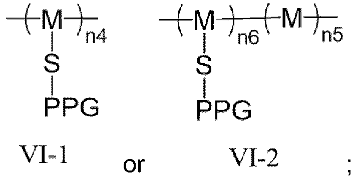 where each M is the same or different, and M is a repeating unit formed by polymerization of at least one selected from styrene, acrylate, alkyl acrylate, maleic anhydride, or caprolactone styrene; n4 is selected from positive integers greater than or equal to 2; n5+n6 is selected from positive integers greater than or equal to 2; and a value of n6/(n5+n6) ranges from 1% to 1.

As an example, n4 is selected from positive integers greater than or equal to 2 and less than or equal to 15. For example, n4 is 2, 4, 6, 7, 10, 11, 12, 13, 14, or 15, which is not limited here.

As an example, n5+n6 is selected from positive integers greater than or equal to 2 and less than or equal to 15; and the value of n6/(n5+n6) ranges from 1% to 1. For example, the value of n6/(n5+n6) ranges from 1/4 to 3/4, and n5+n6 is 2, 4, 6, 7, 10, 11, 12, 13, 14, or 15, which are not limited here.

As an example, the cross-linking agent is selected from at least one of the following structural formulas:

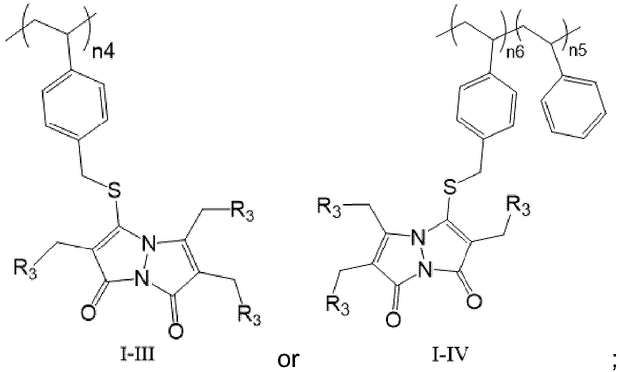

R₃ is independently selected from any one of H, an alkyl group, an electron-withdrawing group, an electron-donating group, and a conjugated group.

The following exemplarily describes a manufacturing method for the aforementioned cross-linking agent.

### Example 1

The structural formula of the cross-linking agent is shown as follows:

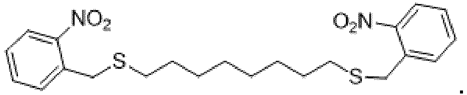

The molecular weight of the cross-linking agent is 448.60.

The manufacturing method for the cross-linking agent is as follows

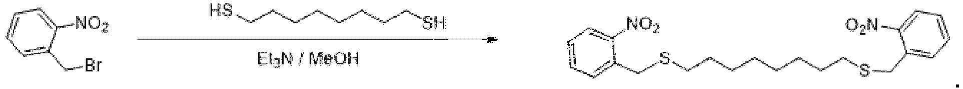

475 mg (2.2 mmol) of 2-nitrobenzyl bromide (CAS No.: 3958-60-9), 178 mg (1 mmol) of 1,8-octanedithiol (CAS No.: 1191-62-4), and 404 mg (4 mmol) of triethylamine (CAS No.: 121-44-8) are dissolved in 10 mL of methanol, and the reaction proceeds at room temperature for 12 hours. After that, the methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 245 mg, and the production rate of the cross-linking agent is 54.7%, with ¹H NMR (600 MHz, CDCl₃) δ (ppm): 7.94 (d, 2H), 7.57-7.37 (m, 6H), 4.05 (s, 4H), 2.42 (t, 4H), 1.55-1.18 (m, 14H), where NMR refers to nuclear magnetic resonance data of the cross-linking agent.

### Example 2

The structural formula of the cross-linking agent is shown as follows:

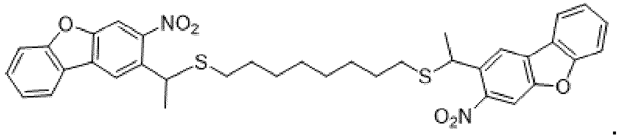

The molecular weight of the cross-linking agent is 656.81.

The manufacturing method for the cross-linking agent is as follows:

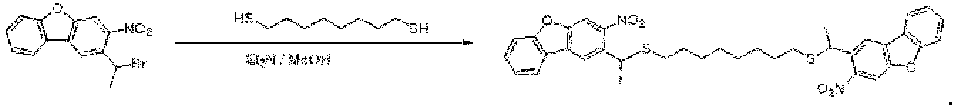

702 mg (2.2 mmol) of 1-(2'-bromoethyl)-2-nitrodibenzofuran, 178 mg (1 mmol) of 1,8-octanedithiol, and 404 mg (4 mmol) of triethylamine are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 310 mg, and the production rate of the cross-linking agent is 47.3%, with ¹H NMR (600 MHz, CDCl₃) δ (ppm): 8.43 (s, 2H), 8.09 (s, 4H), 7.66-7.57 (m, 4H), 7.48-7.44 (m, 4H), 4.03 (q, 2H), 2.42 (t, 4H), 2.22 (d, 6H), 1.55-1.18 (m, 14H).

### Example 3

The structural formula of the cross-linking agent is shown as follows:

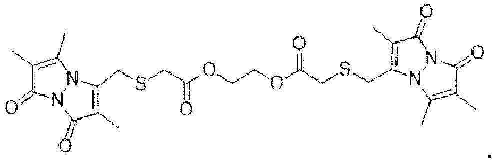

The molecular weight of the cross-linking agent is 590.67.

The manufacturing method for the cross-linking agent is as follows:

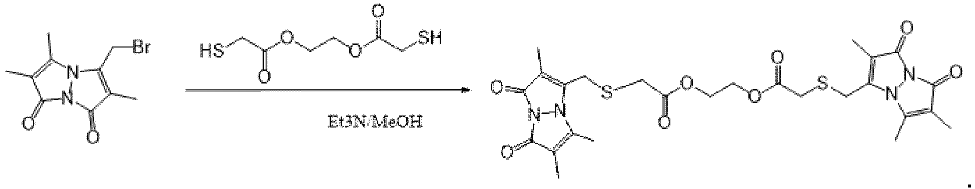

3-bromomethyl-2,5,6-trimethyl-pyrazolo[1,2-a]pyrazole-1,7-dione (CAS No.: 71418-44-5, 390 mg, and 1.44 mmol), 2-(2-sulfanylacetyl)oxyethyl 2-sulfanylacetate (CAS No.: 123-81-9, 126 mg, and 0.6 mmol), and triethylamine (CAS No.: 121-44-8, 145 mg, and 1.44 mmol) are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 152 mg, and the production rate of the cross-linking agent is 42%, with ¹H NMR (600 MHz, CDCl₃) δ (ppm): 4.09 (s, 4H), 3.91(s, 4H), 3.41 (s, 4H) 2.44 (s, 6H), 1.87 (s, 6H), 1.79 (s, 6H).

MS: m/2: 297.08981, where MS refers to mass spectrometry data of the cross-linking agent.

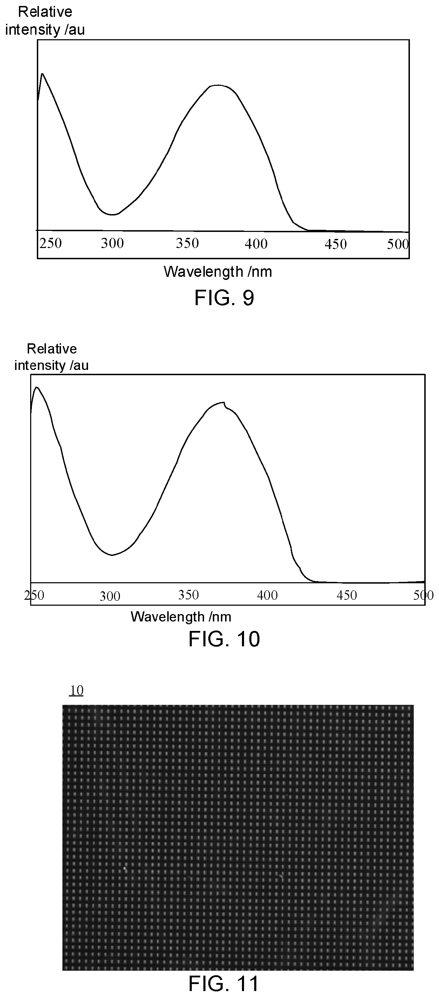

As shown in FIG. 9, FIG. 9 is an ultraviolet-visible absorption spectrum of the cross-linking agent shown in Example 3 of the present disclosure, where the horizontal axis represents wavelength in units of nm, and the vertical axis represents relative intensity in units of au. It can be seen from FIG. 9 that a light absorption peak exists in a wavelength range of 300 nm to 430 nm, which indicates that the cross-linking agent has light absorption property, and light in this wavelength range may be used for exposure to initiate the reaction of the cross-linking agent.

### Example 4

The structural formula of the cross-linking agent is shown as follows:

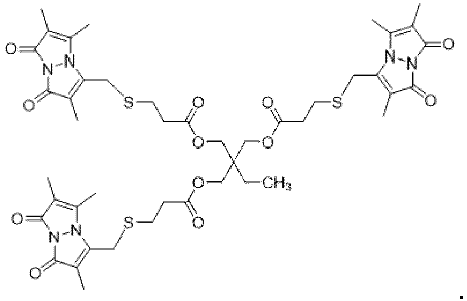

The molecular weight of the cross-linking agent is 969.15.

The manufacturing method for the cross-linking agent is as follows:

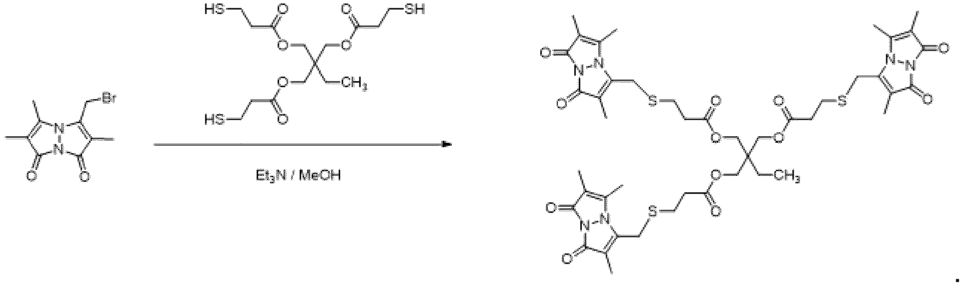

300 mg (1.1 mmol) of 3-bromomethyl-2,5,6-trimethyl-pyrazolo[1,2-a]pyrazole-1,7-dione, 122 mg (0.31 mmol) of trimethylolpropane tris(3-mercaptopropionate) (CAS No.: 33007-83-9), and 111 mg (1.10 mmol) of triethylamine are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 138 mg, and the production rate of the cross-linking agent is 46%, with ¹H NMR (600 MHz, CDCl₃) δ (ppm): 3.73 (s, 12H), 2.87 (t, 6H), 2.66 (t, 6H), 2.42 (s, 9H), 1.92 (s, 9H), 1.85 (s, 9H), 1.74 (q, 2H), 0.89 (t, 3H).

As shown in FIG. 10, FIG. 10 is an ultraviolet-visible absorption spectrum of the cross-linking agent shown in Example 4 of the present disclosure. It can be seen from FIG. 10 that a light absorption peak exists in a wavelength range of 300 nm to 430 nm, which indicates that the cross-linking agent has light absorption property, and light in this wavelength range may be used for exposure to initiate the reaction of the cross-linking agent.

### Example 5

The structural formula of the cross-linking agent is shown as follows:

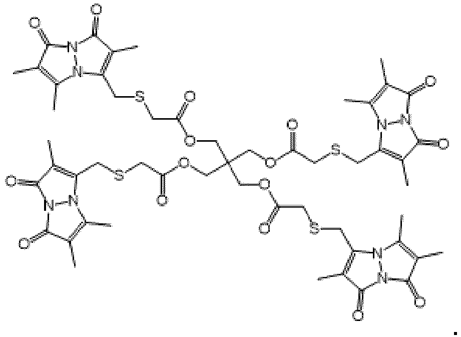

The molecular weight of the cross-linking agent is 1193.34.

The manufacturing method for the cross-linking agent is as follows:

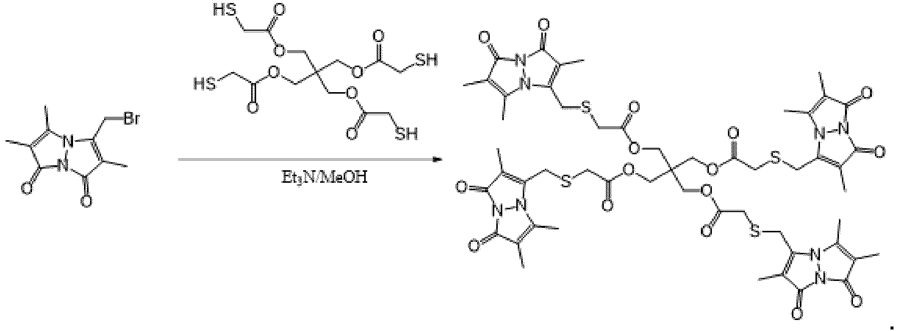

300 mg (1.1 mmol) of 3-bromomethyl-2,5,6-trimethyl-pyrazolo[1,2-a]pyrazole-1,7-dione, 99.6 mg (0.23 mmol) of pentaerythritol tetrakis(thioglycolate) (CAS No.: 10193-99-4), and 111 mg (1.10 mmol) of triethylamine are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 128 mg, and the production rate of the cross-linking agent is 47.2%, with ¹H NMR (600 MHz, CDCl₃) δ (ppm): 3.85 (s, 8H), 3.75 (s, 8H), 3.27 (s, 8H), 2.41 (s, 12H), 1.92 (s, 12H), 1.83 (s, 12H).

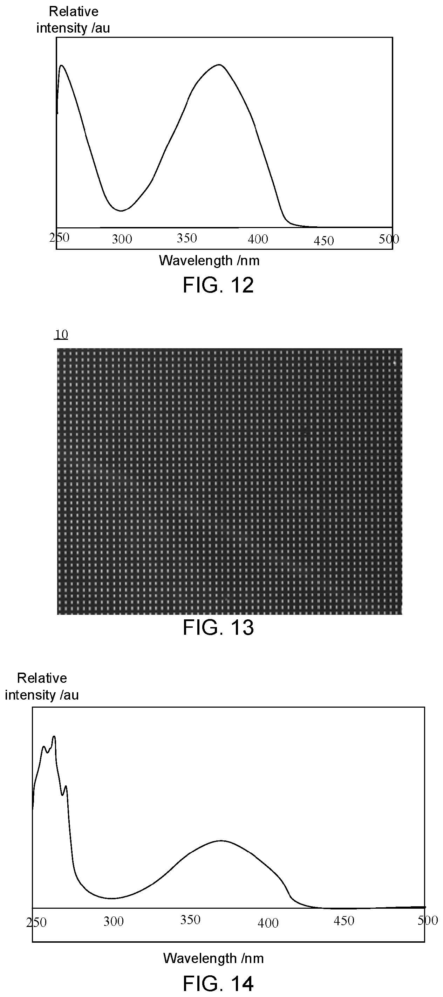

As shown in FIG. 12, FIG. 12 is an ultraviolet-visible absorption spectrum of the cross-linking agent shown in Example 5 of the present disclosure. It can be seen from FIG. 12 that a light absorption peak exists in a wavelength range of 300 nm to 430 nm, which indicates that the cross-linking agent has light absorption property, and light in this wavelength range may be used for exposure to initiate the reaction of the cross-linking agent.

Here, since the raw material has 3-bromomethyl-2,5,6-trimethyl-pyrazolo[1,2-a]pyrazole-1,7-dione, and the pyrazolo[1,2-a]pyrazole-1,7-dione group has three methyl groups at the 2-, 5-, and 6-carbon positions in total, each pyrazolo[1,2-a]pyrazole-1,7-dione group in the obtained cross-linking agent has three methyl groups located at the 2-, 5-, and 6-carbon positions respectively. Moreover, the nuclear magnetic data 1.83 (s, 12H), i.e., 12H at 1.83 ppm, confirms that there are 4 methyl groups in total at the 5-carbon positions of the four pyrazolo[1,2-a]pyrazole-1,7-dione groups of the cross-linking agent.

The cross-linking agent is a small molecule with a molecular weight of 1193.34 and is an oil-soluble material. Since the cross-linking agent is a small molecule, when the cross-linking agent is used for cross-linking of quantum dots, the presence of the cross-linking agent will not increase the distance between quantum dots and therefore does not cause a decrease in the electrical efficiency of the light-emitting device 10.

### Example 6

The structural formula of the cross-linking agent is shown as follows:

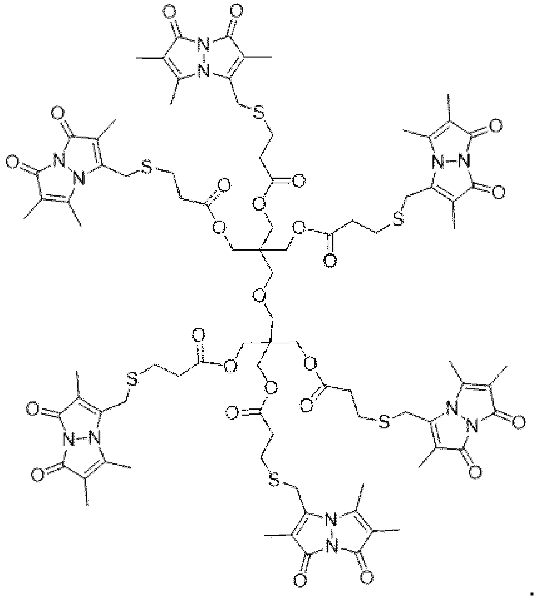

The molecular weight of the cross-linking agent is 1924.24.

The manufacturing method for the cross-linking agent is as follows:

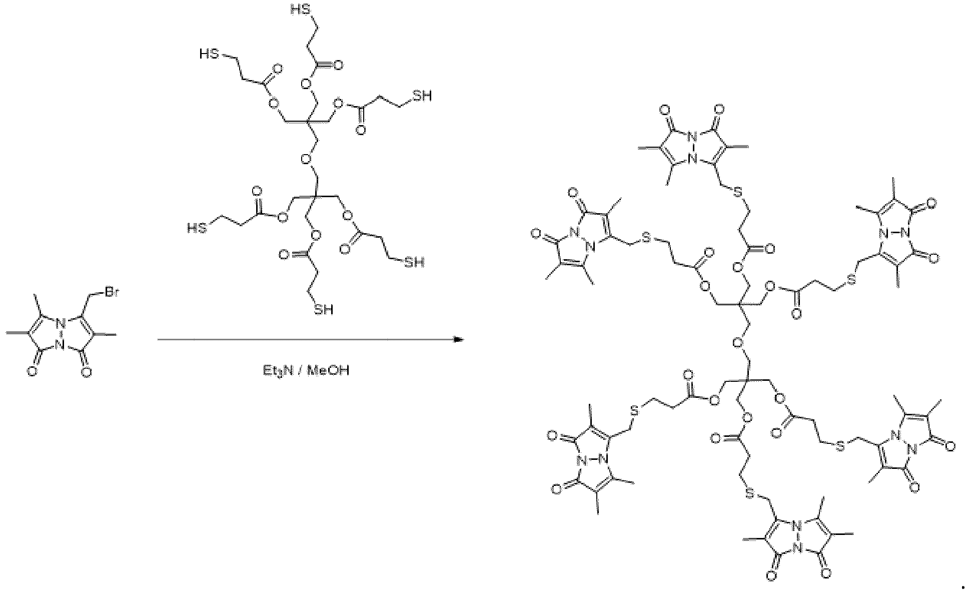

300 mg (1.1 mmol) of 3-bromomethyl-2,5,6-trimethyl-pyrazolo[1,2-a]pyrazole-1,7-dione, 120 mg (0.15 mmol) of dipentaerythritol hexakis(3-mercaptopropionate) (CAS No.: 25359-71-1), and 111 mg (1.10 mmol) of triethylamine are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 133 mg, and the production rate of the cross-linking agent is 45.1%, with ¹H NMR (600 MHz, CDCl₃) δ (ppm): 4.21 (dd, 4H), 3.38 - 3.73 (m, 24H), 2.87 (t, 12H), 2.66 (t, 12H), 2.42 (s, 18H), 1.92 (s, 18H), 1.86 (s, 18H).

As shown in FIG. 14, FIG. 14 is an ultraviolet-visible absorption spectrum of the cross-linking agent shown in Example 6 of the present disclosure. It can be seen from FIG. 14 that a light absorption peak exists in a wavelength range of 300 nm to 430 nm, which indicates that the cross-linking agent has light absorption property, and light in this wavelength range may be used for exposure to initiate the reaction of the cross-linking agent.

### Example 7

The structural formula of the cross-linking agent is shown as follows:

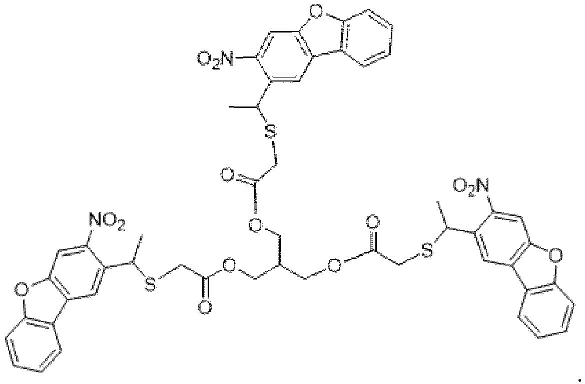

The manufacturing method for the cross-linking agent is as follows:

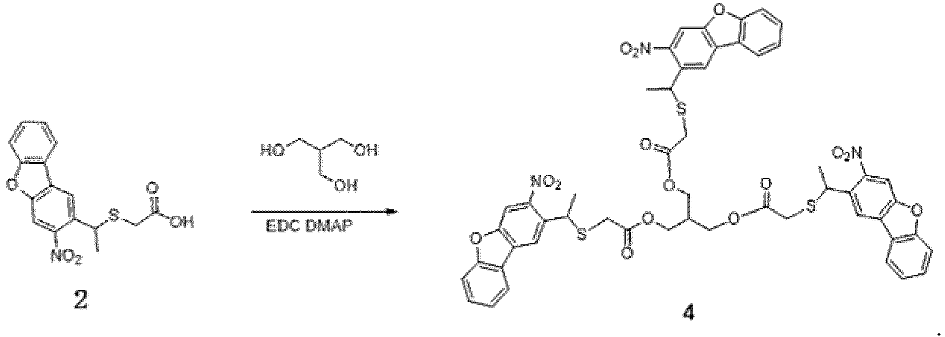

Intermediate 2 (0.166 g, 0.5 mmol) and 2-hydroxymethyl-1,3-propanediol (16 mg, 0.15 mmol) are placed in 10 mL of dichloromethane, 50 mg of 4-dimethylaminopyridine (DMAP) and 150 mg of dichloroethane are added, and the mixture is stirred at 25°C for 12 hours. The mixture is dried by rotary evaporation, 50 mL of saturated sodium chloride solution is added, and the mixture is extracted three times with dichloromethane and then dried by rotary evaporation. The product is purified by column chromatography and dried by rotary evaporation to obtain a cross-linking agent, denoted as Product 4. The yield of the cross-linking agent is 63 mg, and the production rate of the cross-linking agent is 40%, with ¹H NMR δ (ppm): 8.57 (3H), 7.98 (3H), 7.67 (3H), 7.54 (3H), 7.31 - 7.40 (6H), 4.31 (6H), 3.92 (3H), 3.40 (6H), 1.58 (9H), 1.21 (1H).

In some examples, the cross-linking agent further includes a carrier transport regulating group.

Introducing the carrier regulating group into the cross-linking agent may improve the carrier transport performance of the cross-linking agent.

As an example, the cross-linking agent includes a main chain and a side chain connected to the main chain of the cross-linking agent. The carrier transport regulating group is located on the main chain of the cross-linking agent, and the sulfhydryl group protected by the photoremovable group is located on the side chain of the cross-linking agent.

By the setting in which the carrier transport regulating group is located on the main chain of the cross-linking agent, and the sulfhydryl group protected by the photoremovable group is located on the side chain of the cross-linking agent, the cross-linking reaction of the cross-linking agent occurs on the side chain of the cross-linking agent, so as to effectively prevent the cross-linking reaction of the cross-linking agent from affecting the carrier transport performance of the carrier transport regulating group of the cross-linking agent.

In some examples, the cross-linking agent is selected from at least one of structures represented by the following general formula III:

R4-(R1-S-PPG)ₙ₂ III;

where R4 is a substituted or unsubstituted carrier transport regulating group; and n2 ≥ 2.

As an example, n2=2, and the above general formula may be represented as R4-(R1-S-PPG)₂; n2=3, the above general formula may be represented as R4-(R1-S-PPG)₃; and n2=4, the above general formula may be represented as R4-(R1-S-PPG)₄.

In some examples, the carrier transport regulating group is a hole transport group, and the hole transport group includes at least one of a triphenylamine group, a carbazole group, or a linked triphenylamine group.

It will be noted that the hole transport group refers to a functional group capable of efficiently transporting holes (i.e., positive charge carriers) in organic semiconductor materials.

As an example, the cross-linking agent is selected from at least one of the following structural formulas: 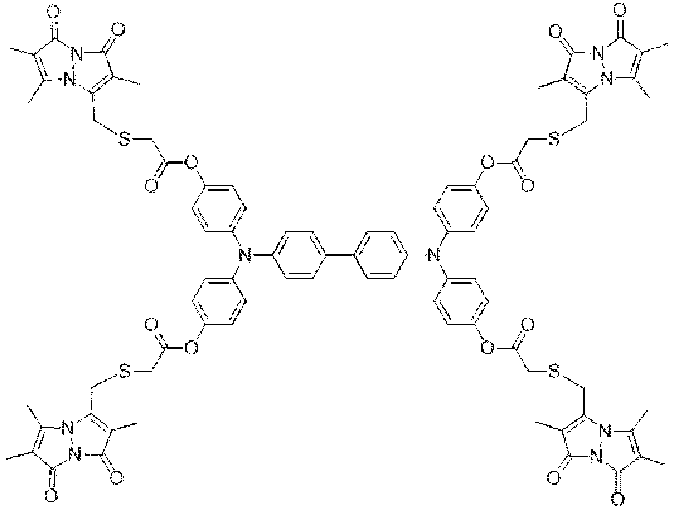 or

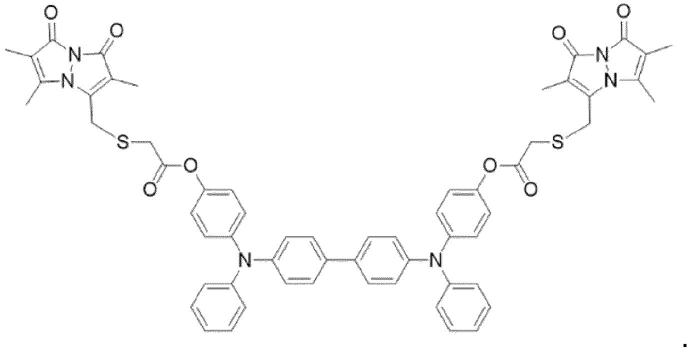

The following exemplarily describes a manufacturing method for a cross-linking agent including a hole transport group.

### Example 8

The structural formula of the cross-linking agent is shown as follows:

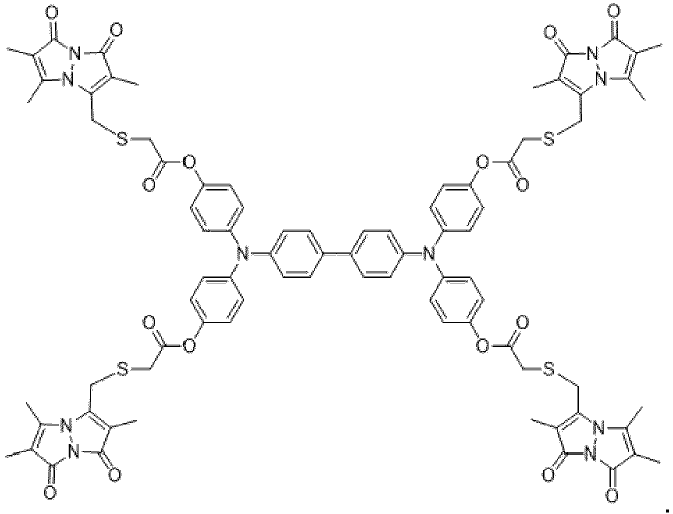

The manufacturing method for the cross-linking agent is as follows 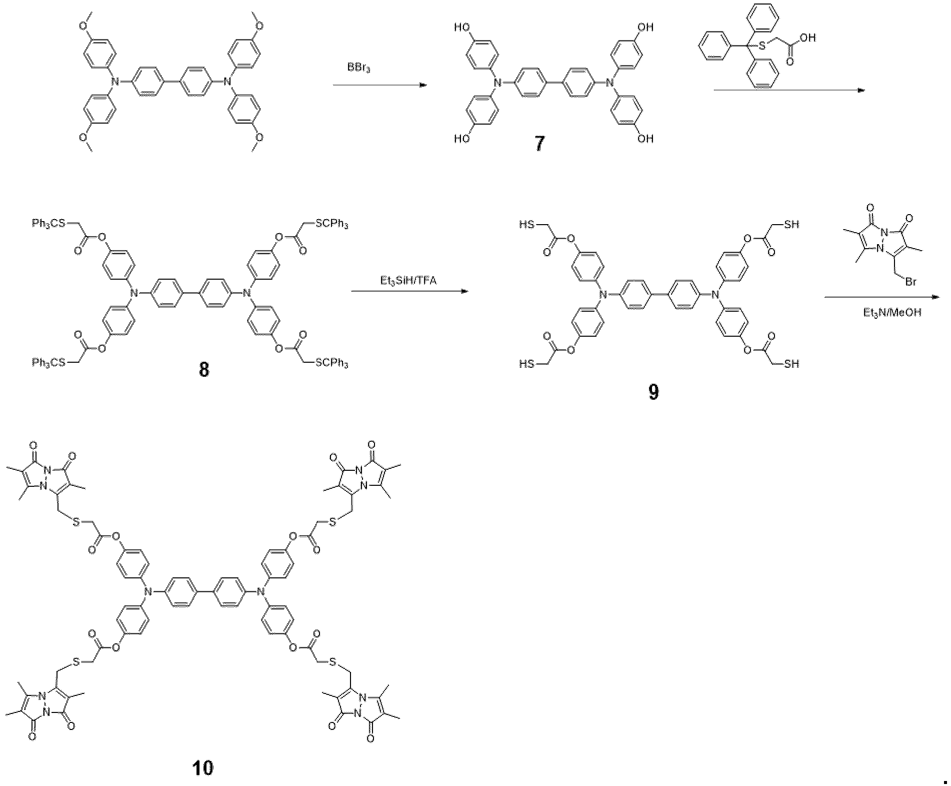
1): 6.08 g (10 mmol) of N4,N4,N4',N4'-tetrakis(4-methoxyphenyl)-[1,1'-biphenyl]-4,4'-diamine is dissolved in 50 mL of anhydrous dichloromethane, the temperature of the mixture is lowered to 0°C, and then a boron tribromide solution in dichloromethane is added dropwise with a volume of 60 mL and a molar concentration of boron tribromide of 2 mol/L. After that, the temperature of the mixture is raised to room temperature and the mixture is stirred for 12 hours. A large amount of water is then added to quench the reaction. Dilute hydrochloric acid is added for acidification, and the resulted brownish-black precipitate is collected by filtration, washed with deionized water, and dried under reduced pressure to obtain Product 7. The yield of Product 7 is 3.9 g, and the production rate of Product 7 is 71%, with ¹H NMR (600 MHz, CDCl₃) δ (ppm): 9.44 (s, 4H), 7.57 (d, 4H), 7.37 (d, 4H), 6.99 (d, 8H), 6.75 (d, 8H).
2): 6.68 g (20 mmol) of 2-(tritylsulfanyl)acetic acid, 2.76 g (5 mmol) of Product 7, 50 mg of DMAP (4-dimethylaminopyridine), and 150 mg of EDC (1-(3-dimethylaminopropyl)-3-ethylcarbodiimide) are mixed in 50 mL of dichloromethane, and the mixture is stirred at room temperature for 12 hours. After dichloromethane is removed by concentration, the mixture is purified by silica gel column chromatography to obtain Product 8. The yield of Product 8 is 8.47 g, and the production rate of Product 8 is 93%, with ¹H NMR (600 MHz, CDCl₃) δ (ppm): 7.57 (d, 4H), 7.30 - 7.16 (m, 80H), 7.06 (d, 8H), 3.54 (s, 8H).
3): 7.26 g (4 mmol) of Product 8 is dissolved in anhydrous dichloromethane, the solution is cooled to 0°C, 3.72 g (32 mmol) of triethylsilane and 31 g (320 mmol) of trifluoroacetic acid (TFA) are added, and stirring is continued at 0°C for 15 minutes. The temperature of the mixture is then slowly raised to room temperature, and after stirring is continued at room temperature for one hour, a saturated NaHCO₃ solution is added to quench the reaction. After water/dichloromethane extraction, the organic phase is dried, concentrated, and purified by silica gel column chromatography to obtain Product 9. The yield of Product 9 is 3.29 g, and the production rate of Product 9 is 97%, with ¹H NMR (600 MHz, CDCl₃) δ (ppm): 7.57 (d, 4H), 7.37 (d, 4H), 7.18 (d, 8H), 7.06 (d, 8H), 3.54 (s, 8H), 1.48 (t, 4H).
4): 4.58 g (17 mmol) of 3-bromomethyl-2,5,6-trimethyl-pyrazolo[1,2-a]pyrazole-1,7-dione, 3 g (3.52 mmol) of Product 9, and 1.72 g (17 mmol) of triethylamine are dissolved in 100 mL of methanol, and the reaction proceeds at room temperature for 12 hours. After that, methanol is removed by concentration under reduced pressure, and the residue is dissolved in 100 mL of dichloromethane. After washing three times with a saturated ammonium chloride solution, the residue is dried over anhydrous Na₂SO₄ and concentrated. The concentrate is purified by silica gel column chromatography to obtain a cross-linking agent, denoted as Product 10. The yield of Product 10 is 2.94 g, and the production rate of Product 10 is 52%, with ¹H NMR (600 MHz, CDCl₃) δ (ppm): 7.57 (d, 4H), 7.37 (d, 4H), 7.18 (d, 8H), 7.06 (d, 8H), 3.73 (s, 8H), 3.54 (s, 8H), 2.42 (s, 12H), 1.92 (s, 12H), 1.86 (s, 12H).

### Example 9

The structural formula of the cross-linking agent is shown as follows:

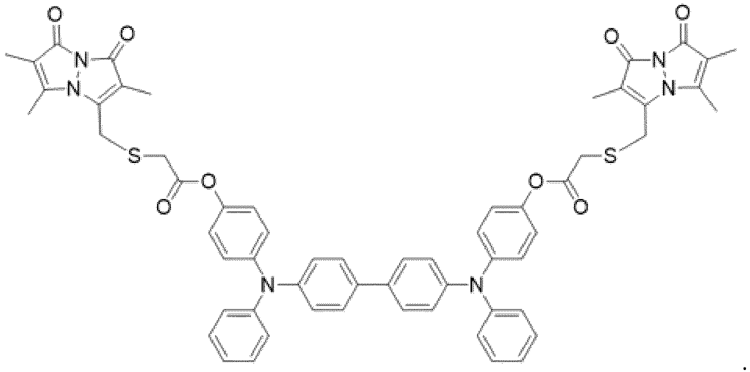

The molecular weight of the cross-linking agent is 1046.23.

The manufacturing method for the cross-linking agent is as follows: 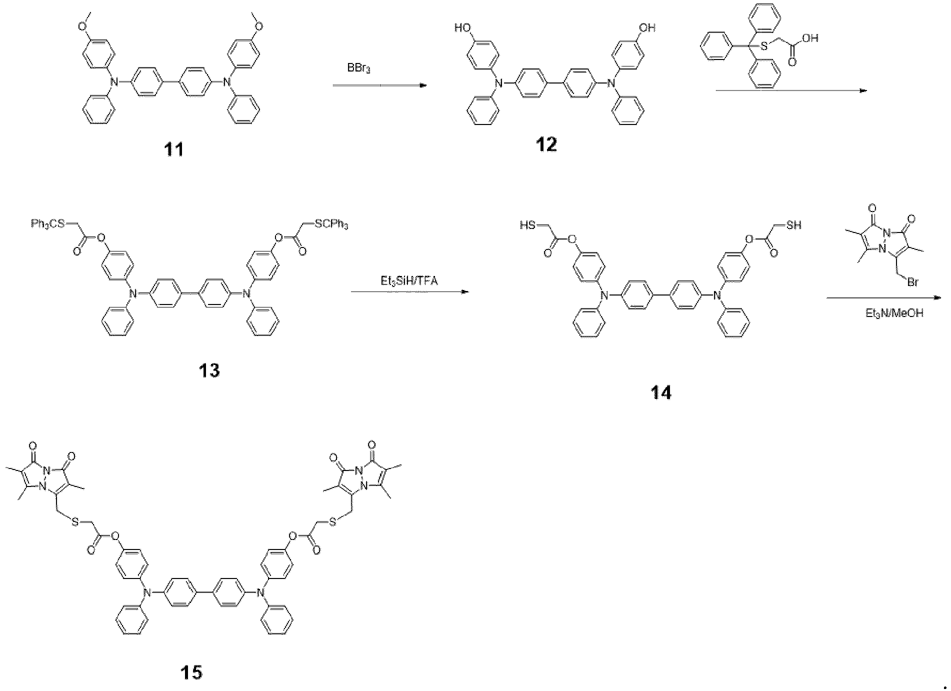
1): 10 mmol of raw material 11 is dissolved in 50 mL of anhydrous dichloromethane, the temperature of the mixture is lowered to 0°C, and then a boron tribromide solution in dichloromethane is added dropwise with a volume of 60 mL and a molar concentration of boron tribromide of 2 mol/L. After that, the temperature of the mixture is raised to room temperature and the mixture is stirred for 12 hours. A large amount of water is then added to quench the reaction. Dilute hydrochloric acid is added for acidification, and the resulted brownish-black precipitate is collected by filtration, washed with deionized water, and dried under reduced pressure to obtain Product 12.
2): 6.68 g (20 mmol) of 2-(tritylsulfanyl)acetic acid, 5 mmol of Product 12, 50 mg of DMAP (4-dimethylaminopyridine), and 150 mg of EDC (1-(3-dimethylaminopropyl)-3-ethylcarbodiimide) are mixed in 50 mL of dichloromethane, and the mixture is stirred at room temperature for 12 hours. After dichloromethane is removed by concentration, the mixture is purified by silica gel column chromatography to obtain Product 13.
3): 4 mmol of Product 13 is dissolved in anhydrous dichloromethane, the solution is cooled to 0°C, 3.72 g (32 mmol) of triethylsilane and 320 mmol of trifluoroacetic acid (TFA) are added, and stirring is continued at 0°C for 15 minutes. The temperature of the mixture is then slowly raised to room temperature, and after stirring is continued at room temperature for one hour, a saturated NaHCO₃ solution is added to quench the reaction. After water/dichloromethane extraction, the organic phase is dried, concentrated, and purified by silica gel column chromatography to obtain Product 14.
4): 4.58 g (17 mmol) of 3-bromomethyl-2,5,6-trimethyl-pyrazolo[1,2-a]pyrazole-1,7-dione, 3.52 mmol of Product 14, and 1.72 g (17 mmol) of triethylamine are dissolved in 100 mL of methanol, and the reaction proceeds at room temperature for 12 hours. After that, methanol is removed by concentration under reduced pressure, and the residue is dissolved in 100 mL of dichloromethane. After washing three times with a saturated ammonium chloride solution, the residue is dried over anhydrous Na₂SO₄ and concentrated. The concentrate is purified by silica gel column chromatography to obtain a cross-linking agent, denoted as Product 15, with ¹H NMR (600 MHz, CDCl₃) δ (ppm): 7.57 (d, 4H), 7.37 (d, 4H), 7.24 - 7.18 (m, 8H), 7.08 - 7.00 (m, 8H), 3.73 (s, 4H), 3.54 (s, 4H), 2.42 (s, 6H), 1.92 (s, 6H), 1.86 (s, 6H).

### Example 10

The structural formula of the cross-linking agent is shown as follows:

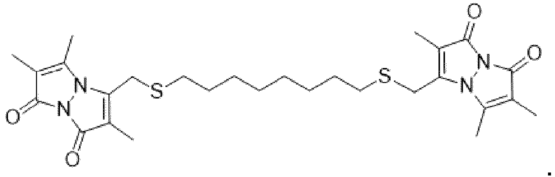

The manufacturing method for the cross-linking agent is as follows:

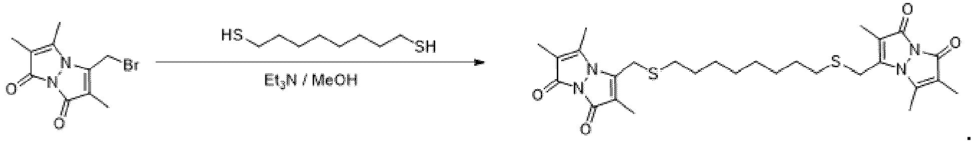

3-bromomethyl-2,5,6-trimethyl-pyrazolo[1,2-a]pyrazole-1,7-dione (CAS No.: 71418-44-5, 600 mg, 2.22 mmol), 1,8-octanedithiol (CAS No.: 1191-62-4, 178 mg, 1 mmol), and triethylamine (CAS No.: 121-44-8, 404 mg, 4 mmol) are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 311 mg, and the production rate of the cross-linking agent is 55.7%, with ¹H NMR (600 MHz, CDCl₃) δ (ppm): 4.05 (s, 4H), 2.42 (t, 4H), 2.40 (s, 6H), 1.87 (s, 6H), 1.83 (s, 6H), 1.55 - 1.18 (m, 14H).

An alkyl chain is located between the two thioether groups of the cross-linking agent. The cross-linking agent has good solubility in non-polar solvents, and non-polar solvents may be used to dissolve the cross-linking agent. For example, non-polar solvents include hexane, toluene, and chlorobenzene.

### Example 11

The structural formula of the cross-linking agent is shown as follows:

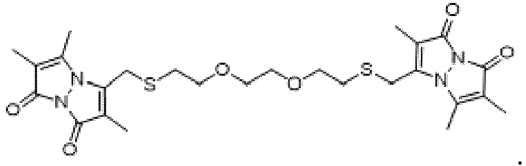

The manufacturing method for the cross-linking agent is as follows:

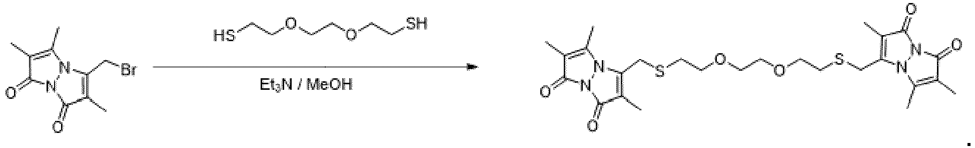

3-bromomethyl-2,5,6-trimethyl-pyrazolo[1,2-a]pyrazole-1,7-dione (CAS No.: 71418-44-5, 600 mg, 2.22 mmol), 2,2'-[1,2-ethandiylbis(oxy)]bis(ethanthiol) (CAS No.: 14970-87-7, 182 mg, 1 mmol), and triethylamine (CAS No.: 121-44-8, 404 mg, 4 mmol) are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 343 mg, and the production rate of the cross-linking agent is 61%, with ¹H NMR (600 MHz, CDCl₃) δ (ppm): 3.74 (t, 4H), 3.52 (t, 4H), 3.11 (s, 4H), 2.54 (t, 4H), 2.40 (s, 6H), 2.34 (s, 6H), 2.26 (s, 6H).

The cross-linking agent of Example 3 has two ester bonds between its two thioether groups, and the cross-linking agent of Example 10 has an alkyl chain between its two thioether groups. Compared with Example 3 and Example 10, the cross-linking agent of the above example has two ether groups between its two thioether groups, and the polarity of this cross-linking agent is between that of the cross-linking agent of Example 3 and that of the cross-linking agent of Example 10.

### Example 12

The structural formula of the cross-linking agent is shown as follows:

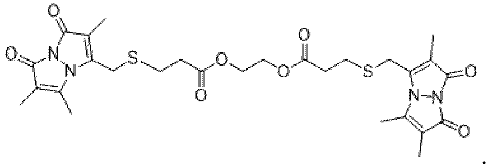

The manufacturing method for the cross-linking agent is as follows:

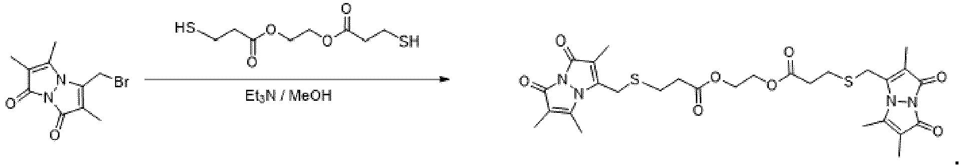

3-bromomethyl-2,5,6-trimethyl-pyrazolo[1,2-a]pyrazole-1,7-dione (CAS No.: 71418-44-5, 390 mg, 1.44 mmol), ethylene bis(3-mercaptopropionate) (CAS No.: 22504-50-3, 126 mg, 0.6 mmol), and triethylamine (CAS No.: 121-44-8, 145 mg, 1.44 mmol) are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 152 mg, and the production rate of the cross-linking agent is 42%, with ¹H NMR (600 MHz, CDCl₃) δ (ppm): 4.31 (s, 4H), 3.11 (s, 4H), 2.83 (t, 4H), 2.58 (t, 4H), 2.42 (s, 6H), 1.89 (s, 6H), 1.83 (s, 6H).

### Example 13

The structural formula of the cross-linking agent is shown as follows:

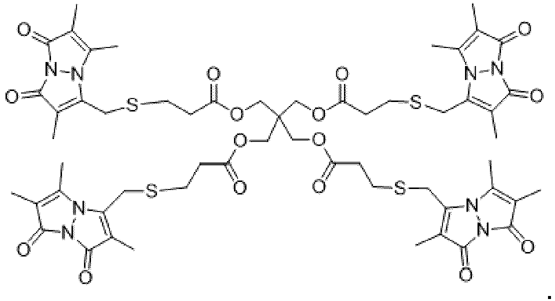

The manufacturing method for the cross-linking agent is as follows: 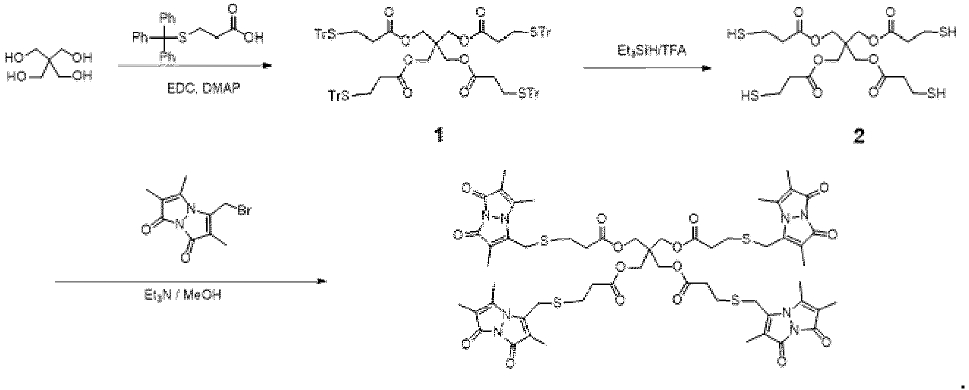 where Ph is the abbreviation for phenyl, and Tr is the abbreviation for trityl.

24 mmol of 3-(tritylthio)propionic acid, 5 mmol of pentaerythritol, 50 mg of DMAP (4-dimethylaminopyridine), and 150 mg of EDC (1-(3-dimethylaminopropyl)-3-ethylcarbodiimide) are mixed in 150 mL of dichloromethane, and the mixture is stirred at room temperature for 12 hours. After dichloromethane is removed by concentration, the mixture is purified by silica gel column chromatography to obtain Product 1. The yield of Product 1 is 6.78 g, and the production rate is 93.2%, with ¹H NMR (600 MHz, CDCl₃) δ (ppm): 7.29 - 7.18 (m, 60H), 3.94 (s, 8H), 2.83 (t, 8H), 2.58 (t, 8H).

4 mmol of Product 1 is dissolved in anhydrous dichloromethane, the solution is cooled to 0°C, 32 mmol of triethylsilane (Et₃SiH) and 320 mmol of trifluoroacetic acid (TFA) are added, and stirring is continued at 0°C for 15 minutes. The temperature of the mixture is then slowly raised to room temperature, and after stirring is continued at room temperature for one hour, a saturated NaHCO₃ solution is added to quench the reaction. After water/dichloromethane extraction, the organic phase is dried, concentrated, and purified by silica gel column chromatography to obtain Product 2. The yield of Product 2 is 1.75 g, and the production rate is 97.5%, with ¹H NMR (600 MHz, CDCl₃) δ (ppm): 3.94 (s, 8H), 2.95 (t, 8H), 2.51 (t, 8H), 1.42 (t, 4H).

3-bromomethyl-2,5,6-trimethyl-pyrazolo[1,2-a]pyrazole-1,7-dione (CAS No.: 71418-44-5, 300 mg, 1.1 mmol), Product 2 (112 mg, 0.25 mmol), and triethylamine (CAS No.: 121-44-8, 111 mg, 1.10 mmol) are dissolved in 10 mL of methanol, and the reaction proceeds at room temperature for 12 hours. After that, methanol is removed by concentration under reduced pressure, and the residue is dissolved in 50 mL of dichloromethane. After washing three times with a saturated ammonium chloride solution, the residue is dried over anhydrous Na₂SO₄ and concentrated. The concentrate is purified by silica gel column chromatography. The yield of the cross-linking agent is 144 mg, and the production rate of the cross-linking agent is 46%, with ¹H NMR (600 MHz, CDCl₃) δ (ppm): 3.96 (s, 8H), 3.18 (s, 8H), 2.83 (t, 8H), 2.58 (t, 8H), 2.41 (s, 12H), 1.89 (s, 12H), 1.83 (s, 12H).

### Example 14

The structural formula of the cross-linking agent is shown as follows: 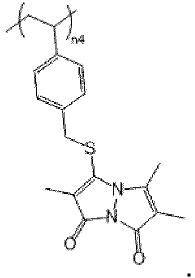 where n4 is selected from positive integers greater than or equal to 2.

The manufacturing method for the cross-linking agent is as follows:

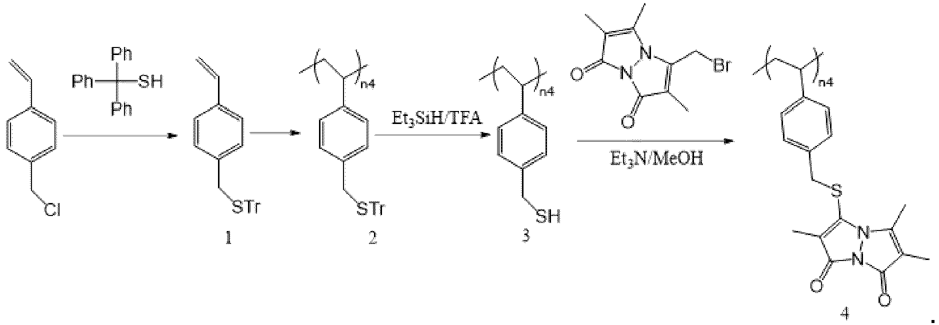

4-(chloromethyl)styrene (CAS No.: 1592-20-7, 15.2 g, 0.1 mol), triphenylmethyl mercaptan (CAS No.: 3695-77-0, 33.1 g, 0.12 mol), and triethylamine (CAS No.: 121-44-8, 14.5 g, 0.144 mol) are dissolved in 400 mL of methanol, and the reaction proceeds at room temperature for 12 hours. After that, methanol is removed by concentration under reduced pressure, and the residue is dissolved in 100 mL of dichloromethane. After washing three times with a saturated ammonium chloride solution, the residue is dried over anhydrous Na₂SO₄ and concentrated. The concentrate is purified by silica gel column chromatography to obtain Product 1 structure 2 in the above formula. The yield of Product 1 is 18.8 g, and the production rate of Product 1 is 48%, with ¹H NMR (600 MHz, CDCl₃) δ (ppm): 7.59 - 7.22 (m, 19H), 6.72 (dd, 1H), 5.76 (d, 1H), 5.72 (d, 1H), 3.67 (d, 2H).

Product 1 (3.92 g, 10 mmol) in the above formula, 4-cyano-4-((phenylcarbonothioyl)thio)pentanoic acid (CAS No.: 201611-92-9, 0.28 g, 1 mmol), and azobisisobutyronitrile (0.055 g, 0.3 mmol) are dissolved in 50 mL of dry tetrahydrofuran. After three cycles of freeze-pump-thaw to remove water and oxygen, the mixture is heated to 100°C under a nitrogen atmosphere and stirred for reaction for 3 hours. After cooling to room temperature, precipitation is performed with methanol. The precipitate is filtered and dissolved in a small amount of tetrahydrofuran. After three cycles of dissolution-precipitation, the precipitate is dried in vacuum to obtain Product 2 in the above formula. The yield of Product 2 is 2.75 g, and the production rate of Product 2 is 70.2%, with ¹H NMR (600 MHz, CDCl₃) δ (ppm): 7.59 - 7.22 (b, 19H), 3.67 (b, 2H), 2.55 (b, 1H), 1.50 (b, 2H). GPC:Mn=3900, PDI=1.2, where GPC is gel permeation chromatography data, which is used to measure the molecular weight of polymer materials, Mn represents number-average molecular weight, and PDI represents polymer dispersity index.

2.35 g of Product 2 in the above formula is dissolved in anhydrous tetrahydrofuran, the solution is cooled to 0°C, 48 mmol of triethylsilane and 480 mmol of trifluoroacetic acid (TFA) are added, and stirring is continued at 0°C for 15 minutes. The temperature of the mixture is then slowly raised to room temperature, and after stirring is continued at room temperature for one hour, a saturated NaHCO₃ solution is added to quench the reaction. After water/dichloromethane extraction, precipitation is performed with methanol. The precipitate is filtered and dissolved in a small amount of tetrahydrofuran. After three cycles of dissolution-precipitation, the precipitate is dried in vacuum to obtain Product 3 in the above formula. The yield of Product 3 is 0.94 g, and the production rate of Product 3 is 87%, with ¹H NMR (600 MHz, CDCl₃) δ (ppm): 7.24 - 7.10 (b, 4H), 3.67 (b, 2H), 2.55 (b, 1H), 1.50 (b, 2H), 1.40 (b, 1H).

3-bromomethyl-2,5,6-trimethyl-pyrazolo[1,2-a]pyrazole-1,7-dione (CAS No.: 71418-44-5, 1.64 g, 6 mmol), Product 3 (0.6 g), and triethylamine (CAS No.: 121-44-8, 1009 mg, 10 mmol) are dissolved in 100 mL of dichloromethane, and the reaction proceeds at room temperature for 12 hours. After that, precipitation is performed with methanol. The precipitate is filtered and dissolved in a small amount of tetrahydrofuran. After three cycles of dissolution-precipitation, the precipitate is dried in vacuum. The yield of the cross-linking agent is 0.68 g, and the production rate of the cross-linking agent is 35%, with ¹H NMR (600 MHz, CDCl₃) δ (ppm): 7.23 (b, 2H), 7.00 (b, 2H), 4.39 (b, 2H), 2.42 (b, 3H), 1.92 (b, 3H), 1.86 (b, 3H), 1.54 - 1.46 (b, 3H).

### Example 15

The structural formula of the cross-linking agent is shown as follows: 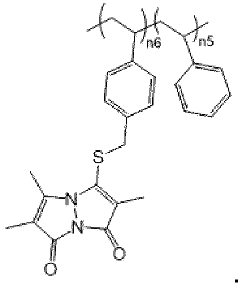 where n5+n6 is selected from positive integers greater than or equal to 2.

The manufacturing method for the cross-linking agent is as follows:

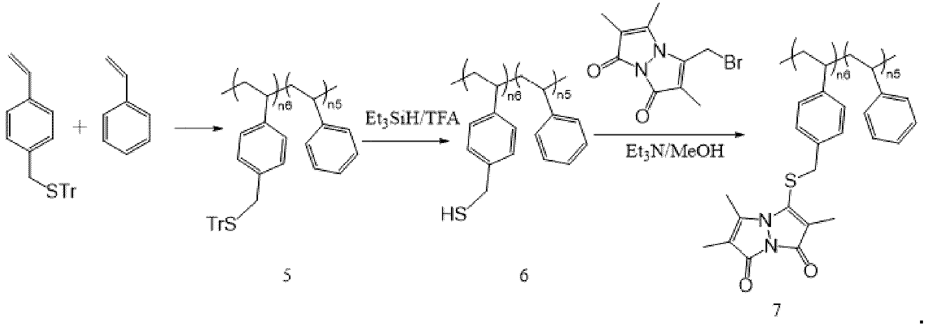

Product 1 (1.58 g, 4 mmol) in Example 14, styrene (0.62 g, 6 mmol), 4-cyano-4-((phenylcarbonothioyl)thio)pentanoic acid (CAS No.: 201611-92-9, 0.28 g, 1 mmol), and azobisisobutyronitrile (0.055 g, 0.3 mmol) are dissolved in 50 mL of dry tetrahydrofuran. After three cycles of freeze-pump-thaw to remove water and oxygen, the mixture is heated to 100°C under a nitrogen atmosphere and stirred for reaction for three hours. After cooling to room temperature, precipitation is performed with methanol. The precipitate is filtered and dissolved in a small amount of tetrahydrofuran. After three cycles of dissolution-precipitation, the precipitate is dried in vacuum to obtain Product 5 in the above formula. The yield of Product 5 is 1.61 g, and the production rate of Product 5 is 73%, with ¹H NMR (600 MHz, CDCl₃) δ (ppm): 7.59 - 7.22 (b, 11H), 4.40 (b, 2H), 2.41 (b, 3H), 1.92 (b, 3H), 1.87 (b, 3H), 1.54 - 1.45 (b, 3H). GPC:Mn=2100, and PDI=1.22.

1.32 g of Product 5 in the above formula is dissolved in anhydrous tetrahydrofuran, the solution is cooled to 0°C, 19.2 mmol of triethylsilane and 192 mmol of trifluoroacetic acid (TFA) are added, and stirring is continued at 0°C for 15 minutes. The temperature of the mixture is then slowly raised to room temperature, and after stirring is continued at room temperature for one hour, a saturated NaHCO₃ solution is added to quench the reaction. After water/dichloromethane extraction, precipitation is performed with methanol. The precipitate is filtered and dissolved in a small amount of tetrahydrofuran. After three cycles of dissolution-precipitation, the precipitate is dried in vacuum to obtain Product 6 in the above formula. The yield of Product 6 is 1.04 g, and the production rate of Product 6 is 79%, with ¹H NMR (600 MHz, CDCl₃) δ (ppm): 7.24 - 7.10 (b, 4.6H), 3.67 (b, 0.8H), 2.55 (b, 1H), 1.50 (b, 2H), 1.40 (b, 0.4H).

3-bromomethyl-2,5,6-trimethyl-pyrazolo[1,2-a]pyrazole-1,7-dione (CAS No.: 71418-44-5, 0.33 g, 1.2 mmol), Product 6 (0.66 g), and triethylamine (CAS No.: 121-44-8, 1009 mg, 10 mmol) are dissolved in 100 mL of dichloromethane, and the reaction proceeds at room temperature for 12 hours. After that, precipitation is performed with methanol. The precipitate is filtered and dissolved in a small amount of tetrahydrofuran. After three cycles of dissolution-precipitation, the precipitate is dried in vacuum to obtain a cross-linking agent. i.e., Product 7. The yield of Product 7 is 0.68 g, and the production rate of Product 7 is 35%, with ¹H NMR (600 MHz, CDCl₃) δ (ppm): 7.23 - 7.10 (b, 4.6H), 4.40 (b, 0.8H), 2.43 (b, 1.2H), 1.91 (b, 1.2H), 1.86 (b, 1.2H), 1.54 - 1.46 (b, 3H).

Embodiments of the present disclosure further provide another hole transport composition. The hole transport composition includes: a hole transport material and a cross-linking agent. The hole transport material includes a main chain and a side chain connected to the main chain of the hole transport material. Here, at least one of the side chain of the hole transport material or the cross-linking agent has a sulfhydryl group protected by a photoremovable group, and the photoremovable group is removed under light irradiation to release the sulfhydryl group, a sulfur free-radical or a sulfur anion; and the released sulfhydryl group, sulfur free-radical or sulfur anion is configured to enable cross-linking between the hole transport material and the cross-linking agent.

As for the photoremovable group, reference is made to the above description, which will not be repeated here.

In some examples, the cross-linking agent has a sulfhydryl group protected by a photoremovable group. Reference may be made to the foregoing description of the cross-linking agent for details of the cross-linking agent having the sulfhydryl group protected by the photoremovable group, which will not be repeated here. The released sulfhydryl group, sulfur free-radical or sulfur anion on the cross-linking agent is configured to react with the side chain of the hole transport material to form a chemical bond.

The setting in which the cross-linking agent has the sulfhydryl group protected by the photoremovable group may not only solve the problem that the sulfhydryl group has a foul odor and is inconvenient to use, but also endow the sulfhydryl group protected by the photoremovable group with better stability and higher controllability. The photoremovable group is removed under light irradiation to release the sulfhydryl group, a sulfur free-radical or a sulfur anion, and the released sulfhydryl group, sulfur free-radical or sulfur anion may crosslink with the side chain of the hole transport material to form the hole transport layer 141.

Moreover, since the activity of the sulfhydryl group, sulfur free-radical or sulfur anion generated from the sulfhydryl group protected by the photoremovable group under light irradiation is relatively low, the sulfhydryl group in the cross-linking agent is connected to the side chain of the hole transport material, which may effectively prevent the possibility of reaction of the conjugated repeating units on the main chain of the hole transport material, maintain the hole transport path of the hole transport layer 141, and thus improve the light-emitting efficiency of the light-emitting device 10.

Furthermore, if the cross-linking agent includes a hole transport group, the hole transport group may compensate for the problem that holes are weaker than electrons, which is beneficial to improving carrier balance.

As an example, in a case where the released sulfhydryl group, sulfur free-radical or sulfur anion is located on the cross-linking agent, the side chain of the hole transport material further includes an activating group. The activating group includes at least one of a carbon-carbon double bond or a carbon-carbon triple bond.

Reference may be made to the foregoing description of the activating group in the cross-linking agent, which will not be repeated here.

Introducing the activating group onto the side chain of the hole transport material may improve the reactivity of the side chain of the hole transport material, thereby increasing the reaction rate and cross-linking degree between the hole transport material and the cross-linking agent.

In some other examples, in a case where the released sulfhydryl group, sulfur free-radical or sulfur anion is located on the side chain of the hole transport material, the released sulfhydryl group, sulfur free-radical or sulfur anion is configured to react with the cross-linking agent to form a chemical bond.

The setting in which the side chain of the hole transport material has the sulfhydryl group protected by the photoremovable group may not only solve the problem that the sulfhydryl group has a foul odor and is inconvenient to use, but also endow the sulfhydryl group protected by the photoremovable group with better stability and higher controllability. The photoremovable group is removed under light irradiation to release the sulfhydryl group, a sulfur free-radical or a sulfur anion, and the released sulfhydryl group, sulfur free-radical or sulfur anion may crosslink with the cross-linking agent to form the hole transport layer 141.

Moreover, since the activity of the sulfhydryl group, sulfur free-radical or sulfur anion generated by the photoremovable group under light irradiation is relatively low, the sulfhydryl group in the cross-linking agent is connected to the cross-linking agent, which may effectively prevent the possibility of reaction of the conjugated repeating units on the main chain of the hole transport material, maintain the hole transport path of the hole transport layer 141, and thus improve the light-emitting efficiency of the light-emitting device 10.

As an example, in a case where the released sulfhydryl group, sulfur free-radical or sulfur anion is located on the side chain of the hole transport material, the cross-linking agent further includes an activating group.

Introducing the activating group onto the cross-linking agent may improve the reactivity between the cross-linking agent and the side chain of the hole transport material, thereby increasing the reaction rate and cross-linking degree between the hole transport material and the cross-linking agent.

In some examples, the side chain of the hole transport material further includes at least one of an ethylene glycol group or an ester group.

As an example, the hole transport material is capable of being dissolved in a propylene glycol methyl ether acetate solvent.

By the setting in which the side chain of the hole transport material includes at least one of an ethylene glycol group or an ester group, the solubility of the hole transport material may be increased.

Embodiments of the present disclosure further provide a ligand. The ligand is configured to coordinatively connect with a quantum dot body. The ligand includes a sulfhydryl group protected by a photoremovable group. The photoremovable group is removed under light irradiation to release the sulfhydryl group, a sulfur free-radical or a sulfur anion.

As for the photoremovable group, reference is made to the above description, which will not be repeated here.

By the setting in which the ligand includes the sulfhydryl group protected by the photoremovable group, the deprotected sulfhydryl group protected by the photoremovable group may achieve connection between the ligand and other materials (e.g., the cross-linking agent). The sulfhydryl group protected by the photoremovable group may solve the problem that the sulfhydryl group has a foul odor and makes the ligand inconvenient to use. Moreover, the sulfhydryl group protected by the photoremovable group has better stability and higher controllability.

In some embodiments, the ligand further includes a coordination group. The coordination group is configured to coordinatively connect with the quantum dot body. The coordination group includes at least one of an amino group, a carboxylic acid group, a sulfhydryl group, a phosphino group, a phosphine oxide group, a phosphate group, a phosphite group, or a hypophosphite group.

As an example, the ligand is selected from at least one of structures represented by the following general formula IV:

A-R1-S-PPG IV;

where A is the coordination group; R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and PPG is the photoremovable group.

R1 is a linking group, and R1 is configured to achieve connection between the sulfhydryl group protected by the photoremovable group and the coordination group.

As an example, the structural formula of the ligand is shown as follows:

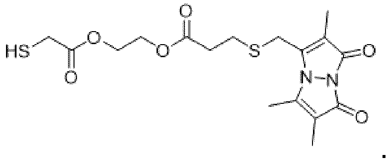

The following exemplarily describes a manufacturing method for the ligand: 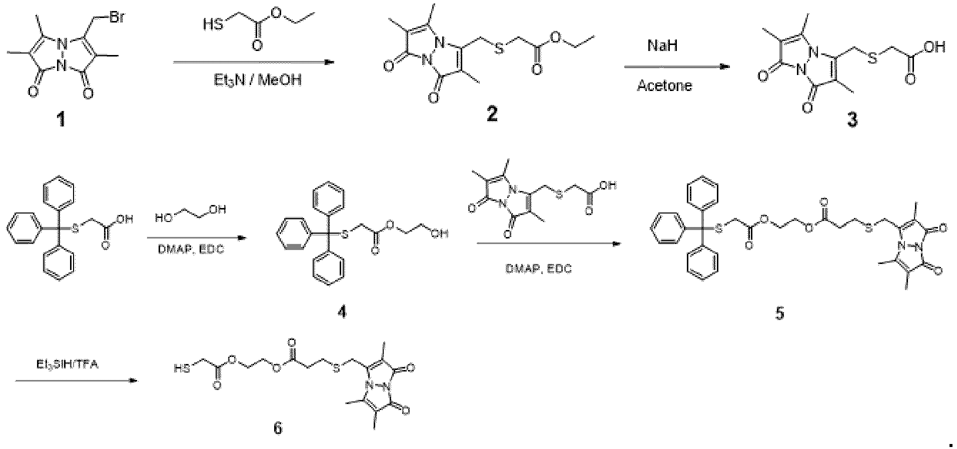
1): 3 g (11 mmol) of 3-bromomethyl-2,5,6-trimethyl-pyrazolo[1,2-a]pyrazole-1,7-dione (denoted as raw material 1 in the above formula), 1.2 g (10 mmol) of ethyl mercaptoacetate, and 1.11 g (11 mmol) of triethylamine are dissolved in 100 mL of methanol, and the reaction proceeds at room temperature for 12 hours. After that, methanol is removed by concentration under reduced pressure, and the residue is dissolved in 100 mL of dichloromethane. After washing three times with a saturated ammonium chloride solution, the residue is dried over anhydrous Na₂SO₄ and concentrated. The concentrate is purified by silica gel column chromatography to obtain Product 2 in the above formula. The yield of Product 2 is 2.82 g, and the production rate of Product 2 is 91%, with ¹H NMR (600 MHz, CDCl₃) δ (ppm): 4.17 (q, 2H), 3.73 (s, 2H), 3.11 (s, 2H), 2.42 (s, 3H), 1.92 (s, 3H), 1.86 (s, 3H), 1.25 (t, 3H).
2): In a dry three-necked flask, 0.58 g (24 mmol) of NaH is added. After three cycles of vacuum/nitrogen replacement, 2.48 g (8 mmol) of Product 2 and 50 mL of acetone are added, and the reaction proceeds at 40°C for 12 hours under nitrogen protection. After that, water is added to quench NaH. Acetone is then removed by concentration under reduced pressure, and the residue is dissolved in 100 mL of dichloromethane. After washing three times with saturated brine, the residue is dried over anhydrous Na₂SO₄ and concentrated. The concentrate is purified by silica gel column chromatography to obtain Product 3 in the above formula. The yield of Product 3 is 2.23 g, and the production rate of Product 3 is 79%, with ¹H NMR (600 MHz, CDCl₃) δ (ppm): 3.75 (s, 2H), 3.14 (s, 2H), 2.42 (s, 3H), 1.89 (s, 3H), 1.83 (s, 3H).
3): 3.34 g (10 mmol) of 2-(tritylsulfanyl)acetic acid, 0.62 g (10 mmol) of ethylene glycol, 50 mg of 4-dimethylaminopyridine, and 150 mg of dichloroethane are mixed and dissolved in 50 mL of dichloromethane, and the reaction proceeds at room temperature for 12 hours. After dichloromethane is removed by concentration, the mixture is purified by silica gel column chromatography to obtain Product 4 in the above formula. The yield of Product 4 is 1.1 g, and the production rate of Product 4 is 29%, with ¹H NMR (600 MHz, CDCl₃) δ (ppm): 7.30 - 7.18 (m, 15H), 4.78 (s, 1H), 4.22 (s, 2H), 3.54 (t, 2H), 3.34 (s, 2H).
4): 0.56 g (2 mmol) of Product 3, 0.76 g (2 mmol) of Product 4, 50 mg of 4-dimethylaminopyridine, and 150 mg of dichloroethane are mixed and dissolved in 10 mL of dichloromethane, and the reaction proceeds at room temperature for 12 hours. After dichloromethane is removed by concentration, the mixture is purified by silica gel column chromatography to obtain Product 5 in the above formula. The yield of Product 5 is 1.18 g, and the production rate of Product 5 is 89%, with ¹H NMR (600 MHz, CDCl₃) δ (ppm): 7.30 - 7.18 (m, 15H), 4.31 (t, 4H), 3.73 (s, 2H), 3.34 (s, 2H), 2.83 (t, 2H), 2.58 (s, 2H), 2.42 (s, 3H), 1.89 (s, 3H), 1.83 (s, 3H).
5): 0.98 g (1.5 mmol) of Product 5 and triethylsilane are dissolved in 10 mL of dichloromethane. The solution is cooled to 0°C, and trifluoroacetic acid is added. After 15 minutes, a saturated NaHCO₃ solution is added. After extraction, the organic phase is collected, dried over Na₂SO₄, and concentrated to remove dichloromethane. The product is purified by silica gel column chromatography to obtain a ligand, denoted as Product 6. The yield of Product 6 is 460 mg, and the production rate of Product 6 is 74%, with ¹H NMR (600 MHz, CDCl₃) δ (ppm): 4.31 (t, 4H), 3.73 (s, 2H), 3.34 (s, 2H), 2.83 (t, 2H), 2.58 (t, 2H), 2.42 (s, 3H), 1.89 (s, 3H), 1.83 (s, 3H), 1.52 (t, 1H).

Furthermore, taking red quantum dots as an example, the step of connecting the obtained ligand to the quantum dot body includes:

Ligand exchange: 100 mg of red quantum dots with oleic acid ligands, and 400 mg of Product 6 are dissolved in chloroform. The solution is sparged with nitrogen to remove oxygen, then heated under reflux for 4 hours. Precipitation is performed with ethanol, and the precipitate is dissolved in a minimum amount of chloroform. After three repeated cycles of dissolution and precipitation, a red quantum dot material with the above ligand is obtained. The material is dissolved in octane for storage.

In some examples, the ligand is selected from at least one of structures represented by the following general formula V:

A-R5-(R1-S-PPG)ₙ₃ V;

R5 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, and an alkynyl group; and n3 ≥ 2.

Here, R1 and R5 may be the same or different, which is not limited here.

As an example, n3 is taken a value of 2, and the ligand is selected from at least one of structures represented by the following general formula: 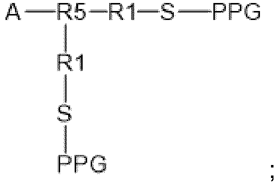 where in the above general formula, these two PPG groups may be the same or different, and these two R1 groups may be the same or different, which are not limited here.

As an example, n3 is taken a value of 3, and the ligand is selected from at least one of structures represented by the following general formula: 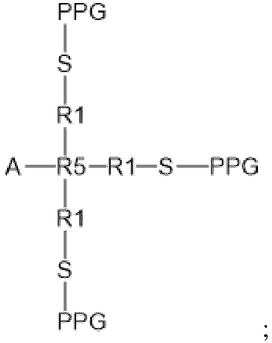 where in the above general formula, these three PPG groups may be the same or different, and these three R1 groups may be the same or different, which are not limited here.

By setting the general formula V of the ligand, it is possible to provide a ligand including multiple sulfhydryl groups protected by photoremovable groups.

Embodiments of the present disclosure further provide a quantum dot composition. The quantum dot composition includes a quantum dot body, a ligand, and a cross-linking agent, the ligand being coordinatively connected to the quantum dot body, in which at least one of the ligand or the cross-linking agent has a sulfhydryl group protected by a photoremovable group, and the photoremovable group is removed under light irradiation to release the sulfhydryl group, a sulfur free-radical or a sulfur anion; and the released sulfhydryl group, sulfur free-radical or sulfur anion is configured to enable cross-linking between at least two of the quantum dot body, the ligand, or the cross-linking agent.

As an example, the quantum dot body may include a Group II-VI semiconductor compound, a Group III-V semiconductor compound, a Group IV-VI semiconductor compound, a Group IV semiconductor, a Group I-III-VI semiconductor compound, a Group I-II-IV-VI semiconductor compound, a Group II-III-V semiconductor compound, or a combination thereof. For example, the Group II-VI semiconductor compound may be selected from: binary semiconductor compounds such as CdSe, CdTe, ZnS, ZnSe, ZnTe, ZnO, HgS, HgSe, HgTe, MgSe, MgS, or mixtures thereof, ternary semiconductor compounds such as CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, or mixtures thereof, and quaternary semiconductor compounds such as HgZnTeS, CdZnSeS, CdZnSeTe, CdZnSTe, CdHgSeS, CdHgSeTe, CdHgSTe, HgZnSeS, HgZnSeTe, HgZnSTe, or mixtures thereof, but is not limited thereto. As another example, the Group III-V semiconductor compound may be selected from: binary semiconductor compounds such as GaN, GaP, GaAs, GaSb, AlN, AlP, AlAs, AlSb, InN, InP, InAs, InSb, or mixtures thereof, ternary semiconductor compounds such as GaNP, GaNAs, GaNSb, GaPAs, GaPSb, AlNP, AlNAs, AlNSb, AlPAs, AlPSb, InNP, InNAs, InNSb, InPAs, InPSb, or mixtures thereof, and quaternary semiconductor compounds such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or mixtures thereof, but is not limited thereto. As yet another example, the Group IV-VI semiconductor compound may be selected from: binary semiconductor compounds such as SnS, SnSe, SnTe, PbS, PbSe, PbTe, or mixtures thereof, ternary semiconductor compounds such as SnSeS, SnSeTe, SnSTe, PbSeS, PbSeTe, PbSTe, SnPbS, SnPbSe, SnPbTe, or mixtures thereof, and quaternary semiconductor compounds such as SnPbSSe, SnPbSeTe, SnPbSTe, or mixtures thereof, but is not limited thereto. The Group IV semiconductor may be selected from, for example: elemental (single-component) semiconductors such as Si, Ge, or mixtures thereof, and binary semiconductor compounds such as SiC, SiGe, and mixtures thereof, but is not limited thereto. The Group I-III-VI semiconductor compound may be, for example, CuInSe₂, CuInS₂, CuInGaSe, CuInGaS, or a mixture thereof, but is not limited thereto. The Group I-II-IV-VI semiconductor compound may be, for example, CuZnSnSe, CuZnSnS, or a mixture thereof, but is not limited thereto. The Group II-III-V semiconductor compound may include, for example, InZnP, but is not limited thereto.

The setting in which one of the ligand and the cross-linking agent in the quantum dot composition has the sulfhydryl group protected by the photoremovable group may effectively solve the problem that the sulfhydryl group has a foul odor and is inconvenient to use. Moreover, the sulfhydryl group protected by the photoremovable group has better stability and higher controllability.

In some examples, the cross-linking agent has a sulfhydryl group protected by a photoremovable group. The released sulfhydryl group, sulfur free-radical or sulfur anion on the cross-linking agent is configured to coordinatively connect with the quantum dot body or for reacting with the ligand to form a chemical bond.

Reference may be made to the foregoing content for the description of the cross-linking agent having the sulfhydryl group protected by the photoremovable group, which will not be repeated here.

Reference may be made to the subsequent content of the light-emitting device 10 for the description that the released sulfhydryl group, sulfur free-radical or sulfur anion on the cross-linking agent is configured to coordinatively connect with the quantum dot body or for reacting with the ligand to form a chemical bond, which will not be detailed here.

In some examples, the ligand includes: a first ligand, a structural formula of the first ligand being A1-R1-D, where A1 is a coordination group capable of coordinating with the quantum dot body; R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and D is an activating group.

Reference may be made to the foregoing content for the description of the activating group, which will not be repeated here.

By setting the first ligand to include the activating group, the reaction rate and cross-linking degree between the first ligand coordinatively connected to the quantum dot body and the cross-linking agent may be improved.

In some examples, the ligand further includes a second ligand, a structural formula of the second ligand being A2-R1, where A2 is a coordination group capable of coordinating with the quantum dot body; R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group. R1 of the first ligand and R1 of the second ligand may be the same or different, which is not limited here.

That is, a portion of the ligand may not be provided with the activating group.

As an example, a proportion of the mass of the first ligand to the mass of the ligand is greater than or equal to 5%. For example, the proportion of the mass of the first ligand to the mass of the ligand is 5%, 8%, 15%, 20%, 30%, 50%, 70%, 80%, 90%, or 100%, which is not limited here.

In some other examples, the ligand has a sulfhydryl group protected by a photoremovable group. The released sulfhydryl group, sulfur free-radical or sulfur anion on the ligand is used for reacting with the cross-linking agent to form a chemical bond, for coordinatively connecting with the quantum dot body, or for reacting with another ligand to form a chemical bond.

Reference may be made to the foregoing content for the description of the ligand having the sulfhydryl group protected by the photoremovable group, which will not be repeated here.

Reference may be made to the subsequent content of the light-emitting device 10 for the description that the released sulfhydryl group, sulfur free-radical or sulfur anion on the ligand is used for reacting with the cross-linking agent to form a chemical bond, for coordinatively connecting with the quantum dot body, or for reacting with the ligand to form a chemical bond, which will not be detailed here.

In some examples, the ligand has a sulfhydryl group protected by a photoremovable group, and the cross-linking agent includes an activating group. The activating group includes at least one of a carbon-carbon double bond or a carbon-carbon triple bond.

Reference may be made to the foregoing content for the description of the activating group, which will not be repeated here.

By setting the cross-linking agent to include the activating group, the reaction rate and cross-linking degree between the ligand coordinatively connected to the quantum dot body and the cross-linking agent may be improved.

As shown in FIG. 5, embodiments of the present disclosure further provide a light-emitting device 10. The light-emitting device 10 includes a hole transport layer 141 and a quantum dot light-emitting layer 13 that are stacked.

In some embodiments, a material of the hole transport layer 141 is formed by cross-linking a hole transport composition under light irradiation. The hole transport composition includes a hole transport material and a cross-linking agent. The hole transport material includes a main chain and a side chain connected to the main chain of the hole transport material. Here, at least one of the side chain of the hole transport material or the cross-linking agent has a sulfhydryl group protected by a photoremovable group. The photoremovable group is removed under light irradiation to release the sulfhydryl group, a sulfur free-radical or a sulfur anion; and the released sulfhydryl group, sulfur free-radical or sulfur anion is configured to enable cross-linking between the hole transport material and the cross-linking agent to form the hole transport layer 141.

Reference may be made to the foregoing content for the description of the hole transport composition, which will not be repeated here.

Under light irradiation, the photoremovable group undergoes a decomposition reaction. As shown in FIG. 5, a material resulting from the decomposition of the photoremovable group is denoted as PPG1, and the material of PPG1 includes at least one of the following structural formulas: 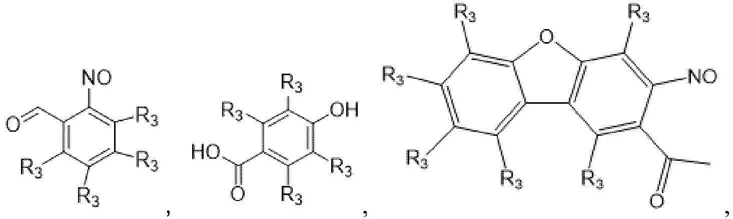 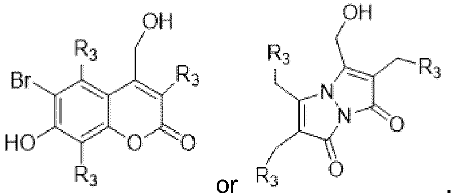 where each R₃ is independently selected from any one of H, an alkyl group, an electron-withdrawing group, an electron-donating group, and a conjugated group.

As an example, the photoremovable group undergoes photolysis to generate the sulfur anion and PPG1, with the reaction formula shown as follows: 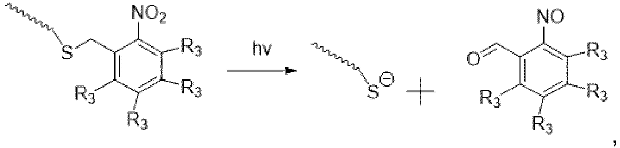 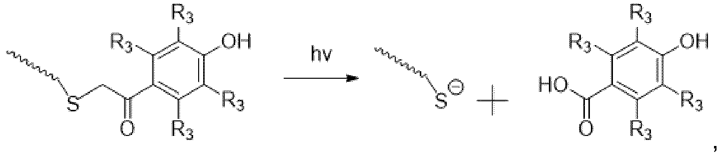 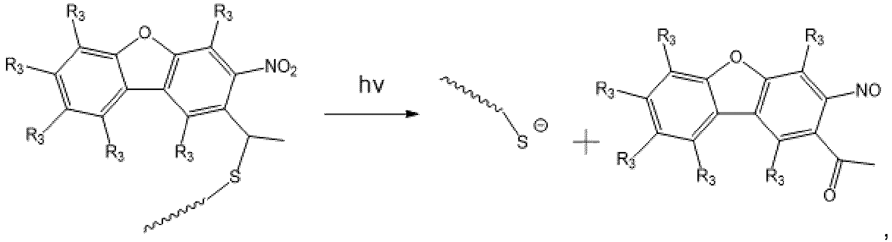 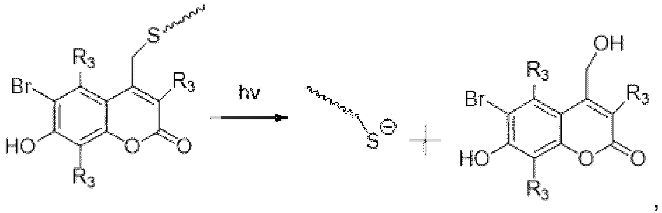 or

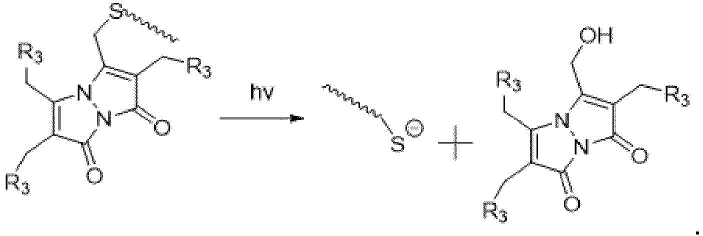

It will be noted that a circle is used to represent PPG1 in FIG. 5. The circle only indicates the presence of PPG1, and does not limit the shape of the material after decomposition of the photoremovable group.

It can be understood that the material after the decomposition reaction of the photoremovable group remains in the hole transport layer 141. Therefore, the hole transport layer 141 includes at least one of the materials after decomposition of the photoremovable group.

In some examples, the material of the hole transport layer 141 further includes a first cross-linking material, in which the first cross-linking material includes a first group, the first group including a main chain and a side chain connected to the main chain of the first group, and the first cross-linking material further includes a first cross-linking group connected to the side chain of the first group, and the side chain of the first group and the first cross-linking group are connected via at least two thioether structures.

In some examples, the main chain of the first group includes at least one of at least one of polycarbazole, polybenzidine, a substituted or unsubstituted carbazole-fluorene copolymer, or a substituted or unsubstituted benzidine-fluorene copolymer.

It will be noted that the first group is formed after cross-linking of the hole transport material and the cross-linking agent, and the main chain of the first group has hole transport performance.

As an example, the structural formula of the first cross-linking material is shown as follows:

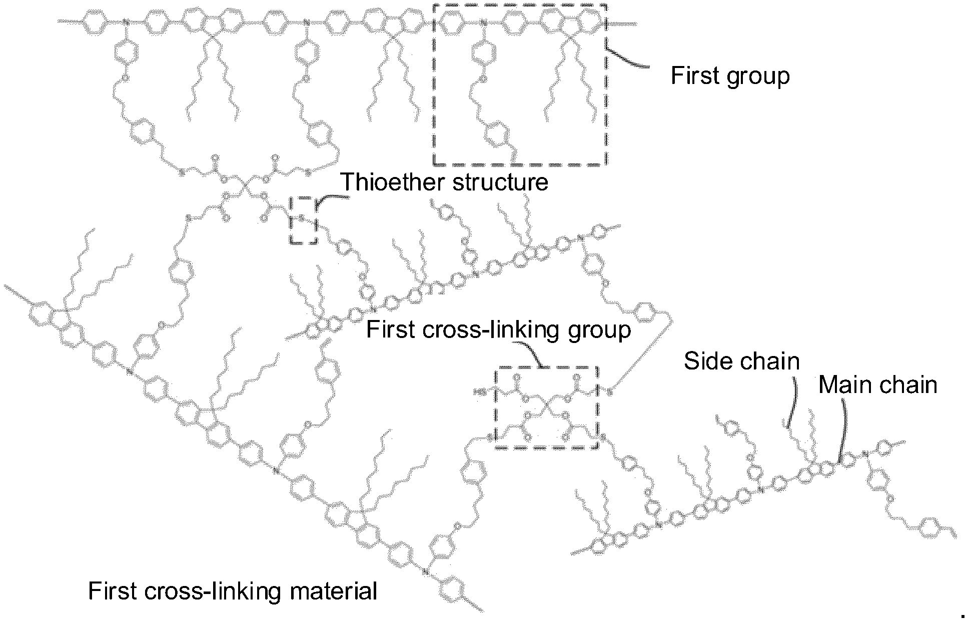

As an example, the reaction between the cross-linking agent having a sulfhydryl group protected by a photoremovable group and the hole transport material whose side chain has an activating group has the general formula shown as follows: 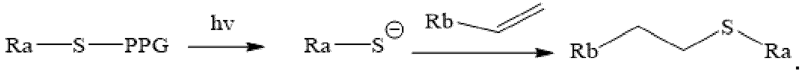 where Ra-S-PPG represents the cross-linking agent having the sulfhydryl group protected by the photoremovable group. Ra-S-PPG releases a sulfur anion under light irradiation, and the sulfur anion reacts with the activating group of the side chain of the hole transport material to form a first cross-linking material.

For example, the structural formula of the cross-linking agent having the sulfhydryl group protected by the photoremovable group is shown as follows:

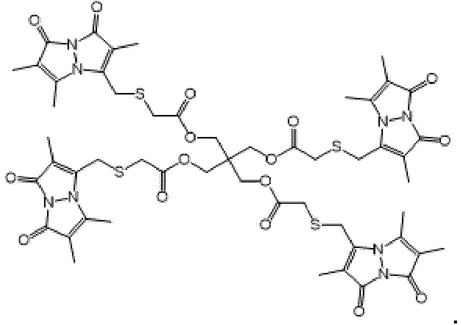

The structural formula of the hole transport material whose side chain has the activating group is shown as follows: 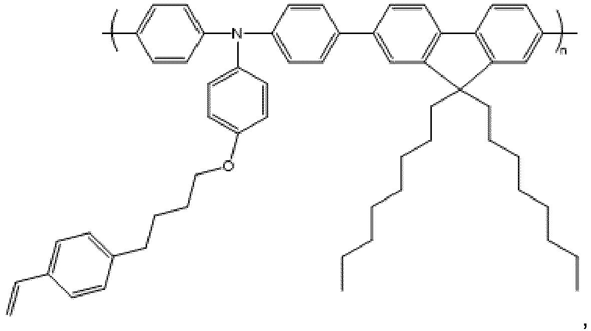 where n ≥ 1.

The first cross-linking material with the above structural formula is obtained after cross-linking of the cross-linking agent and the hole transport material.

In some examples, the side chain of the first group further includes at least one of an ethylene glycol group or an ester group.

As an example, the side chain of the hole transport material includes at least one of an ethylene glycol group or an ester group.

As an example, the hole transport material is dissolved in a propylene glycol methyl ether acetate solvent for the cross-linking reaction. By setting the side chain of the hole transport material to include at least one of an ethylene glycol group or an ester group, the solubility of the hole transport material may be increased.

In some examples, the first cross-linking group further includes at least one of a triphenylamine group, a carbazole group, or a linked triphenylamine group.

The triphenylamine group, carbazole group, and linked triphenylamine group are hole transport groups. By setting the first cross-linking group to be a hole transport group, the hole transport performance of the first cross-linking material may be improved, and the performance of the light-emitting device 10 may be enhanced.

In some embodiments, the material of the quantum dot light-emitting layer 13 is formed by cross-linking a quantum dot composition under light irradiation. The quantum dot composition includes a quantum dot body, a ligand, and a cross-linking agent, the ligand being coordinatively connected to the quantum dot body, in which at least one of the ligand or the cross-linking agent has a sulfhydryl group protected by a photoremovable group, and the photoremovable group is removed under light irradiation to release the sulfhydryl group, a sulfur free-radical or a sulfur anion; and the released sulfhydryl group, sulfur free-radical or sulfur anion is configured to enable cross-linking between at least two of the quantum dot body, the ligand, or the cross-linking agent.

Reference may be made to the foregoing content for the description of the quantum dot composition, which will not be repeated here.

It can be understood that the material after the decomposition reaction of the photoremovable group remains in the quantum dot light-emitting layer 13. Therefore, the quantum dot light-emitting layer 13 includes at least one of the materials after decomposition of the photoremovable group.

In some embodiments, the quantum dot light-emitting layer 13 includes quantum dot bodies connected to each other via a second cross-linking material, in which the second cross-linking material includes a coordination group coordinating with a quantum dot body and a second cross-linking group connected to the coordination group, where the coordination group and the second cross-linking group are connected via a thioether structure.

As an example, the reaction formula for the quantum dot composition undergoing cross-linking under light irradiation to form the material of the quantum dot light-emitting layer 13 is shown as follows:

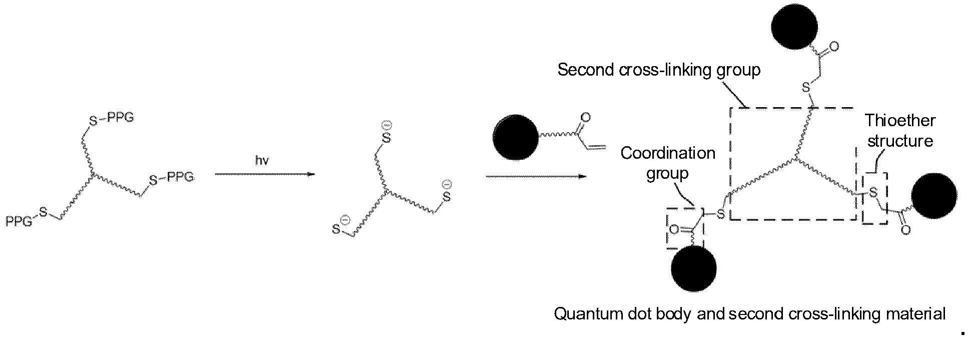

In the above reaction formula, the symbol of " 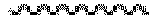 " represents the skeleton structure connected to a functional group (e.g., a sulfhydryl group protected by a photoremovable group, a sulfhydryl group, a sulfur free-radical, a sulfur anion, an active alkenyl group, or the like) in the cross-linking agent or the ligand. For example, the symbol of " 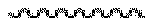 " represents the first linking group of the cross-linking agent or the non-functional moiety of the ligand. The symbol of " 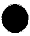 " represents the quantum dot body.

In this example, the structural formula of the cross-linking agent is shown as follows:

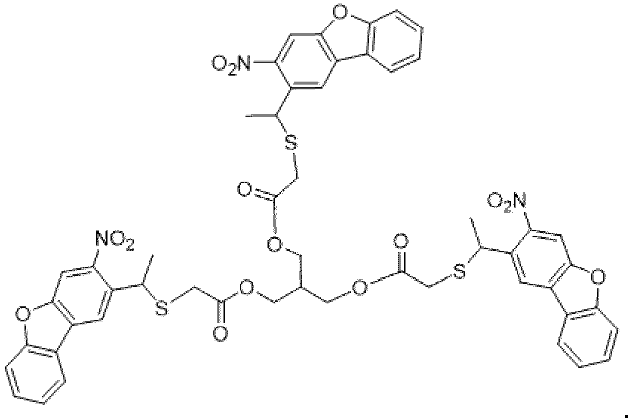

FIG. 6 is a diagram showing the light emission of a light-emitting device 10 including a red quantum dot light-emitting layer. Here, the cross-linking agent is the cross-linking agent provided in Example 3 above, and the ligand is mono[2-[(2-methyl-1-oxo-2-propenyl)oxy]ethyl]ester (denoted as MMES), with a ratio of the mass of the quantum dot body to the mass of the cross-linking agent of 40:1. The cross-linking agent crosslinks with the ligand on the quantum dot body to form the red quantum dot light-emitting layer. It can be seen from FIG. 6 that the light-emitting device 10 emits light uniformly, which indicates that the red quantum dot light-emitting layer is formed by this method.

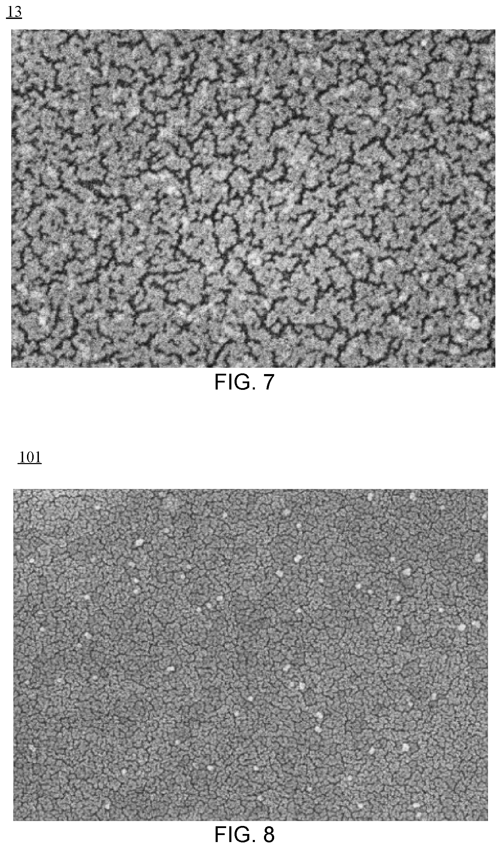

FIG. 7 is a scanning electron micrograph of the quantum dot light-emitting layer in an exposed region, and FIG. 8 is a scanning electron micrograph of the quantum dot light-emitting layer in an unexposed region. By comparing FIG. 7 and FIG. 8, it can be seen that the quantum dot composition undergoes cross-linking under light irradiation to form the quantum dot light-emitting layer 13, in which the quantum dot composition in the unexposed region does not undergo cross-linking, i.e., does not crosslink to form the quantum dot light-emitting layer 13. FIG. 8 shows the morphology of the substrate 101.

As an example, the ligand includes a sulfhydryl group protected by a photoremovable group, and the cross-linking agent includes an activating group. For example, the cross-linking agent is dipentaerythritol pentaacrylate. In this example, the sulfhydryl group protected by the photoremovable group serves as a ligand of the quantum dot body, and reacts with the cross-linking agent to form the material of the quantum dot light-emitting layer 13. In the material of the quantum dot light-emitting layer 13, the coordination group and the second cross-linking group are connected via a thioether structure.

Using a sulfhydryl group protected by a photoremovable group as a ligand of the quantum dot body may utilize the Thiol-ene click reaction for cross-linking, which may reduce the cross-linking temperature, change thermal cross-linking into photo-cross-linking (or a combination of light and heat), and simplify the film-forming process. The Thiol-ene click reaction is a type of click reaction with high yield, which may improve the cross-linking degree and is beneficial to improving the service life of the light-emitting device 10. Using the sulfhydryl group protected by the photoremovable group as the ligand of the quantum dot body may effectively prevent spontaneous cross-linking of the quantum dot body in solution and after film coating, thereby achieving the effect of light-controlled cross-linking. An appropriate photoremovable group may be selected, which has a high deprotection reaction rate and does not affect the Thiol-ene click reaction. Through structural design of the photoremovable group, the response wavelength of exposure may be adjusted, the absorbance of the cross-linking agent at the response wavelength may be increased, and the exposure intensity may be reduced, thereby diminishing damage to the conjugated repeating units of the hole transport material and the quantum dots of the light-emitting device 10, which helps to improve the optical performance and service life of the light-emitting device 10.

In some embodiments, the structural formula of the cross-linking agent is shown as follows:

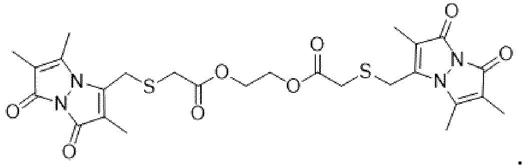

The steps for preparing the quantum dot light-emitting layer 13 using the above cross-linking agent are as follows.

Red quantum dots with double-bond ligands and the cross-linking agent are dissolved in propylene glycol methyl ether acetate (PGMEA). The concentration of the red quantum dots is 30 mg/mL, and the concentration of the cross-linking agent is 1 mg/mL. A TFB film is formed by spin coating and baked at 120°C for 20 minutes under a nitrogen atmosphere. The above red quantum dot/cross-linking agent mixed solution is used for spin-coating at a rotation speed of 3,000 rpm to form a quantum dot film layer. A photomask is placed on the quantum dot film layer, and exposure is performed using a 405 nm ultraviolet light source with an exposure dose of 150 mJ/cm². After that, development is performed with PGMEA, and a patterned quantum dot light-emitting layer 13 is obtained after drying. The diagram showing the light emission of the light-emitting device 10 including this red quantum dot light-emitting layer is presented in FIG. 6.

In some embodiments, the structural formula of the cross-linking agent is shown as follows:

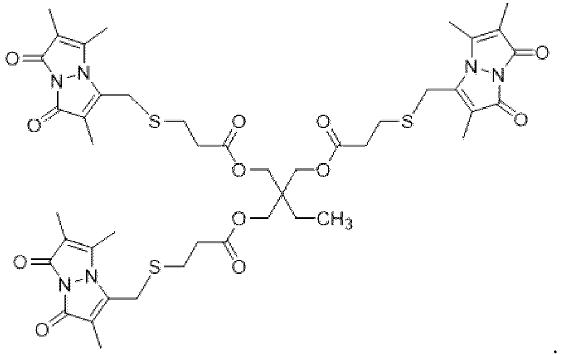

The steps for preparing the quantum dot light-emitting layer 13 using the above cross-linking agent are as follows.

Green quantum dots with double-bond ligands and the cross-linking agent are dissolved in PGMEA. The concentration of the green quantum dots is 30 mg/mL, and the concentration of the cross-linking agent is 1 mg/mL. The green quantum dot/cross-linking agent mixed solution is used for spin-coating on a pixelated substrate at a rotation speed of 3,000 rpm to form a quantum dot film layer. A photomask is placed on the quantum dot film layer and aligned, and exposure is performed using a 405 nm ultraviolet light source with an exposure dose of 140 mJ/cm². After that, development is performed with PGMEA. A patterned quantum dot light-emitting layer 13 is obtained after drying. The diagram showing the light emission of the light-emitting device 10 including the green quantum dot light-emitting layer is presented in FIG. 11.

In some embodiments, the structural formula of the cross-linking agent is shown as follows:

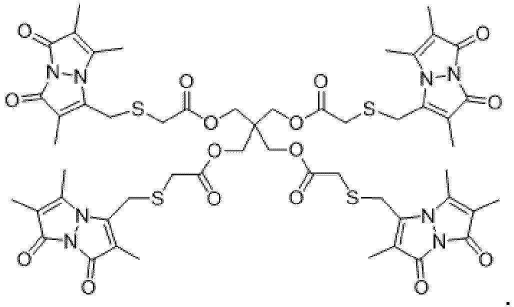

The steps for preparing the quantum dot light-emitting layer 13 using the above cross-linking agent are as follows.

Red quantum dots with double-bond ligands and the cross-linking agent are dissolved in PGMEA. The concentration of the red quantum dots is 30 mg/mL, and the concentration of the cross-linking agent is 1 mg/mL. The red quantum dot/cross-linking agent mixed solution is used for spin-coating on a pixelated substrate at a rotation speed of 3,000 rpm to form a quantum dot film layer. A photomask is placed on the quantum dot film layer and aligned, and exposure is performed using a 405 nm ultraviolet light source with an exposure dose of 70 mJ/cm². After that, development is performed with PGMEA. A patterned quantum dot light-emitting layer 13 is obtained after drying. The diagram showing the light emission of the light-emitting device 10 including the green quantum dot light-emitting layer is presented in FIG. 13.

In some other examples, the second cross-linking material includes a second cross-linking group. The second cross-linking group and the quantum dot body are connected via an S-Zn coordination bond or an S-Cd coordination bond.

As an example, the reaction formula for the quantum dot composition undergoing cross-linking under light irradiation to form the material of the quantum dot light-emitting layer 13 is shown as follows:

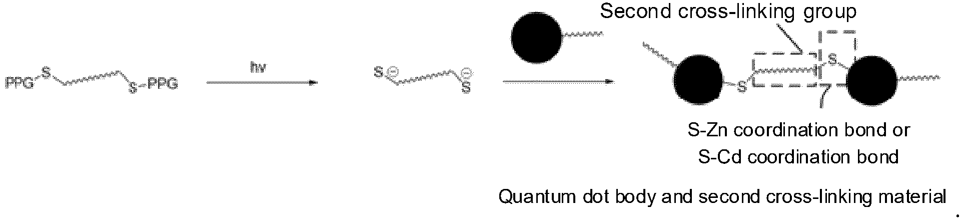

In this example, the sulfhydryl group has strong binding force with a metal atom (e.g., zinc) on the shell of the quantum dot body. The sulfhydryl group is a common coordination group, and a multi-sulfhydryl ligand may serve as a cross-linking agent for the quantum dot body. Using the multi-sulfhydryl cross-linking agent protected by a photoremovable group may prevent spontaneous cross-linking of the quantum dot body in solution and after film coating, thereby achieving the effect of light-controlled cross-linking. Moreover, through structural design of the cross-linking having the sulfhydryl group protected by the photoremovable group, the response wavelength of exposure may be adjusted, the absorbance of the cross-linking agent at the response wavelength may be increased, and the exposure intensity may be reduced, thereby diminishing damage to the conjugated repeating units of the hole transport material and the quantum dots of the light-emitting device 10, which helps to improve the optical performance and service life of the light-emitting device 10.

In this example, there is no limitation on the ligand on the quantum dot body. The ligand may be a polar ligand, a non-polar ligand, or a mixed material of a polar ligand and a non-polar ligand. Alternatively, the ligand may include an activating group to improve the cross-linking degree at the same exposure dose.

As an example, the sulfhydryl group protected by the photoremovable group serves as a ligand of the quantum dot body and reacts with another quantum dot body. The formed second cross-linking material includes a second cross-linking group, where the second cross-linking group and the quantum dot body are connected via a thioether structure.

After the sulfhydryl group protected by the photoremovable group is deprotected under light irradiation, it may coordinate with the shell layer of another quantum dot body to form a second cross-linking material, thereby obtaining a cross-linked structure. The ligand of the quantum dot body may be a polar ligand, a non-polar ligand, or a mixed material of a polar ligand and a non-polar ligand.

In yet some examples, the second cross-linking material includes a first coordination group coordinating with the quantum dot body and a second coordination group coordinating with the quantum dot body, where the first coordination group and the second coordination group are connected via a thioether structure.

As an example, the quantum dot composition includes two types of ligands. One type of ligand includes a sulfhydryl group protected by a photoremovable group, in which the photoremovable group is removed under light irradiation to release a sulfhydryl group, a sulfur free-radical or a sulfur anion. The structure of the other type of ligands is the same as the first ligand described above, that is, the structural formula of this ligand is A1-R1-D, where A1 is a coordination group capable of coordinating with the quantum dot body; R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and D is an activating group.

That is, the sulfhydryl group protected by the photoremovable group serves as one of the ligands of the quantum dot body, and reacts with a ligand having an activating group on the quantum dot body to form the quantum dot light-emitting layer 13. The coordination group on the ligand having the sulfhydryl group protected by the photoremovable group is referred to as the first coordination group, and the coordination group on the ligand having the activating group is referred to as the second coordination group. When the sulfhydryl group protected by the photoremovable group, as one of the ligands of the quantum dot body, reacts with the ligand having the activating group on the quantum dot body, the deprotected sulfhydryl group protected by the photoremovable group forms a thioether structure, achieving the connection between the first coordination group and the second coordination group.

This embodiment simultaneously utilizes the coordination between the sulfhydryl group and the shell layer of the quantum dot body, and the connection between the Thiol-ene click reaction and a ligand of another quantum dot body, which may improve the cross-linking degree. Furthermore, the ligand may be optimized so that the quantum dot body simultaneously meets the requirements of photolithography and high electrical performance. Moreover, the ligand may be a combination of two or more types of ligands, and the selection of ligands may further optimize the performance of the light-emitting device 10.

In some examples, as shown in FIG. 5, the light-emitting device 10 further includes an anode 11 and a cathode 12. The anode 11, the hole transport layer 141, the quantum dot light-emitting layer 13, and the cathode 12 are stacked.

The light-emitting principle of the light-emitting device 10 is as follows: through a circuit connected to the anode 11 and the cathode 12, holes are injected from the anode 11 into the quantum dot light-emitting layer 13, and electrons are injected from the cathode 12 into the quantum dot light-emitting layer 13; and the injected electrons and holes form excitons (i.e., electron-hole pairs) in the quantum dot light-emitting layer 13, and the excitons return to the ground state through radiative transition to emit photons.

As an example, to ensure that the light-emitting device 10 can emit light effectively, the anode 11 may be made of a material with a high work function. In this way, holes generated by the anode 11 may effectively migrate into the quantum dot light-emitting layer 13 under the drive of an electric field, so as to recombine with electrons generated by the cathode 12 to emit light.

In some examples, the anode 11 may be a transparent electrode. In this case, the material of the anode 11 may be indium tin oxide (ITO) or fluorine-doped tin oxide conductive glass (FTO). Alternatively, the material of the anode 11 may be a conductive polymer, such as polyaniline, polycarbazole, polythiophene, or polypyrrole, etc. In yet some examples, the anode 11 may be an opaque electrode. In this case, the material of the anode 11 may be a metal material, such as aluminum or silver.

As an example, the cathode 12 may be made of a material with a low work function. In this way, electrons from the cathode 12 may be more easily injected into the adjacent film layer (e.g., an electron transport layer 16). Thus, the electrons generated by the cathode 12 may effectively migrate into the quantum dot light-emitting layer 13 under the drive of the electric field, so as to recombine with the holes generated by the anode 11 to emit light.

In some examples, the material of the cathode 12 may be a metal material, a metal oxide, or a metal alloy. The metal material is, for example, aluminum, silver, gold, magnesium, calcium, ytterbium, indium, lithium, potassium, sodium, tin, titanium, lead, samarium, or yttrium; the metal oxide is, for example, indium tin oxide or indium zinc oxide; the metal alloy is, for example, magnesium-silver alloy, ytterbium-gold alloy, ytterbium-silver alloy, lithium-aluminum alloy, or lithium-calcium-magnesium alloy. Alternatively, the material of the cathode 12 may be a laminated material, such as magnesium/aluminum, magnesium/silver, aluminum/silver, aluminum/gold, ytterbium/gold, ytterbium/silver, calcium/magnesium, calcium/silver, or barium/silver.

In some embodiments, as shown in FIG. 5, to improve light-emitting efficiency, the light-emitting device 10 further includes a hole injection layer 15. The hole injection layer 15 is located on a side of the hole transport layer 141 away from the quantum dot light-emitting layer 13. The light-emitting device 10 further includes an electron blocking layer (not shown in the figure). The electron blocking layer is located on a side of the hole transport layer 141 proximate to the quantum dot light-emitting layer 13.

In some embodiments, as shown in FIG. 5, to improve the light-emitting efficiency, the light-emitting device 10 further includes an electron transport layer 16. The electron transport layer 16 is located on a side of the quantum dot light-emitting layer 13 proximate to the cathode 12. The light-emitting device 10 further includes at least one of an electron injection layer (not shown in the figure) or a hole blocking layer (not shown in the figure). The electron injection layer is located on a side of the electron transport layer 16 away from the quantum dot light-emitting layer 13, and the hole blocking layer is located on a side of the electron transport layer 16 proximate to the quantum dot light-emitting layer 13.

Setting the hole injection layer 15, the hole transport layer 141, and the electron blocking layer is equivalent to providing a transition step between the anode 11 and the quantum dot light-emitting layer 13, and setting the electron injection layer, the electron transport layer 16, and the hole blocking layer is equivalent to providing a transition step between the cathode 12 and the quantum dot light-emitting layer 13, which reduce the height of the potential barrier that carriers need to overcome for transition, resulting in higher light-emitting efficiency of the light-emitting device 10.

As an example, a material of the hole injection layer may be an organic material, such as poly(3,4-ethylenedioxythiophene)-poly(styrenesulfonate) (PEDOT:PSS); alternatively, the material of the hole injection layer may be an inorganic oxide, such as molybdenum oxide.

As an example, a material of the electron blocking layer may include 4,4'-cyclohexylidenebis[N,N-bis(p-tolyl)aniline] or 4,4',4"-tris(carbazol-9-yl)triphenylamine, which is not limited here.

As an example, a material of the hole blocking layer may be 2,9-dimethyl-4,7-diphenyl-1,10-phenanthroline.

As an example, a material of the electron transport layer 141 may be zinc oxide or magnesium zinc oxide. Here, zinc oxide and magnesium zinc oxide may be nanoparticles, or may be films prepared by a sputtering process.

As an example, a material of the electron injection layer may be a metal, such as Li, Ca or Yb, or may be a metal salt, such as LiF, or LiQ₃, which are not limited here.

The following examples are provided to demonstrate the differences in current efficiency and relative luminance between the light-emitting device 10 using the cross-linking agent provided by the embodiments of the present disclosure and a case without using the cross-linking agent provided by the embodiments of the present disclosure.

### Comparative Example 1

Reference may be made to FIG. 5 for the structure of the light-emitting device 10.
(1): An anode 11 is formed on a side of a substrate 101.

As an example, the anode 11 is formed on the substrate 101. The substrate 101 may be glass or a flexible polyethylene terephthalate (PET) substrate.

The anode 11 may be made of transparent indium tin oxide (ITO), fluorine-doped tin oxide (FTO) conductive glass, a conductive polymer, or the like, or may be made of an opaque metal electrode such as Al or Ag.

In this example, the substrate 101 is a glass substrate, and the anode 11 is made of ITO.

(2): A hole injection layer 15 is formed on a side of the anode 11 away from the substrate 101.

As an example, the hole injection layer 15 is formed by a deposition process.

As an example, a material of the hole injection layer 15 includes PEDOT:PSS, or an inorganic oxide such as MoOₓ.

In this example, the material of the hole injection layer 15 includes PEDOT:PSS.

(3): A hole transport layer 141 is formed on a side of the hole injection layer 15 away from the substrate 101.

As an example, the hole transport layer 141 is formed by a deposition process.

As an example, a material of the hole transport layer 141 may be an organic material or an inorganic oxide. For example, the material of the hole transport layer 141 includes poly[(9,9-dioctylfluorenyl-2,7-diyl)-co-(4,4'-(N-(4-sec-butylphenyl) diphenylamine)] (TFB), polyvinylcarbazole (PVK), N,N'-diphenyl-N,N'-bis(3-methylphenyl)-1,1'-biphenyl-4,4'-diamine (TPD), NiOₓ, or VOₓ.

In this example, the material of the hole transport layer 141 includes TFB.

(4): A quantum dot light-emitting layer 13 is formed on a side of the hole transport layer 141 away from the substrate 101.

As an example, the quantum dot light-emitting layer 13 is formed by a deposition process, and the quantum dot light-emitting layer 13 is configured to emit red light.

(5): An electron transport layer 16 is formed on a side of the quantum dot light-emitting layer 13 away from the substrate 101.

As an example, the electron transport layer 16 is formed by a deposition process. A material of the electron transport layer 16 includes ZnO nanoparticles or Mg-doped ZnO nanoparticles.

As an example, the electron transport layer 16 is formed by a sputtering process. The material of the electron transport layer 16 includes ZnO (or doped ZnO).

In this example, the electron transport layer 16 is formed by spin-coating Mg-doped ZnO nanoparticles.

(6): A cathode 12 is formed on a side of the electron transport layer 16 away from the substrate 101.

As an example, the cathode 12 is formed by depositing IZO (10 wt% zinc oxide doped in indium tin oxide) by magnetron sputtering, or is prepared by evaporation of Al, Ag, Mg:Ag, or the like, with a thickness ranging from 10 nm to 100 nm.

In this example, the cathode 12 is formed by evaporating Al through an evaporation process.

### Embodiment 1

In Embodiment 1, the structure of the cross-linking agent is shown as follows:

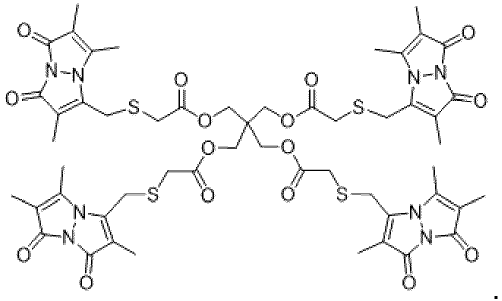

Reference may be made to FIG. 5 for the structure of the light-emitting device 10.
(1): Red quantum dots with double-bond ligands and the above cross-linking agent are dissolved together in PGMEA. The concentration of the quantum dots is 30 mg/mL, and the concentration of the cross-linking agent is 1 mg/mL.
(2): An anode 11 is formed on a side of a substrate 101.
(3): A hole injection layer 15 is formed on a side of the anode 11 away from the substrate 101.

In this example, a material of the hole injection layer 15 includes PEDOT:PSS.

(4): A hole transport layer 141 is formed on a side of the hole injection layer 15 away from the substrate 101.

In this example, a material of the hole transport layer 141 includes TFB.

(5): A red quantum dot light-emitting layer is formed on a side of the hole transport layer 141 away from the substrate 101 by using the material of step (1).

As an example, the red quantum dot/cross-linking agent mixed solution is used for spin-coating at a rotation speed of 3,000 rpm to form a red quantum dot film layer. A photomask is placed on the red quantum dot film layer, aligned with red sub-pixels, and exposed using a 405 nm ultraviolet light source with an exposure dose of 70 mJ/cm². After that, development is performed with PGMEA.

(6): An electron transport layer 16 is formed on a side of the quantum dot light-emitting layer 13 away from the substrate 101.

In this example, the electron transport layer 16 is formed by spin-coating Mg-doped ZnO nanoparticles.

(7): A cathode 12 is formed on a side of the electron transport layer 16 away from the substrate 101.

In this example, the cathode 12 is formed by evaporating Al through an evaporation process. Encapsulation is then performed to obtain the light-emitting devices 10 arranged in an array.

### Embodiment 2

In Embodiment 2, the structure of the cross-linking agent is shown as follows:

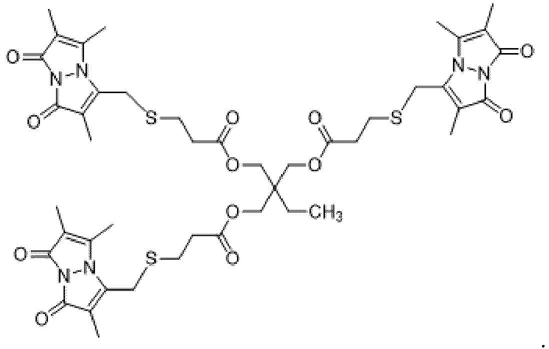

Reference may be made to FIG. 5 for the structure of the light-emitting device 10.
(1): Red quantum dots with double-bond ligands and the above cross-linking agent are dissolved together in PGMEA. The concentration of the quantum dots is 30 mg/mL, and the concentration of the cross-linking agent is 1 mg/mL.
(2): An anode 11 is formed on a side of a substrate 101.
(3): A hole injection layer 15 is formed on a side of the anode 11 away from the substrate 101.

In this example, a material of the hole injection layer 15 includes PEDOT:PSS.

(4): A hole transport layer 141 is formed on a side of the hole injection layer 15 away from the substrate 101.

In this example, a material of the hole transport layer 141 includes TFB.

(5): A red quantum dot light-emitting layer is formed on a side of the hole transport layer 141 away from the substrate 101 by using the material of step (1).

As an example, the red quantum dot/cross-linking agent mixed solution is used for spin-coating at a rotation speed of 3,000 rpm to form a red quantum dot film layer. A photomask is placed on the red quantum dot film layer, aligned with red sub-pixels, and exposed using a 405 nm ultraviolet light source with an exposure dose of 70 mJ/cm². After that, development is performed with PGMEA.

(6): An electron transport layer 16 is formed on a side of the quantum dot light-emitting layer 13 away from the substrate 101.

In this example, the electron transport layer 16 is formed by spin-coating Mg-doped ZnO nanoparticles.

(7): A cathode 12 is formed on a side of the electron transport layer 16 away from the substrate 101.

In this example, the cathode 12 is formed by evaporating Al through an evaporation process. Encapsulation is then performed to obtain the light-emitting devices 10 arranged in an array.

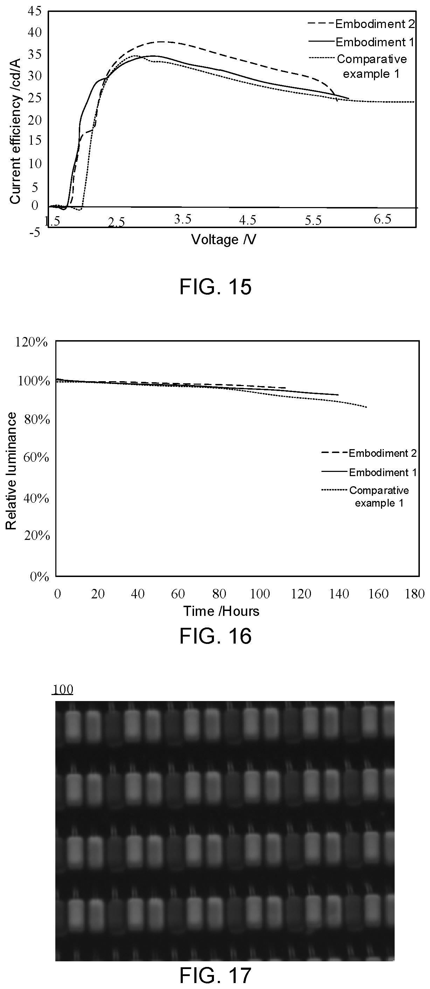

As shown in FIGS. 15 and 16, FIG. 15 is a graph showing current efficiency curves of Comparative Example 1, Embodiment 1 and Embodiment 2 of the present disclosure, where the horizontal axis represents voltage, in units of volts (V), and the vertical axis represents current efficiency, in units of cd/A, and FIG. 16 is a graph showing relative luminance curves of Comparative Example 1, Embodiment 1 and Embodiment 2 of the present disclosure, where the horizontal axis represents time in units of hours, and the vertical axis represents relative luminance.

It can be seen from FIGS. 15 and 16 that, compared with a case without using the cross-linking agent provided by the embodiments of the present disclosure, the light-emitting substrate 100 with the quantum dot light-emitting layer 13 formed by using the cross-linking agent provided by the embodiments of the present disclosure has higher current efficiency and higher relative luminance.

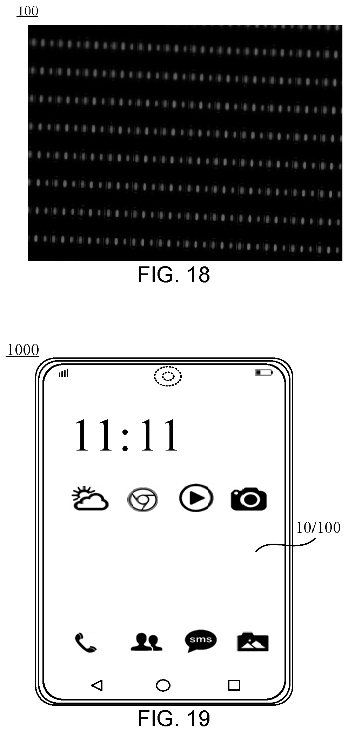

As shown in FIG. 19, embodiments of the present disclosure further provide a light-emitting substrate 100. The light-emitting substrate 100 includes at least one light-emitting device 10 according to any of the above embodiments. The light-emitting substrate 100 further includes pixel driving circuits, and a pixel driving circuit is configured to drive the light-emitting device 10 to emit light.

In some embodiments, the structural formula of the cross-linking agent is shown as follows:

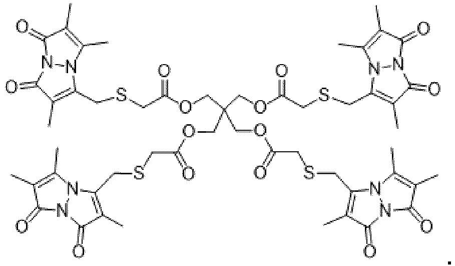

The steps for forming the light-emitting substrate 100 by reacting the cross-linking agents with red quantum dots with double-bond ligands, green quantum dots with double-bond ligands, and blue quantum dots with double-bond ligands respectively are as follows.

Red quantum dots with double-bond ligands, green quantum dots with double-bond ligands, and blue quantum dots with double-bond ligands are respectively dissolved together with the cross-linking agents in PGMEA. The concentration of the quantum dots is 30 mg/mL, and the concentration of the cross-linking agent is 1 mg/mL.

The red quantum dot/cross-linking agent mixed solution is used for spin-coating on a pixelated substrate at a rotation speed of 3,000 rpm to form a red quantum dot film layer. A photomask is placed on the red quantum dot film layer, aligned with red sub-pixels, and exposed using a 405 nm ultraviolet light source with an exposure dose of 70 mJ/cm². After that, development is performed with PGMEA.

The green quantum dot/cross-linking agent mixed solution is used for spin-coating on the pixelated substrate at a rotation speed of 3,000 rpm to form a green quantum dot film layer. A photomask is placed on the green quantum dot film layer, aligned with green sub-pixels, and exposed using a 405 nm ultraviolet light source with an exposure dose of 130 mJ/cm². After that, development is performed with PGMEA.

The blue quantum dot/cross-linking agent mixed solution is used for spin-coated on the pixelated substrate at a rotation speed of 3,000 rpm to form a blue quantum dot film layer. A photomask is placed on the blue quantum dot film layer, aligned with blue sub-pixels, and exposed using a 405 nm ultraviolet light source with an exposure dose of 1600 mJ/cm². After that, development is performed with PGMEA.

The light-emitting substrate 100 including the patterned quantum dot light-emitting layer 13 is obtained after drying. A diagram showing the light emission of the light-emitting substrate 100 including the quantum dot light-emitting layer is presented in FIG. 17.

The following provides an example for forming a full-color light-emitting substrate 100.

In this embodiment, the structure of the cross-linking agent is shown as follows:

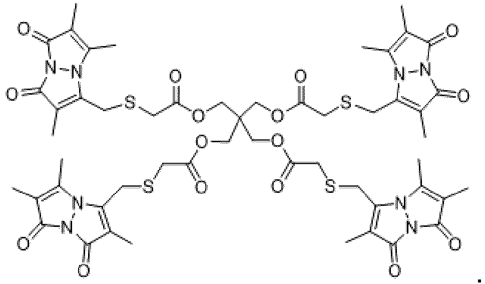

Reference may be made to FIGS. 5 and 19 for the structures of the light-emitting substrate 100 and the light-emitting device 10.
(1): Red quantum dots with double-bond ligands, green quantum dots with double-bond ligands, and blue quantum dots with double-bond ligands are respectively dissolved together with the above cross-linking agent in PGMEA. The concentration of the quantum dots is 30 mg/mL, and the concentration of the cross-linking agent is 1 mg/mL.
(2): An anode 11 is formed on a side of a substrate 101.
(3): A hole injection layer 15 is formed on a side of the anode 11 away from the substrate 101.

In this example, a material of the hole injection layer 15 includes PEDOT:PSS.

(4): A hole transport layer 141 is formed on a side of the hole injection layer 15 away from the substrate 101.

In this example, a material of the hole transport layer 141 includes TFB.

(5): A red quantum dot light-emitting layer, a green quantum dot light-emitting layer, and a blue quantum dot light-emitting layer are formed on a side of the hole transport layer 141 away from the substrate 101 by using the material of step (1), so as to obtain the quantum dot light-emitting layer 13.

As an example, the red quantum dot/cross-linking agent mixed solution is used for spin-coating at a rotation speed of 3,000 rpm to form a red quantum dot film layer. A photomask is placed on the red quantum dot film layer, aligned with red sub-pixels, and exposed using a 405 nm ultraviolet light source with an exposure dose of 70 mJ/cm². After that, development is performed with PGMEA.

The green quantum dot/cross-linking agent mixed solution is used for spin-coating at a rotation speed of 3,000 rpm to form a green quantum dot film layer. A photomask is placed on the green quantum dot film layer, aligned with green sub-pixels, and exposed using a 405 nm ultraviolet light source with an exposure dose of 130 mJ/cm². After that, development is performed with PGMEA.

The blue quantum dot/cross-linking agent mixed solution is used for spin-coating at a rotation speed of 3,000 rpm to form a blue quantum dot film layer. A photomask is placed on the blue quantum dot film layer, aligned with blue sub-pixels, and exposed using a 405 nm ultraviolet light source with an exposure dose of 1600 mJ/cm². After that, development is performed with PGMEA.

(6): An electron transport layer 16 is formed on a side of the quantum dot light-emitting layer 13 away from the substrate 101.

In this example, the electron transport layer 16 is formed by spin-coating Mg-doped ZnO nanoparticles.

As shown in FIG. 18, FIG. 18 is a diagram showing the light emission of the light-emitting substrate 100, in accordance with embodiments of the present disclosure.

The light-emitting substrate 100 includes the light-emitting device 10 provided by any of the above embodiments. Therefore, the light-emitting substrate 100 provided by the embodiments of the present disclosure has all the beneficial effects of the light-emitting device 10 provided by any of the above embodiments, which will not be repeated here.

As shown in FIG. 19, embodiments of the present disclosure further provide a display apparatus 1000. The display apparatus 1000 includes the light-emitting substrate 100 according to any of the above embodiments. The display apparatus 1000 further includes a driving chip. The driving chip is configured to drive the light-emitting substrate 100 for display.

The display apparatus 1000 may be any apparatus capable of displaying both moving (e.g., video) and fixed (e.g., still images) content, whether text or graphics. More specifically, it is contemplated that the embodiments may be implemented in or associated with a variety of electronic devices, such as, but not limited to, mobile phones, wireless devices, personal digital assistants (PDAs), handheld or portable computers, GPS receivers/navigators, cameras, MP4 video players, camcorders, game consoles, watches, clocks, calculators, television monitors, flat-panel displays, computer monitors, automotive displays (e.g., odometer displays, etc.), navigators, cockpit controllers and/or displays, camera view displays (e.g., displays of rearview cameras in vehicles), electronic photographs, electronic billboards or signs, projectors, architectural structures, packaging and aesthetic structures (e.g., displays for images of a piece of jewelry). FIG. 19 schematically illustrates the display apparatus 1000 by taking a mobile phone as an example.

The display apparatus 1000 includes the light-emitting substrate 100 provided by any of the above embodiments. Therefore, the display apparatus 1000 provided by the embodiments of the present disclosure has all the beneficial effects of the light-emitting substrate 100 provided by any of the above embodiments, which will not be repeated here.

The foregoing description is only specific embodiments of the present disclosure, but the scope of protection of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. A cross-linking agent, comprising: a sulfhydryl group protected by a photoremovable group, the photoremovable group being removed under light irradiation to release the sulfhydryl group, a sulfur free-radical or a sulfur anion.

2. The cross-linking agent according to claim 1, wherein the cross-linking agent is selected from at least one of structures represented by following general formula I:
PPG-S-R1-S-PPG I;
wherein R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and PPG is the photoremovable group.

3. The cross-linking agent according to claim 1, wherein the cross-linking agent is selected from at least one of structures represented by following general formula II:
R2-(R1-S-PPG)ₙ₁ II;
wherein R2 is selected from any one of a secondary carbon atom, a tertiary carbon atom, and a quaternary carbon atom; and n1 ≥ 2.

4. The cross-linking agent according to claim 1, wherein the cross-linking agent is selected from at least one of structures represented by following general formulas VI-1 or VI-2: 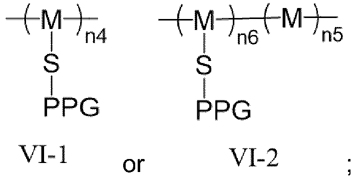 wherein each M is same or different, and M is a repeating unit formed by polymerization of at least one selected from styrene, acrylate, alkyl acrylate, maleic anhydride, or caprolactone styrene; n4 is selected from positive integers greater than or equal to 2; n5+n6 is selected from positive integers greater than or equal to 2; and a value of n6/(n5+n6) ranges from 1% to 1.

5. The cross-linking agent according to any one of claims 1 to 4, wherein the photoremovable group is selected from at least one of following substituents: 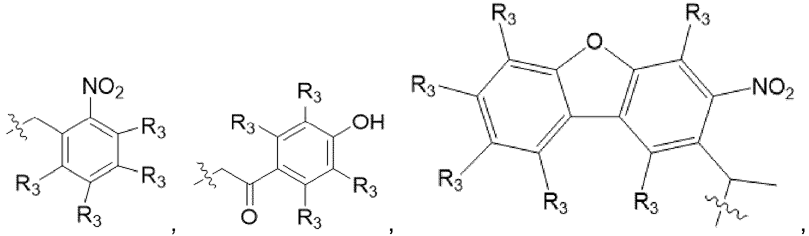 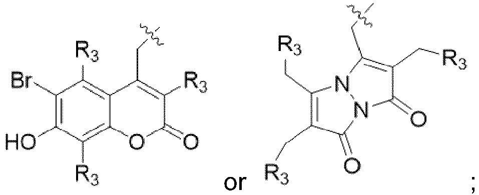 wherein each R₃ is independently selected from any one of H, an alkyl group, an electron-withdrawing group, an electron-donating group, and a conjugated group.

6. The cross-linking agent according to claim 5, wherein the cross-linking agent is selected from at least one of structures represented by following formula I-I:

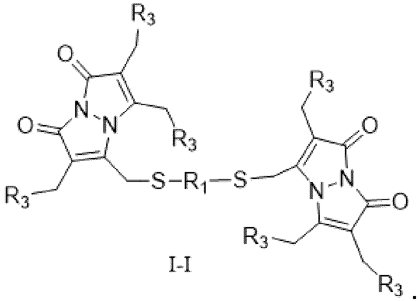

7. The cross-linking agent according to claim 5, wherein the cross-linking agent is selected from at least one of structures represented by following formula I-II:

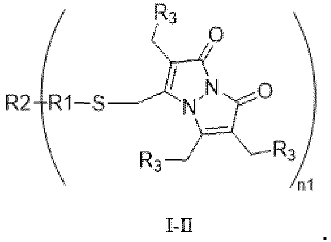

8. The cross-linking agent according to claim 5, wherein the cross-linking agent is selected from at least one of structures represented by following formulas I-III or I-IV:

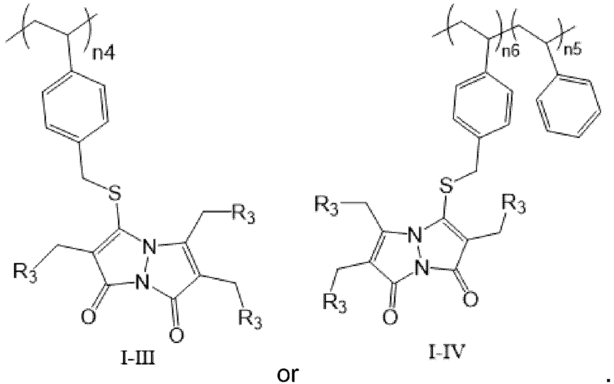

9. The cross-linking agent according to any one of claims 1 to 8, wherein the cross-linking agent is selected from at least one of following structural formulas:

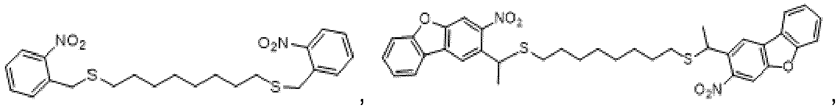

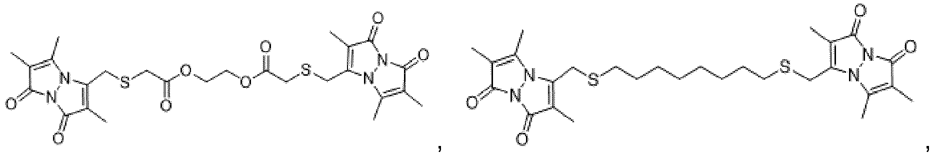

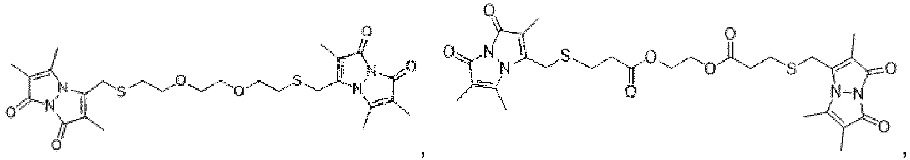

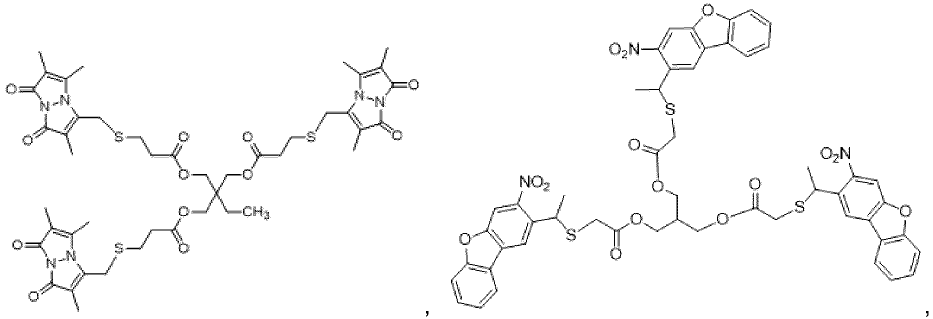

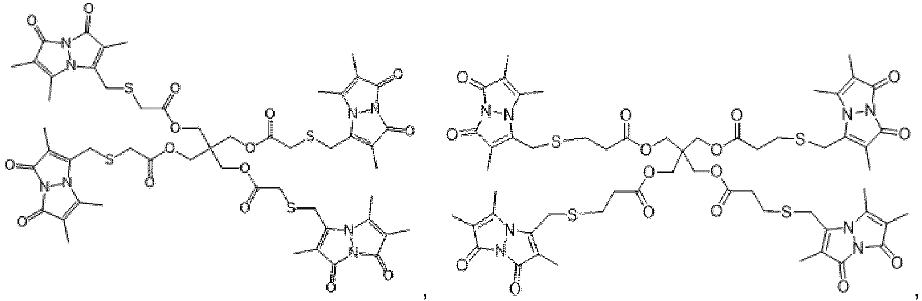

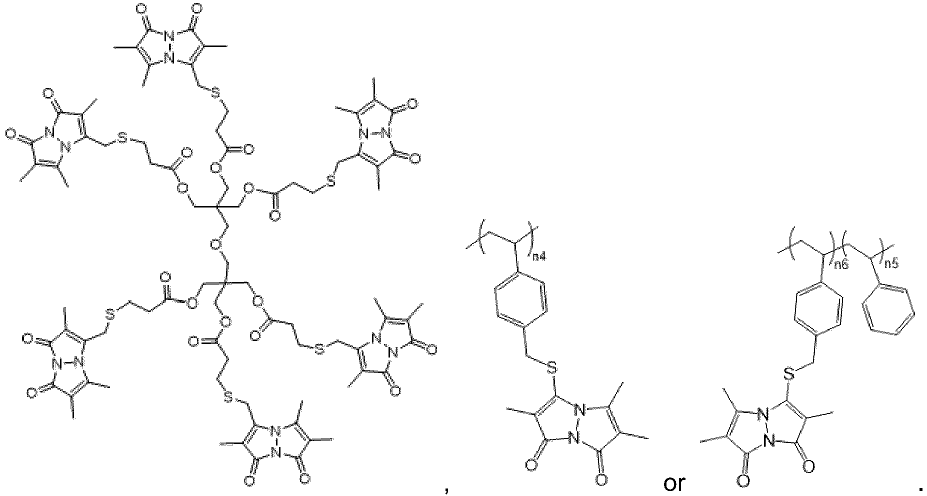

10. The cross-linking agent according to claim 1, further comprising: a carrier transport regulating group.

11. The cross-linking agent according to claim 10, wherein
the cross-linking agent comprises: a main chain and a side chain connected to the main chain of the cross-linking agent; the carrier transport regulating group is located on the main chain of the cross-linking agent; and the sulfhydryl group protected by the photoremovable group is located on the side chain of the cross-linking agent.

12. The cross-linking agent according to claim 11, wherein the cross-linking agent is selected from at least one of structures represented by following general formula III:
R4-(R1-S-PPG)ₙ₂ III;
wherein R4 is the substituted or unsubstituted carrier transport regulating group; and n2 ≥ 2.

13. The cross-linking agent according to any one of claims 10 to 12, wherein the carrier transport regulating group is a hole transport group, and the hole transport group comprises at least one of a triphenylamine group, a carbazole group, or a linked triphenylamine group.

14. The cross-linking agent according to any one of claims 10 to 13, wherein the cross-linking agent is selected from at least one of following structural formulas:

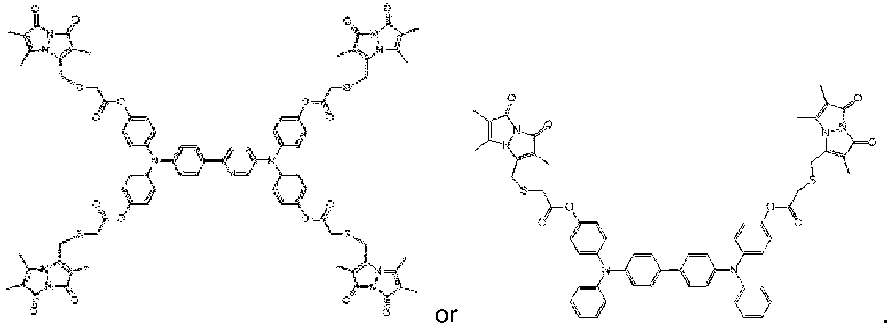

15. A hole transport composition, comprising: a hole transport material and a cross-linking agent, wherein the hole transport material comprises a main chain and a side chain connected to the main chain of the hole transport material, wherein
at least one of the side chain of the hole transport material or the cross-linking agent has a sulfhydryl group protected by a photoremovable group, and the photoremovable group is removed under light irradiation to release the sulfhydryl group, a sulfur free-radical or a sulfur anion;
wherein the released sulfhydryl group, sulfur free-radical or sulfur anion is configured to enable cross-linking between the hole transport material and the cross-linking agent.

16. The hole transport composition according to claim 15, wherein the cross-linking agent is selected from the cross-linking agent according to any one of claims 1 to 14, and the sulfhydryl group, sulfur free-radical or sulfur anion released from the cross-linking agent is configured to react with the side chain of the hole transport material to form a chemical bond.

17. The hole transport composition according to claim 15, wherein the released sulfhydryl group, sulfur free-radical or sulfur anion is located on the side chain of the hole transport material, and the released sulfhydryl group, sulfur free-radical or sulfur anion is configured to react with the cross-linking agent to form a chemical bond.

18. The hole transport composition according to any one of claims 15 to 17, wherein in a case where the released sulfhydryl group, sulfur free-radical or sulfur anion is located on the cross-linking agent, the side chain of the hole transport material further comprises an activating group; in a case where the released sulfhydryl group, sulfur free-radical or sulfur anion is located on the side chain of the hole transport material, the cross-linking agent further comprises an activating group;
wherein the activating group comprises at least one of a carbon-carbon double bond or a carbon-carbon triple bond.

19. The hole transport composition according to claim 18, wherein the activating group having the carbon-carbon double bond comprises at least one of a styryl group, an acrylate group, an alkyl acrylate group, a maleic anhydride group, or a maleimide group.

20. A ligand for coordinatively connecting to a quantum dot body, comprising: a sulfhydryl group protected by a photoremovable group, the photoremovable group being removed under light irradiation to release the sulfhydryl group, a sulfur free-radical or a sulfur anion.

21. The ligand according to claim 20, wherein the photoremovable group is selected from at least one of following substituents: 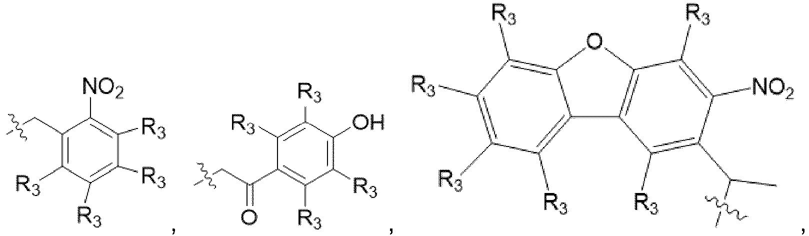 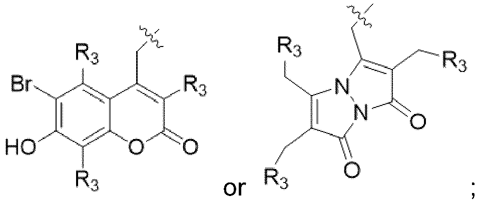 wherein each R₃ is independently selected from any one of H, an alkyl group, an electron-withdrawing group, an electron-donating group, and a conjugated group.

22. The ligand according to claim 20 or 21, further comprising: a coordination group for coordinatively connecting to the quantum dot body, wherein the coordination group comprises at least one of an amino group, a carboxylic acid group, a sulfhydryl group, a phosphino group, a phosphine oxide group, a phosphate group, a phosphite group, or a hypophosphite group.

23. The ligand according to claim 22, wherein the ligand is selected from at least one of structures represented by following general formula IV:
A-R1-S-PPG IV;
wherein A is the coordination group; R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and PPG is the photoremovable group.

24. The ligand according to claim 23, wherein a structural formula of the ligand comprises:

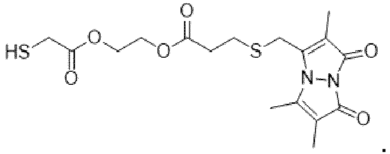

25. The ligand according to claim 22, wherein the ligand is selected from at least one of structures represented by following general formula V:
A-R5-(R1-S-PPG)ₙ₃ V;
wherein R5 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, and an alkynyl group; and n3 ≥ 2.

26. A quantum dot composition, comprising: a quantum dot body, a ligand, and a cross-linking agent, the ligand being coordinatively connected to the quantum dot body, wherein
at least one of the ligand or the cross-linking agent has a sulfhydryl group protected by a photoremovable group, and the photoremovable group is removed under light irradiation to release the sulfhydryl group, a sulfur free-radical or a sulfur anion;
wherein the released sulfhydryl group, sulfur free-radical or sulfur anion is configured to enable cross-linking between at least two of the quantum dot body, the ligand, or the cross-linking agent.

27. The quantum dot composition according to claim 26, wherein the cross-linking agent is selected from the cross-linking agent according to any one of claims 1 to 13, and the sulfhydryl group, sulfur free-radical or sulfur anion released from the cross-linking agent is configured to coordinatively connect with the quantum dot body or react with the ligand to form a chemical bond.

28. The quantum dot composition according to claim 27, wherein the ligand comprises: a first ligand, a structural formula of the first ligand being A1-R1-D, wherein A1 is a coordination group capable of coordinating with the quantum dot body; R1 is selected from a substituted or unsubstituted alkyl group, or a substituted or unsubstituted alkyl group comprising at least one of an ethylene glycol group, an ether group, a ketone group, an amine group, a thioether group, a sulfone group, an ester group, an amide group, an alkenyl group, or an alkynyl group; and D is an activating group.

29. The quantum dot composition according to claim 28, wherein the ligand further comprises: a second ligand, a structural formula of the second ligand being A2-R1, wherein A2 is a coordination group capable of coordinating with the quantum dot body; and R1 of the first ligand and R1 of the second ligand are same or different.

30. The quantum dot composition according to claim 29, wherein a proportion of mass of the first ligand to mass of the ligand is greater than or equal to 5%.

31. The quantum dot composition according to claim 26, wherein the ligand comprises the ligand according to any one of claims 19 to 24, and the sulfhydryl group, sulfur free-radical or sulfur anion released from the ligand is configured to react with the cross-linking agent to form a chemical bond, coordinatively connect the quantum dot body, or react with another ligand to form a chemical bond.

32. The quantum dot composition according to claim 31, wherein the cross-linking agent comprises: an activating group, the activating group comprising at least one of a carbon-carbon double bond or a carbon-carbon triple bond.

33. A light-emitting device, comprising: a hole transport layer and a quantum dot light-emitting layer that are stacked, wherein
a material of at least one of the hole transport layer or the quantum dot light-emitting layer comprises at least one of following materials: 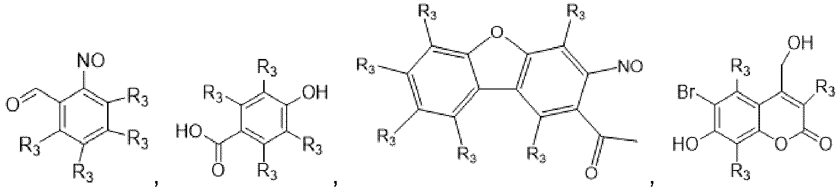
or 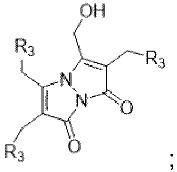
wherein each R₃ is independently selected from any one of H, an alkyl group, an electron-withdrawing group, an electron-donating group, or a conjugated group.

34. The light-emitting device according to claim 33, wherein a material of the hole transport layer further comprises a first cross-linking material, wherein
the first cross-linking material comprises a first group, the first group comprising a main chain and a side chain connected to the main chain of the first group; and
the first cross-linking material further comprises a first cross-linking group connected to the side chain of the first group, and the side chain of the first group and the first cross-linking group are connected via at least two thioether structures.

35. The light-emitting device according to claim 34, wherein the first cross-linking group further comprises at least one of a triphenylamine group, a carbazole group, or a linked triphenylamine group.

36. The light-emitting device according to claim 34 or 35, wherein the main chain of the first group comprises at least one of polycarbazole, polybenzidine, a substituted or unsubstituted carbazole-fluorene copolymer, or a substituted or unsubstituted benzidine-fluorene copolymer.

37. The light-emitting device according to any one of claims 34 to 36, wherein the side chain of the first group further comprises at least one of an ethylene glycol group or an ester group.

38. The light-emitting device according to any one of claims 33 to 37, wherein the quantum dot light-emitting layer comprises quantum dot bodies connected to each other via a second cross-linking material, wherein
the second cross-linking material comprises at least one of the following materials:
a coordination group coordinating with a quantum dot body, and a second cross-linking group connected to the coordination group, the coordination group and the second cross-linking group being connected via a thioether structure;
a second cross-linking group connected to the quantum dot body via an S-Zn coordination bond or an S-Cd coordination bond; or
a first coordination group coordinating with the quantum dot body, and a second coordination group coordinating with the quantum dot body, the first coordination group and the second coordination group being connected via a thioether structure.
